(19) Europäisches Patentamt
European Patent Office
Office européen des brevets

(11) EP 2 243 177 B1

(12) **EUROPEAN PATENT SPECIFICATION**

(45) Date of publication and mention of the grant of the patent:
**15.05.2019 Bulletin 2019/20**

(21) Application number: **09705052.0**

(22) Date of filing: **27.01.2009**

(51) Int Cl.:
***H01L 51/52*** *(2006.01)*

(86) International application number:
**PCT/US2009/000530**

(87) International publication number:
**WO 2009/097108 (06.08.2009 Gazette 2009/32)**

(54) **PHOSPHORESCENT OLED HAVING DOUBLE HOLE-BLOCKING LAYERS**

PHOSPHORESZENTE OLED MIT DOPPELLOCHBLOCKIERSCHICHTEN

DISPOSITIF ÉLECTROLUMINESCENT ORGANIQUE PHOSPHORESCENT À DOUBLE COUCHE DE BLOCAGE DE TROUS

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **30.01.2008 US 22402**

(43) Date of publication of application:
**27.10.2010 Bulletin 2010/43**

(73) Proprietor: **Global OLED Technology LLC**
**Sterling, Virginia 20164 (US)**

(72) Inventors:
- **BEGLEY, William James**
  **Rochester**
  **New York 14650 (US)**
- **LIAO, Liang-Sheng**
  **Rochester**
  **New York 14650 (US)**
- **PELLOW, Cynthia A.**
  **Rochester**
  **New York 14650 (US)**

(74) Representative: **Wibbelmann, Jobst**
**Wuesthoff & Wuesthoff**
**Patentanwälte PartG mbB**
**Schweigerstrasse 2**
**81541 München (DE)**

(56) References cited:
**EP-A- 1 653 784**
**WO-A-03/107452**
**WO-A-2005/011334**

- **YANG H ET AL: "Organic light-emitting devices with double-block layer" MICROELECTRONICS JOURNAL, MACKINTOSH PUBLICATIONS LTD. LUTON, GB, vol. 37, no. 11, 1 November 2006 (2006-11-01), pages 1271-1275, XP025250109 ISSN: 0026-2692 [retrieved on 2006-11-01]**
- **LI Y ET AL: "AN EFFICIENT PURE BLUE ORGANIC LIGHT-EMITTING DEVICE WITH LOW DRIVING VOLTAGES" ADVANCED MATERIALS, WILEY VCH, WEINHEIM, DE, vol. 14, no. 18, 16 September 2002 (2002-09-16), pages 1317-1321, XP001131372 ISSN: 0935-9648**
- **CHIECHI R C ET AL: "Efficient Blue-Light-Emitting Electroluminescent Devices with a Robust Fluorophore: 7,8,10-Triphenylfluoranthene" ADVANCED MATERIALS, WILEY VCH, WEINHEIM, DE, vol. 18, 10 January 2006 (2006-01-10), pages 325-328, XP002514326 ISSN: 0935-9648**
- **KINOSHITA M ET AL: "A NOVEL FAMILY OF BORON-CONTAINING HOLE-BLOCKING AMORPHOUS MOLECULAR MATERIALS FOR BLUE- AND BLUE-VIOLET-EMITTING ORGANIC ELECTROLUMINESCENT DEVICES" ADVANCED FUNCTIONAL MATERIALS, WILEY VCH, WIENHEIM, DE, vol. 11/12, no. 12, 1 December 2002 (2002-12-01), pages 780-786, XP001141057 ISSN: 1616-301X**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 243 177 B1

## Description

### FIELD OF THE INVENTION

The present invention relates to organic light-emitting devices (OLEDs) or organic electroluminescent (EL) devices including a phosphorescent light-emitting layer and two adjacent hole-blocking layers.

### BACKGROUND OF THE INVENTION

Organic light-emitting devices (OLEDs) or organic

electroluminescent (EL) devices have been known for several decades, however, their performance limitations have represented a barrier for many applications. In the simplest form, an OLED is comprised of an anode for hole injection, a cathode for electron injection, and an organic medium sandwiched between these electrodes to support charge recombination and emission of light. Representative of earlier OLEDs can be found in the RCA Review, 30, 322 (1969), entitled "Double Injection Electroluminescence in Anthracene" and U.S. Patent Nos. 3,172,862; 3,173,050; and 3,710,167. The organic layers in these devices, usually composed of a polycyclic aromatic hydrocarbon, were very thick (much greater than 1 $\mu$m). Consequently, operating voltages were very high, often >100V.

More recent OLEDs include an organic EL medium containing extremely thin layers (e.g. <1.0 $\mu$m) between the anode and the cathode. Herein, the term "organic EL medium" encompasses the layers between the anode and cathode. Reducing the thickness has lowered the resistance of the organic layers and enabled devices that operate at much lower voltage. In a basic two-layer OLED structure, described first in U.S. Patent No. 4,356,429 by Tang, one organic layer of the EL medium adjacent to the anode is specifically selected to transport holes, and therefore is referred to as the hole-transporting layer (HTL), and the other organic layer is specifically selected to transport electrons and is referred to as the electron-transporting layer (ETL). Recombination of the injected holes and electrons within the organic EL medium, results in efficient electroluminescence.

Based on the two-layer OLED structure, numerous OLEDs with alternative layer structures have been disclosed. For example, there are three-layer OLEDs that contain an organic light-emitting layer (LEL) between the HTL and the ETL, such as that disclosed by Adachi et al., "Electroluminescence in Organic Films with Three-Layer Structure", Japanese Journal of Applied Physics, 27, L269 (1988), and by Tang et al., " Electroluminescence of Doped Organic Thin Films", Journal of Applied Physics, 65, 3610 (1989). The LEL commonly include a host material doped with a guest material, otherwise known as a dopant. Further, there are other multilayer OLEDs that contain additional functional layers, such as a hole-injecting layer (HIL), an electron-injecting layer (EIL), an electron-blocking layer (EBL), a hole-blocking layer (HBL), or an exciton-blocking layer (EXBL) in the devices. These new structures have resulted in improved device performance.

Many light-emitting materials emit light from their excited singlet state by fluorescence. The excited singlet state can be created when excitons formed in an OLED transfer their energy to the singlet excited state of the dopant. However, only 25% of the excitons created in an OLED are singlet excitons. The remaining excitons are triplets, which cannot readily transfer their energy to the dopant to produce the singlet excited state of a dopant. This results in a large loss in efficiency since 75% of the excitons are not used in the light emission process.

Triplet excitons can transfer their energy to a dopant if the dopant has a triplet excited state that is low enough in energy. If the triplet state of the dopant is emissive it can produce light by phosphorescence. In many cases, singlet excitons can also transfer their energy to the lowest singlet excited state of the same dopant. The singlet excited state can often relax, by an intersystem crossing process, to the emissive triplet excited state. By the proper choice of host and dopant, energy can be collected from both the singlet and triplet excitons created in an OLED. The term electrophosphorescence is sometimes used to denote EL wherein the mechanism of luminescence is phosphorescence; the term phosphorescent OLED is used to denote the OLED that can produce electrophosphorescence.

From device architecture perspective, in order to achieve improved external quantum efficiency in a phosphorescent OLED, a blocking layer, which can be either a hole-blocking layer or an electron-blocking layer, has been used to confine carriers and excitons within a light-emitting layer. For example, Baldo et al in U.S. Patent No. 6,097,147 teaches a hole-blocking layer, such as bathocuprione (BCP), between a light-emitting layer and an electron-transporting layer in a phosphorescent OLED. For another example, Thompson et al. in U.S. Patent No. 7,261,954 B2 also disclose phosphorescent OLEDs including a hole-blocking layer. By inserting a hole-blocking layer between the light-emitting layer and an electron-transporting layer, hole leakage and exciton diffusion can be eliminated and, hence, external quantum efficiency is increased. Thompson et al also discloses bis(2-(4,6-difluorophenyl)pyridyl-N, $C^{2'}$)iridium picolinate (FIrpic) as a suitable hole-blocking material.

EP 1 653 784 A1 discloses an electroluminescent element containing an anode and a cathode having therebetween a light emitting layer containing a phosphorescent compound, and hole blocking layer provided adjacent to the

light emitting layer and between the light emitting layer and the cathode, wherein the hole blocking layer contains a phosphorescent compound.

Yang H. et al., in MICROELECTRONICS JOURNAL, MACKINTOSH PUBLICATIONS LTD., Luton, GB, vol. 37, no. 11, 1 November 2006, pages 1271-1275, discuss "Organic light-emitting devices with double-block layer". The authors report on the fabrication of organic light-emitting devices using double-block layers on the electron transport layer and emitting layer.

Notwithstanding all these developments, there remains a need to further improve external quantum efficiency and operational lifetime of the phosphorescent OLEDs.

## SUMMARY OF THE INVENTION

Although an HBL between a phosphorescent LEL and an ETL can effectively block holes (excitons) from transporting (diffusing) into the ETL, and can increase external quantum efficiency in a phosphorescent OLED, it has been found that only one HBL cannot fully improve device performance. An effective HBL should not only block holes and excitons but also facilitate electron injection from the adjacent ETL into the HBL as well as from the HBL into adjacent LEL. Moreover, an effective HBL should have very stable LEL/HBL interface and HBL/ETL interface to guarantee a satisfied operational lifetime. However, in real applications, it is difficult to find or to design such an effective hole-blocking material.

It is therefore an object of the present invention to improve the external quantum efficiency of a phosphorescent OLED.

It is another object of the present invention to improve the operational lifetime of a phosphorescent OLED.

These objects are achieved by an organic light-emitting device (100) comprising:

a) an anode (110);
b) a cathode (190);
c) a phosphorescent light-emitting layer (150) disposed between the anode and the cathode, wherein the phosphorescent light-emitting layer includes at least one host and at least one phosphorescent dopant;
d) a first hole-blocking layer (161) disposed in contact with the phosphorescent light-emitting layer at the cathode side, wherein the first hole-blocking layer includes a first hole-blocking material having a triplet energy greater than the triplet energy of the predominant host in the phosphorescent light-emitting layer; and wherein the HOMO energy of the first hole-blocking material in the first hole-blocking layer is lower than that of the predominant host in the phosphorescent light-emitting layer;
e) a second hole-blocking layer (162) disposed in contact with the first hole-blocking layer at the cathode side, wherein the second hole-blocking layer includes a second hole-blocking material having a triplet energy greater than the triplet energy of the dopant in the phosphorescent light-emitting layer, and wherein the HOMO energy of the second hole-blocking material in the second hole-blocking layer is lower than that of the predominant host in the phosphorescent light-emitting layer; and
f) an electron-transporting layer (170) disposed between the second hole-blocking layer and the cathode, wherein the electron-transporting layer includes at least one electron-transporting material;

wherein there is a LUMO energy difference between the predominant host in the phosphorescent light-emitting layer and the first hole-blocking material in the first hole-blocking layer, and wherein the LUMO energy difference is less than 0.5 V; and
wherein the first hole-blocking material in the first hole-blocking layer and the second hole-blocking matrial in the second hole blocking layer are different electron-transporting materials.

Further embodiments of the invention are set forth in the claims dependent on claim 1 as represented above.

The present invention forms two adjacent HBLs between the LEL and the cathode to enhance hole- and exciton-blocking effects as well as to enhance electron injection capability in the device. It is an advantage of the present invention that the phosphorescent OLED having two hole-blocking layers can generate electrophosphorescence with improved external quantum efficiency and operational lifetime.

## BRIEF DESCRIPTION OF THE DRAWINGS

FIG. 1 shows a cross-sectional view of one embodiment of a phosphorescent OLED prepared in accordance with the present invention;
FIG. 2 shows a cross-sectional view of another embodiment of a phosphorescent OLED prepared in accordance

with the present invention;
FIG. 3 shows a cross-sectional view of a prior art phosphorescent OLED;
FIG. 4 shows a cross-sectional view of another prior art phosphorescent OLED; and
FIG. 5 shows the EL spectra of Devices 1, 2, and 3.

It will be understood that FIGS. 1-4 are not to scale since the individual layers are too thin and the thickness differences of various layers are too great to permit depiction to scale.

## DETAILED DESCRIPTION OF THE INVENTION

The present invention can be employed in many OLED configurations using small molecule materials, oligomeric materials, polymeric materials, or combinations thereof. These include from very simple structures having a single anode and cathode to more complex devices, such as passive matrix displays having orthogonal arrays of anodes and cathodes to form pixels, and active-matrix displays where each pixel is controlled independently, for example, with thin film transistors (TFTs). There are numerous configurations of the organic layers, wherein, the present invention is successfully practiced.

A typical structure according to the present invention and especially useful for a small molecule device is shown in FIG. 1. OLED 100 in FIG. 1 includes anode 110, HIL 120, HTL 130, EXBL 140, phosphorescent LEL 150, first HBL 161, second HBL 162, ETL 170, EIL 180 and cathode 190. OLED 100 can be operated by applying an electric potential produced by a voltage/current source between the pair of the electrodes, anode 110 and cathode 190. Shown in FIG. 2 is OLED 200, which is another embodiment of OLEDs prepared in accordance with the present invention. OLED 200 in FIG. 2 is the same as OLED 100 except that there is no EIL 180 in OLED 200.

As a comparison, shown in FIGS. 3 and 4 are OLED 300 and OLED 400, respectively, which are the OLEDs prepared in accordance with the prior art. OLED 300 in FIG. 3 includes anode 110, HIL 120, HTL 130, phosphorescent LEL 150, ETL 170, EIL 180 and cathode 190. OLED 400 in FIG. 4 includes anode 110, HIL 120, HTL 130, EXBL 140, phosphorescent LEL 150, HBL 460, ETL 170, EIL 180 and cathode 190. The difference between the prior art OLEDs and the OLEDs prepared in accordance with the present invention is that there is no HBL or only one HBL in the prior art OLEDs.

In order to facilitate a detailed discussion on the aforementioned OLEDs, several terms are discussed as follows: Triplet energy can be measured by any of several ways, as discussed for instance in S. L. Murov, I. Carmichael, and G. L. Hug, Handbook of Photochemistry, 2nd ed. (Marcel Dekker, New York, 1993). However, direct measurement can often be difficult to accomplish.

For simplicity and convenience, the triplet state of a compound should be calculated for this invention even though the calculated values for the triplet state energy of a given compound can typically show some deviation from the experimental values. If calculated triplet energy values are unavailable, then experimentally determined values can be used. Because the triplet energies cannot be either calculated or measured accurately in some situations, differences of less than 0.05 should be considered equal for the purposes of this invention.

The calculated triplet state energy for a molecule is derived from the difference between the ground state energy (E(gs)) of the molecule and the energy of the lowest triplet state (E(ts)) of the molecule, both given in eV. This difference is modified by empirically derived constants whose values were obtained by comparing the result of E(ts)-E(gs) to experimental triplet energies, so that the triplet state energy is given by equation 1:

$$E(t) = 0.84 \times (E(ts)-E(gs)) + 0.35 \qquad \text{(eq. 1)}$$

Values of E(gs) and E(ts) are obtained using the B3LYP method as implemented in the Gaussian 98 (Gaussian, Inc., Pittsburgh, PA) computer program. The basis set for use with the B3LYP method is defined as follows: MIDI! for all atoms for which MIDI! is defined, 6-31G* for all atoms defined in 6-31G* but not in MIDI!, and either the LACV3P or the LANL2DZ basis set and pseudopotential for atoms not defined in MIDI! or 6-31G*, with LACV3P being the preferred method. For any remaining atoms, any published basis set and pseudopotential can be used. MIDI!, 6-31G* and LANL2DZ are used as implemented in the Gaussian98 computer code and LACV3P is used as implemented in the Jaguar 4.1 (Schrodinger, Inc., Portland Oregon) computer code. The energy of each state is computed at the minimum-energy geometry for that state

For polymeric or oligomeric materials, it is sufficient to compute the triplet energy over a monomer or oligomer of sufficient size so that additional units do not substantially change the computed triplet energy.

The term "reduction potential" expressed in volts and abbreviated $E^{red}$, measures the affinity of a substance for an electron: the larger (more positive) the number, the greater the affinity. The reduction potential of a substance can be conveniently obtained by cyclic voltammetry (CV) and it is measured vs. SCE. The measurement of the reduction

potential of a substance can be as following: An electrochemical analyzer (for instance, a CHI660 electrochemical analyzer, made by CH Instruments, Inc., Austin, TX) is employed to carry out the electrochemical measurements. Both CV and Osteryoung square-wave voltammetry (SWV) can be used to characterize the redox properties of the substance. A glassy carbon (GC) disk electrode (A=0.071 $cm^2$) is used as working electrode. The GC electrode is polished with 0.05 $\mu$m alumina slurry, followed by sonication cleaning in deionized water twice and rinsed with acetone between the two water cleanings. The electrode is finally cleaned and activated by electrochemical treatment prior to use. A platinum wire can be used as the counter electrode and the SCE is used as a quasi-reference electrode to complete a standard 3-electrode electrochemical cell. A mixture of acetonitrile and toluene (1:1 MeCN/toluene) or methylene chloride ($MeCl_2$) can be used as organic solvent systems. All solvents used are ultra low water grade (<10 ppm water). The supporting electrolyte, tetrabutylammonium tetrafluoroborate (TBAF) is recrystallized twice in isopropanol and dried under vacuum for three days. Ferrocene (Fc) can be used as an internal standard ($E^{red}_{Fc}$=0.50 V vs. SCE in 1:1 MeCN/toluene, $E^{red}_{Fc}$=0.55 V vs. SCE in $MeCl_2$, 0.1 M TBAF, both values referring to the reduction of the ferrocenium radical anion). The testing solution is purged with high purity nitrogen gas for approximately 15 minutes to remove oxygen and a nitrogen blanket is kept on the top of the solution during the course of the experiments. All measurements are performed at an ambient temperature of 25 $\pm$ 1 °C. If the compound of interest has insufficient solubility, other solvents can be selected and used by those skilled in the art. Alternatively, if a suitable solvent system cannot be identified, the electron accepting material can be deposited onto the electrode and the reduction potential of the modified electrode can be measured.

Similarly, the term "oxidation potential", expressed in volts and abbreviated $E^{ox}$, measures the ability to lose electron from a substance: the larger the value, the more difficult to lose electron. A CV, as discussed above, can also conveniently obtain the oxidation potential of a substance.

The electronic energy level of the Lowest Unoccupied Molecular Orbital (LUMO) of an organic material can be obtained based on the value of the reduction potential of the organic material. The relationship between LUMO energy and the $E^{red}$ is:

$$\text{LUMO (eV)} = -4.8 - e \times (E^{red}\text{ vs. SCE} - E^{red}_{Fc}\text{ vs. SCE}) \qquad \text{(eq. 2)}$$

Similarly, the electronic energy level of the Highest Occupied Molecular Orbital (HOMO) of an organic material can be obtained based on the value of oxidation potential of the organic material. The relationship between LUMO energy and the $E^{ox}$ is:

$$\text{HOMO (eV)} = -4.8 - e \times (E^{ox}\text{ vs. SCE} - E^{red}_{Fc}\text{ vs. SCE}) \qquad \text{(eq. 3)}$$

For example, in 1:1 MeCN/toluene, if a material has an $E^{red}$ vs. SCE = -2.0 V and an $E^{ox}$ vs. SCE = 1.0 V, the LUMO energy of the material is-2.3 eV, and the HOMO energy of the material is -5.3 eV ($E^{red}_{Fc}$=0.50 V vs. SCE in 1:1 MeCN/toluene).

In addition, there are other ways to measure LUMO energy, such as inversed photoelectron spectroscopy (IPES); there are other ways to measure HOMO energy, such as ultraviolet photoelectron spectroscopy (UPS). LUMO energy is also commonly estimated based on the values of the measured HOMO energy minus the optical band gap of the same material.

Unless otherwise specifically stated when a molecular structure is discussed, use of the term "substituted" or "substituent" means any group or atom other than hydrogen. Unless otherwise provided, when a group (including a compound or complex) containing a substitutable hydrogen is referred to, it is also intended to encompass not only the unsubstituted form, but also form further substituted derivatives with any substituent group or groups as herein mentioned, so long as the substituent does not destroy properties necessary for utility. Suitably, a substituent group can be halogen or can be bonded to the remainder of the molecule by an atom of carbon, silicon, oxygen, nitrogen, phosphorous, sulfur, selenium, or boron. The substituent can be, for example, halogen, such as chloro, bromo or fluoro; nitro; hydroxyl; cyano; carboxyl; or groups which can be further substituted, such as alkyl, including straight or branched chain or cyclic alkyl, such as methyl, trifluoromethyl, ethyl, t-butyl, 3-(2,4-di-t-pentylphenoxy) propyl, and tetradecyl; alkenyl, such as ethylene, 2-butene; alkoxy, such as methoxy, ethoxy, propoxy, butoxy, 2-methoxyethoxy, sec-butoxy, hexyloxy, 2-ethylhexyloxy, tetradecyloxy, 2-(2,4-di-t-pentylphenoxy)ethoxy, and 2-dodecyloxyethoxy; aryl such as phenyl, 4-t-butylphenyl, 2,4,6-trimethylphenyl, naphthyl; aryloxy, such as phenoxy, 2-methylphenoxy, alpha- or beta-naphthyloxy, and 4-tolyloxy; carbonamido, such as acetamido, benzamido, butyramido, tetradecanamido, alpha-(2,4-di-t-pentyl-phenoxy)acetamido, alpha-(2,4-di-t-pentylphenoxy)butyramido, alpha-(3 -pentadecylphenoxy)-hexanamido, alpha-(4-hydroxy-3 -t-butylphenoxy)-tetradecanamido, 2-oxo-pyrrolidin-1-yl, 2-oxo-5-tetradecylpyrrolin-1-yl, N-methyltetradecanamido, N-succinimido, N-phthalimido, 2,5-dioxo-1-oxazolidinyl, 3-dodecyl-2,5-dioxo-1-imidazolyl, and N-acetyl-N-dodecylamino, ethoxycarbonylamino, phenoxycarbonylamino, benzyloxycarbonylamino, hexadecyloxycarbonylamino, 2,4-di-t-butylphenoxycarbonylamino, phenylcarbonylamino, 2,5-(di-t-pentylphenyl)carbonylamino, p-dodecyl-phenylcarbonylamino, p-tolylcarbonylamino, N-methylureido, N,N-dimethylureido, N-methyl-N-dodecylureido, N-hexadecylureido, N,N-dioctadecylureido, N,N-dioctyl-N'-ethylureido, N-phenylureido, N,N-diphenylureido, N-phenyl-N-p-tolylureido, N-(m-hexadecylphenyl)ureido, N,N-(2,5-di-t-pentylphenyl)-N'-ethylureido, and t-butylcarbonamido; sulfonamido, such as methylsulfonamido, benzenesulfonamido, p-tolylsulfonamido, p-dodecylbenzenesulfonamido, N-methyltetradecylsulfonamido, N,N-dipropylsulfamoylamino, and hexadecylsulfonamido; sulfamoyl, such as N-methylsulfamoyl, N-ethylsulfamoyl, N,N-dipropylsulfamoyl, N-hexadecylsulfamoyl, N,N-dimethylsulfamoyl, N-[3-(dodecyloxy)propyl]sulfamoyl, N-[4-(2,4-di-t-pentylphenoxy)butyl]sulfamoyl, N-methyl-N-tetradecylsulfamoyl, and N-dodecylsulfamoyl; carbamoyl, such as N-methylcarbamoyl, N,N-dibutylcarbamoyl, N-octadecylcarbamoyl, N-[4-(2,4-di-t-pentylphenoxy)butyl]carbamoyl, N-methyl-N-tetradecylcarbamoyl, and N,N-dioctylcarbamoyl; acyl, such as acetyl, (2,4-di-t-amylphenoxy)acetyl, phenoxycarbonyl, p-dodecyloxyphenoxycarbonyl methoxycarbonyl, butoxycarbonyl, tetradecyloxycarbonyl, ethoxycarbonyl, benzyloxycarbonyl, 3-pentadecyloxycarbonyl, and dodecyloxycarbonyl; sulfonyl, such as methoxysulfonyl, octyloxysulfonyl, tetradecyloxysulfonyl, 2-ethylhexyloxysulfonyl, phenoxysulfonyl, 2,4-di-t-pentylphenoxysulfonyl, methylsulfonyl, octylsulfonyl, 2-ethylhexylsulfonyl, dodecylsulfonyl, hexadecylsulfonyl, phenylsulfonyl, 4-nonylphenylsulfonyl, and p-tolylsulfonyl; sulfonyloxy, such as dodecylsulfonyloxy, and hexadecylsulfonyloxy; sulfinyl, such as methylsulfinyl, octylsulfinyl, 2-ethylhexylsulfinyl, dodecylsulfinyl, hexadecylsulfinyl, phenylsulfinyl, 4-nonylphenylsulfinyl, and p-tolylsulfinyl; thio, such as ethylthio, octylthio, benzylthio, tetradecylthio, 2-(2,4-di-t-pentylphenoxy)ethylthio, phenylthio, 2-butoxy-5-t-octylphenylthio, and p-tolylthio; acyloxy, such as acetyloxy, benzoyloxy, octadecanoyloxy, p-dodecylamidobenzoyloxy, N-phenylcarbamoyloxy, N-ethylcarbamoyloxy, and cyclohexylcarbonyloxy; amine, such as phenylanilino, 2-chloroanilino, diethylamine, dodecylamine; imino, such as 1 (N-phenylimido)ethyl, N-succinimido or 3-benzylhydantoinyl; phosphate, such as dimethylphosphate and ethylbutylphosphate; phosphite, such as diethyl and dihexylphosphite; a heterocyclic group, a heterocyclic oxy group or a heterocyclic thio group, each of which can be substituted and which contain a 3 to 7 membered heterocyclic ring composed of carbon atoms and at least one hetero atom selected from the group containing oxygen, nitrogen, sulfur, phosphorous, or boron, such as 2-furyl, 2-thienyl, 2-benzimidazolyloxy or 2-benzothiazolyl; quaternary ammonium, such as triethylammonium; quaternary phosphonium, such as triphenylphosphonium; and silyloxy, such as trimethylsilyloxy.

If desired, the substituents can themselves be further substituted one or more times with the described substituent groups. The particular substituents used can be selected by those skilled in the art to attain the desired desirable properties for a specific application and can include, for example, electron-withdrawing groups, electron-donating groups, and steric groups. When a molecule can have two or more substituents, the substituents can be joined together to form a ring such as a fused ring unless otherwise provided. Generally, the above groups and substituents thereof can include those having up to 48 carbon atoms, typically 1 to 36 carbon atoms and usually less than 24 carbon atoms, but greater numbers are possible depending on the particular substituents selected.

It is well within the skill of the art to determine whether a particular group is electron donating or electron accepting. The most common measure of electron donating and accepting properties is in terms of Hammett $\sigma$ values. Hydrogen has a Hammett $\sigma$ value of zero, while electron donating groups have negative Hammett $\sigma$ values and electron accepting groups have positive Hammett $\sigma$ values. Lange's handbook of Chemistry, 12th Ed., McGraw Hill, 1979, Table 3-12, pp. 3-134 to 3-138, here incorporated by reference, lists Hammett $\sigma$ values for a large number of commonly encountered groups. Hammett $\sigma$ values are assigned based on phenyl ring substitution, but they provide a practical guide for qualitatively selecting electron donating and accepting groups.

Suitable electron donating groups can be selected from -R', -OR', and -NR'(R") where R' is a hydrocarbon containing up to 6 carbon atoms and R" is hydrogen or R'. Specific examples of electron donating groups include methyl, ethyl, phenyl, methoxy, ethoxy, phenoxy, $-N(CH_3)_2$, $-N(CH_2CH_3)_2$, $-NHCH_3$,$-N(C_6H_5)_2$, $-N(CH_3)(C_6H_5)$, and $-NHC_6H_5$.

Suitable electron accepting groups can be selected from the group containing cyano, $\alpha$-haloalkyl, $\alpha$-haloalkoxy, amido, sulfonyl, carbonyl, carbonyloxy and oxycarbonyl substituents containing up to 10 carbon atoms. Specific examples include -CN, -F, $-CF_3$, $-OCF_3$, $-CONHC_6H_5$, $-SO_2C_6H_5$,$-COC_6H_5$, $-CO_2C_6H_5$, and $-OCOC_6H_5$.

The aforementioned terms will be frequently used in the following discussions. The following is the description of the layers, material selection, and fabrication process for the OLED embodiments shown in FIGS. 1-4.

When the desired EL emission is viewed through the anode, anode 110 should be transparent or substantially transparent to the emission of interest. Common transparent anode materials used in this invention are indium-tin oxide (ITO), indium-zinc oxide (IZO) and tin oxide, but other metal oxides can work including, but not limited to, aluminum- or indium-doped zinc oxide, magnesium-indium oxide, and nickel-tungsten oxide. In addition to these oxides, metal nitrides, such as gallium nitride, and metal selenides, such as zinc selenide, and metal sulfides, such as zinc sulfide, can be used as the anode 110. For applications where EL emission is viewed only through the cathode 190, the transmissive characteristics of the anode 110 are immaterial and any conductive material can be used, transparent, opaque or reflective. Example conductors for this application include, but are not limited to, gold, iridium, molybdenum, palladium, and platinum. Typical anode materials, transmissive or otherwise, have a work function of 4.1 eV or greater. Desired anode materials are commonly deposited by any suitable methods such as evaporation, sputtering, chemical vapor deposition, or electrochemical methods. Anodes can be patterned using well-known photolithographic processes. Optionally, anodes can be polished prior to application of other layers to reduce surface roughness so as to minimize short circuits or enhance reflectivity.

Although it is not always necessary, it is often useful to provide an HIL in the OLEDs. HIL 120 in the OLEDs can serve to facilitate hole injection from the anode into the HTL, thereby reducing the drive voltage of the OLEDs. Suitable materials for use in HIL 120 include, but are not limited to, porphyrinic compounds as described in U.S. Patent No. 4,720,432 and some aromatic amines, for example, 4,4',4"-tris[(3-ethylphenyl)phenylamino]triphenylamine (m-TDATA). Alternative hole-injecting materials reportedly useful in OLEDs are described in EP 0 891 121 A1 and EP 1 029 909 A1. Aromatic tertiary amines discussed below can also be useful as hole-injecting materials. Other useful hole-injecting materials such as dipyrazino[2,3-f:2',3'-h]quinoxalinehexacarbonitrile are described in U.S. Patent Application Publication No. 2004/0113547 A1 and U.S. Patent No. 6,720,573. In addition, a p-type doped organic layer is also useful for the HIL as described in U.S. Patent No. 6,423,429. The term " p-type doped organic layer" means that this layer has semiconducting properties after doping, and the electrical current through this layer is substantially carried by the holes. The conductivity is provided by the formation of a charge-transfer complex as a result of hole transfer from the dopant to the host material.

The thickness of the HIL 120 is in the range of from 0.1 nm to 200 nm, preferably, in the range of from 0.5 nm to 150 nm.

The HTL 130 contains at least one hole-transporting material such as an aromatic tertiary amine, where the latter is understood to be a compound containing at least one trivalent nitrogen atom that is bonded only to carbon atoms, at least one of which is a member of an aromatic ring. In one form the aromatic tertiary amine is an arylamine, such as a monoarylamine, diarylamine, triarylamine, or a polymeric arylamine. Exemplary monomeric triarylamines are illustrated by Klupfel et al. U.S. Patent No. 3,180,730. U.S. Patent Nos. 3,567,450 and 3,658,520, by Brantley, et al. disclose other suitable triarylamines substituted with one or more vinyl radicals or at least one active hydrogen-containing group.

A more preferred class of aromatic tertiary amines are those which include at least two aromatic tertiary amine moieties as described in U.S. Patent Nos. 4,720,432 and 5,061,569. Such compounds include those represented by structural Formula (A)

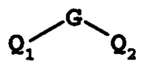

(A)

wherein:

$Q_1$ and $Q_2$ are independently selected aromatic tertiary amine moieties; and
G is a linking group such as an arylene, cycloalkylene, or alkylene group of a carbon-to-carbon bond.

In one embodiment, at least one of $Q_1$ or $Q_2$ contains a polycyclic fused ring structure, e.g., a naphthalene. When G is an aryl group, it is conveniently a phenylene, biphenylene, or naphthalene moiety.

A useful class of triarylamines satisfying structural Formula A and containing two triarylamine moieties is represented by structural Formula (B)

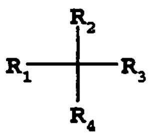

(B)

wherein:

$R_1$ and $R_2$ each independently represents a hydrogen atom, an aryl group, or an alkyl group or $R_1$ and $R_2$ together represent the atoms completing a cycloalkyl group; and
$R_3$ and $R_4$ each independently represents an aryl group, which is in turn substituted with a diaryl substituted amino group, as indicated by structural Formula (C)

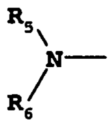

(C)

wherein $R_5$ and $R_6$ are independently selected aryl groups. In one embodiment, at least one of $R_5$ or $R_6$ contains a polycyclic fused ring structure, e.g., a naphthalene.

Another class of aromatic tertiary amines are the tetraaryldiamines. Desirable tetraaryldiamines include two diarylamino groups, such as indicated by Formula (C), and linked through an arylene group. Useful tetraaryldiamines include those represented by Formula (D)

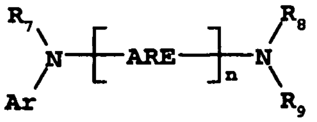

(D)

wherein:

each are is an independently selected arylene group, such as a phenylene or anthracene moiety;
n is an integer of from 1 to 4; and
Ar, $R_7$, $R_8$, and $R_9$ are independently selected aryl groups.

In a typical embodiment, at least one of Ar, $R_7$, $R_8$, and $R_9$ is a polycyclic fused ring structure, e.g., a naphthalene.

Another class of the hole-transporting material includes a material of formula (E):

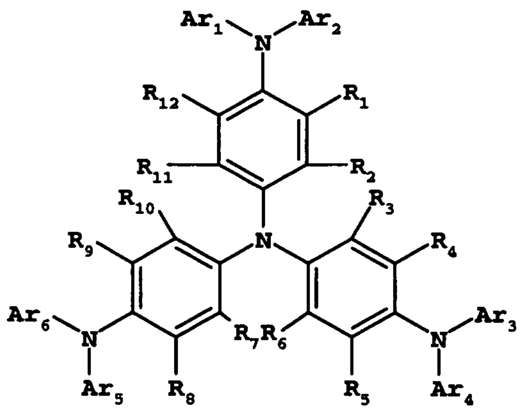

(E)

In formula (E), $Ar_1$-$Ar_6$ independently represent aromatic groups, for example, phenyl groups or tolyl groups; $R_1$-$R_{12}$ independently represent hydrogen or independently selected substituent, for example an alkyl group containing from 1 to 4 carbon atoms, an aryl group, a substituted aryl group.

The various alkyl, alkylene, aryl, and arylene moieties of the foregoing structural Formulae (A), (B), (C), (D), and (E) can each in turn be substituted. Typical substituents include alkyl groups, alkoxy groups, aryl groups, aryloxy groups, and halogen such as fluoride, chloride, and bromide. The various alkyl and alkylene moieties typically contain from about 1 to 6 carbon atoms. The cycloalkyl moieties can contain from 3 to about 10 carbon atoms, but typically contain five, six, or seven ring carbon atoms, e.g. cyclopentyl, cyclohexyl, and cycloheptyl ring structures. The aryl and arylene moieties are typically phenyl and phenylene moieties.

The HTL is formed of a single or a mixture of aromatic tertiary amine compounds. Specifically, one can employ a triarylamine, such as a triarylamine satisfying the Formula (B), in combination with a tetraaryldiamine, such as indicated by Formula (D). When a triarylamine is employed in combination with a tetraaryldiamine, the latter is positioned as a layer interposed between the triarylamine and the electron injecting and transporting layer. Aromatic tertiary amines are useful as hole-injecting materials also. Illustrative of useful aromatic tertiary amines are the following:

1,1-bis(4-di-***p***-tolylaminophenyl)cyclohexane;
1,1-bis(4-di-***p***-tolylaminophenyl)-4-phenylcyclohexane;
1,5-bis[N-(1-naphthyl)-N-phenylamino]naphthalene;
2,6-bis(di-***p***-tolylamino)naphthalene;
2,6-bis[di-(1-naphthyl)amino]naphthalene;
2,6-bis[N-(1-naphthyl)-N-(2-naphthyl)amino]naphthalene;
2,6-bis[N,N-di(2-naphthyl)amine]fluorene;
4-(di-p-tolylamino)-4'-[4(di-***p***-tolylamino)-styryl]stilbene;

4,4'-bis(diphenylamino)quadriphenyl;
4,4"-bis[N-(1-anthryl)-N-phenylamino]-***p***-terphenyl;
4,4'-bis[N-(1-coronenyl)-N-phenylamino]biphenyl;
4,4'-bis[N-(1-naphthyl)-N-phenylamino]biphenyl (NPB);
4,4'-bis[N-(1-naphthyl)-N-(2-naphthyl)amino]biphenyl (TNB);
4,4"-bis[N-(1-naphthyl)-N-phenylamino]p-terphenyl;
4,4'-bis[N-(2-naphthacenyl)-N-phenylamino]biphenyl;
4,4'-bis[N-(2-naphthyl)-N-phenylamino]biphenyl;
4,4'-bis[N-(2-perylenyl)-N-phenylamino]biphenyl;
4,4'-bis[N-(2-phenanthryl)-N-phenylamino]biphenyl;
4,4'-bis[N-(2-pyrenyl)-N-phenylamino]biphenyl;
4,4'-bis[N-(3-acenaphthenyl)-N-phenylamino]biphenyl;
4,4'-bis[N-(3-methylphenyl)-N-phenylamino]biphenyl (TPD);
4,4'-bis[N-(8-fluoranthenyl)-N-phenylamino]biphenyl;
4,4'-bis[N-(9-anthryl)-N-phenylamino]biphenyl;
4,4'-bis{N-phenyl-N-[4-(1-naphthyl)-phenyl]amino}biphenyl;
4,4'-bis[N-phenyl-N-(2-pyrenyl)amino]biphenyl;
4,4',4"-tris[(3-methylphenyl)phenylamino]triphenylamine (m-TDATA);
Bis(4-dimethylamino-2-methylphenyl)-phenylmethane;
N-phenylcarbazole;
N,N'-bis[4-([1,1'-biphenyl]-4-ylphenylamino)phenyl]-N,N'-di-1-naphthalenyl-[1,1'-biphenyl]-4,4'-diamine;
N,N'-bis[4-(di-1-naphthalenylamino)phenyl]-N,N'-di-1-naphthalenyl-[1,1'-biphenyl] -4,4'-diamine;
N,N'-bis[4-[(3-methylphenyl)phenylamino]phenyl]-N,N'-diphenyl-[1,1'-biphenyl]-4,4'-diamine;
N,N-bis[4-(diphenylamino)phenyl]-N',N'-diphenyl-[1,1'-biphenyl]-4,4'-diamine;
N,N'-di-1-naphthalenyl-N,N'-bis[4-(1-naphthalenylphenylamino)phenyl]-[1,1'-biphenyl]-4,4'-diamine;
N,N'-di-1-naphthalenyl-N,N'-bis[4-(2-naphthalenylphenylamino)phenyl]-[1,1'-biphenyl]-4,4'-diamine;
N,N,N-tri(p-tolyl)amine;
N,N,N',N'-tetra-p-tolyl-4-4'-diaminobiphenyl;
N,N,N',N'-tetraphenyl-4,4'-diaminobiphenyl;
N,N,N',N'-tetra-1-naphthyl-4,4'-diaminobiphenyl;
N,N,N',N'-tetra-2-naphthyl-4,4'-diaminobiphenyl; and
N,N,N',N'-tetra(2-naphthyl)-4,4"-diamino-p-terphenyl.

Another class of useful hole-transporting materials includes polycyclic aromatic compounds as described in EP 1 009 041. Tertiary aromatic amines with more than two amine groups can be used including oligomeric materials. In addition, polymeric hole-transporting materials are used such as poly(N-vinylcarbazole) (PVK), polythiophenes, polypyrrole, polyaniline, and copolymers such as poly(3,4-ethylenedioxythiophene)/poly(4-styrenesulfonate) also called PEDOT/PSS.

The thickness of the HTL 130 is in the range of from 5 nm to 200 nm, preferably, in the range of from 10 nm to 150 nm.

EXBL 140 is useful in an OLED employing a phosphorescent dopant (or phosphorescent emitter). When located nearby a phosphorescent LEL on the anode side, it helps to confine triplet excitons without escaping through this layer towards the anode side. In order that the EXBL be capable of confining triplet excitons, the material or materials of this layer should have triplet energies that exceed the triplet energies of the host materials in the phosphorescent LEL 150, (LEL 150 will be discussed thereafter). In some cases it is desirable that the EXBL 140 also help to confine electron-hole recombination events to the LEL by blocking the escape of electrons from the LEL into the EXBL 140.

In addition to having high triplet energy, the EXBL should be capable of transporting holes to a LEL. Thus, a hole-transporting material is desirable to be used in the EXBL. The hole-transporting material for use in the EXBL can be the same or different from a hole-transporting material used in the HTL 130 provided that the triplet energy of the hole-transporting material is greater than the triplet energy of the host in the phosphorescent LEL 150.

The exciton-blocking material used in the EXBL can be selected from compounds containing one or more triarylamine groups, and the triplet energy of these compounds exceeds the triplet energy of the host in the phosphorescent LEL. In order to meet such triplet energy requirements said compounds should not contain aromatic fused rings (e.g. naphthalene).

The substituted triarylamines that function as the exciton-blocking material in the present invention can be selected from compounds having the chemical formula (F):

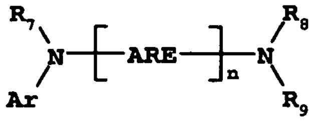

(F)

In formula (F), Are is independently selected from alkyl, substituted alkyl, aryl, or substituted aryl group; $R_1$-$R_4$ are independently selected aryl groups; provided that Are and $R_1$-$R_4$ do not include aromatic hydrocarbon fused rings; and n is an integer of from 1 to 4.

In one suitable embodiment the exciton-blocking material includes a material of formula (E) as discussed before:

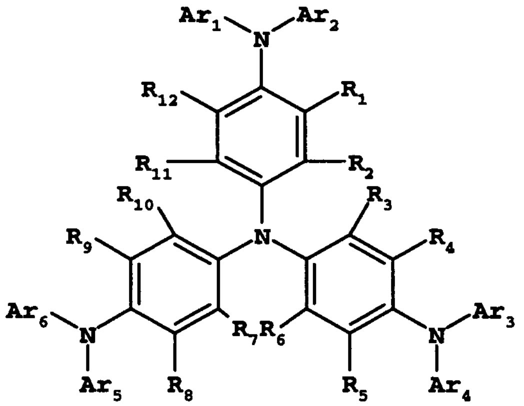

(E)

wherein $Ar_1$-$Ar_6$ independently represent aromatic groups, for example, phenyl groups or tolyl groups;
$R_1$-$R_{12}$ independently represent hydrogen or independently selected substituent, for example a alkyl group containing from 1 to 4 carbon atoms, an aryl group, or a substituted aryl group;
provided that $R_1$-$R_{12}$ and $Ar_5$-$Ar_{10}$ do not contain aromatic hydrocarbon fused rings.

Examples of materials useful in the EXBL 140 include, but are not limited to:

4,4',4"-tris[(3-methylphenyl)phenylamino]triphenylamine (MTDATA);
4,4',4"-tris(N,N-diphenyl-amino)triphenylamine (TDATA);
N,N-bis[2,5-dimethyl-4-[(3-methylphenyl)phenylamino]phenyl]-2,5-dimethyl-N'-(3-methylphenyl)-N'-phenyl-1,4-benzenediamine.

In one desirable embodiment the material in the exciton-blocking layer is selected from formula (G):

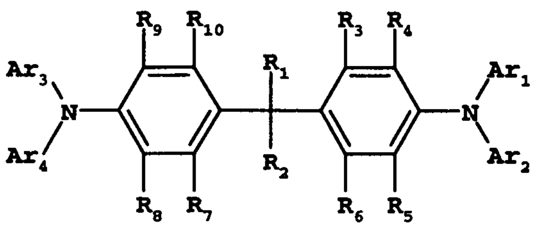

(G)

In formula (G), $R_1$ and $R_2$ represent substituents, provided that $R_1$ and $R_2$ can join to form a ring. For example, $R_1$ and $R_2$ can be methyl groups or join to form a cyclohexyl ring. $Ar_1$-$Ar_4$ represent independently selected aromatic groups, for example phenyl groups or tolyl groups. $R_3$-$R_{10}$ independently represent hydrogen, alkyl, substituted alkyl, aryl, substituted aryl group. In one desirable embodiment, $R_1$-$R_2$, $Ar_1$-$Ar_4$ and $R_3$ - $R_{10}$ do not contain fused aromatic rings.

Some non-limiting examples of such materials are:

1,1-Bis(4-(N,N-di-*p*-tolylamino)phenyl)cyclohexane (TAPC);
1,1-Bis(4-(N, N-di-*p*-tolylamino)phenyl)cyclopentane;
4,4'-(9H-fluoren-9-ylidene)bis[N,N-bis(4-methylphenyl)-benzenamine;
1,1-Bis(4-(N, N-di-*p*-tolylamino)phenyl)-4-phenylcyclohexane;

1,1-Bis(4-(N, N-di-*p*-tolylamino)phenyl)-4-methylcyclohexane;
1,1-Bis(4-(N, N-di-*p*-tolylamino)phenyl)-3-phenylpropane;
Bis[4-(N,N-diethylamino)-2-methylphenyl](4-methylpenyl)methane;
Bis[4-(N,N-diethylamino)-2-methylphenyl](4-methylphenyl)ethane;
4-(4-Diethylaminophenyl)triphenylmethane;
4,4'-Bis(4-diethylaminophenyl)diphenylmethane.

In one suitable embodiment the exciton-blocking material includes a material of formula (H):

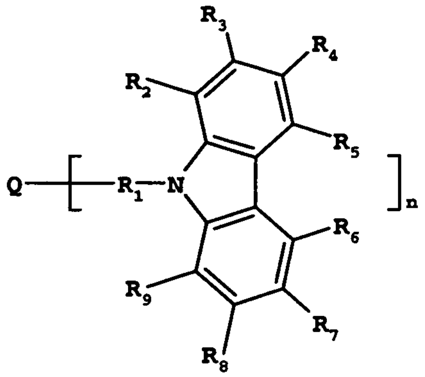

(H)

wherein n is an integer from 1 to 4;
Q is N, C, aryl, or substituted aryl group;
$R_1$ is phenyl, substituted phenyl, biphenyl, substituted biphenyl, aryl or substituted aryl;
$R_2$ through $R_9$ are independently hydrogen, alkyl, phenyl or substituted phenyl, aryl amine, carbazole, or substituted carbazole; provided that $R_2$ - $R_9$ do not contain aromatic hydrocarbon fused rings.

It is further desirable that the exciton-blocking material is selected from formula (I):

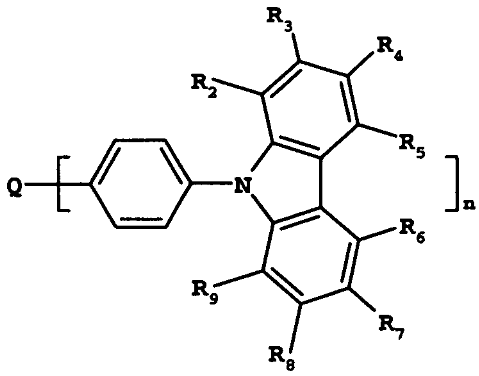

(I)

wherein n is an integer from 1 to 4;
Q is N, C, aryl, or substituted aryl;
$R_2$ through $R_9$ are independently hydrogen, alkyl, phenyl or substituted phenyl, aryl amine, carbazole, provided that $R_2$ - $R_9$ do not contain aromatic hydrocarbon fused rings.

Some non-limiting examples of such materials are:

4-(9H-carbazol-9-yl)-N,N-bis[4-(9H-carbazol-9-yl)phenyl]-benzenamine (TCTA);
4-(3-phenyl-9H-carbazol-9-yl)-N,N-bis[4(3-phenyl-9H- carbazol-9-yl)phenyl] -benzenamine;
9,9'-[5'-[4-(9H-carbazol-9-yl)phenyl][1,1':3',1"-terphenyl]-4,4"-diyl]bis-9H-carbazole.

In one suitable embodiment the exciton-blocking material includes a material of formula (J):

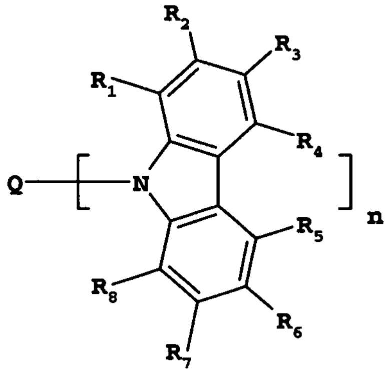

(J)

wherein n is an integer from 1 to 4;
Q is phenyl, substituted phenyl, biphenyl, substituted biphenyl, aryl, or substituted aryl group;
$R_1$ through Rg are independently hydrogen, alkyl, phenyl or substituted phenyl, aryl amine, carbazole, or substituted carbazole;
provided that $R_1$ - $R_8$ do not contain aromatic hydrocarbon fused rings.

Non-limiting examples of suitable materials are:

9,9'-(2,2'-dimethyl[1,1'-biphenyl]-4,4'-diyl)bis-9H-carbazole (CDBP);
9,9'-[1,1'-biphenyl]-4,4'-diylbis-9H-carbazole (CBP);
9,9'-(1,3-phenylene)bis-9H-carbazole (mCP);
9,9'-(1,4-phenylene)bis-9H-carbazole;
9,9',9''-(1,3,5-benzenetriyl)tris-9H-carbazole;
9,9'-(1,4-phenylene)bis[N,N,N',N'-tetraphenyl-9H-carbazole-3,6-diamine;
9-[4-(9H-carbazol-9-yl)phenyl]-N,N-diphenyl-9H-carbazol-3-amine;
9,9'-(1,4-phenylene)bis[N,N-diphenyl-9H-carbazol-3-amine;
9-[4-(9H-carbazol-9-yl)phenyl]-N,N,N',N'-tetraphenyl- 9H-carbazole-3,6-diamine;
9-phenyl-9H-carbazole.

An example of a hole-transporting material that satisfy the requirements for the exciton-blocking material used in the EXBL is TCTA, and an example of a hole-transporting material that fails to satisfy the requirements for the exciton-blocking material used in the EXBL is NPB.

The following table lists the HOMO energy, LUMO energy, redox potentials (in volts) and the triplet energy of some representative structures of hole-transporting materials suitable for use as exciton-blocking materials in the phosphorescent OLEDs. All values are in eV unless noted.

**Exciton-Blocking Materials (EXBM)**

| Identifier | HOMO Energy | LUMO Energy | Triplet Energy | Structure |
|---|---|---|---|---|
| EXBM-1 (TCTA) | -5.43 | -1.88 | 2.85 | 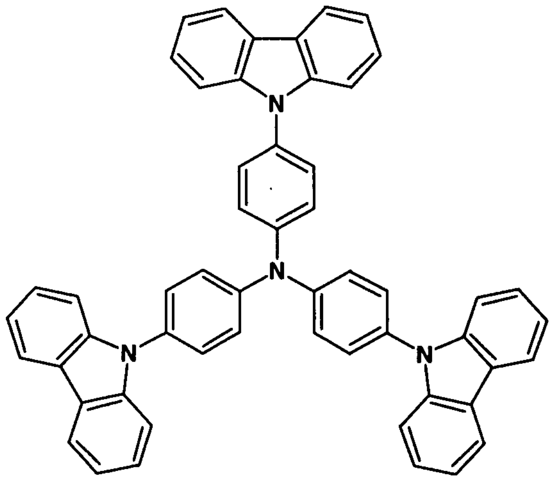 $E^{ox}$ = 1.3; $E^{red}$ = -2.50 |
| EXBM-2 (CBP) | -5.58 | -2.13 | 2.67 | 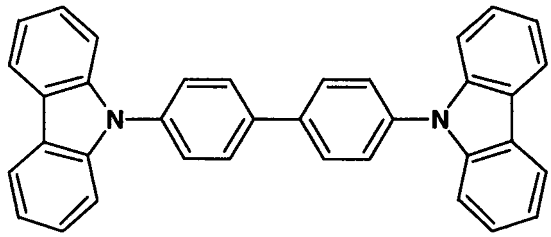 $E^{ox}$ = 1.3; $E^{red}$ = -2.34 |
| EXBM-3 (MCP) | -5.68 | -1.75 | 3.15 | 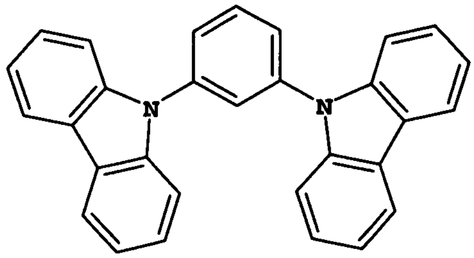 |
| EXBM-4 | -5.15 | -1.30 | 2.95 | 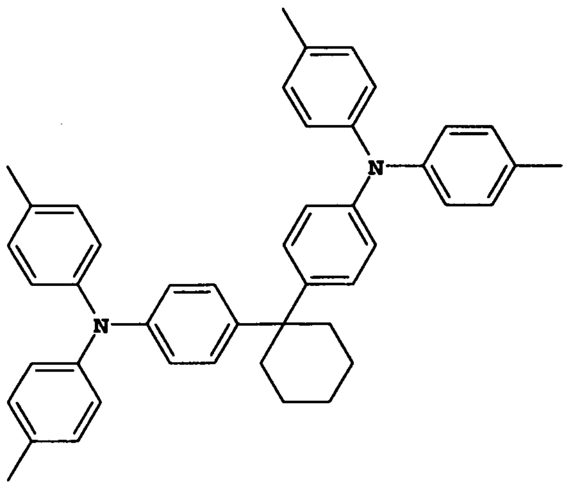 |

(continued)

| Identifier | HOMO Energy | LUMO Energy | Triplet Energy | Structure |
|---|---|---|---|---|
| EXBM-5 (m-TDATA) | -4.93 | -1.91 | 2.65 | 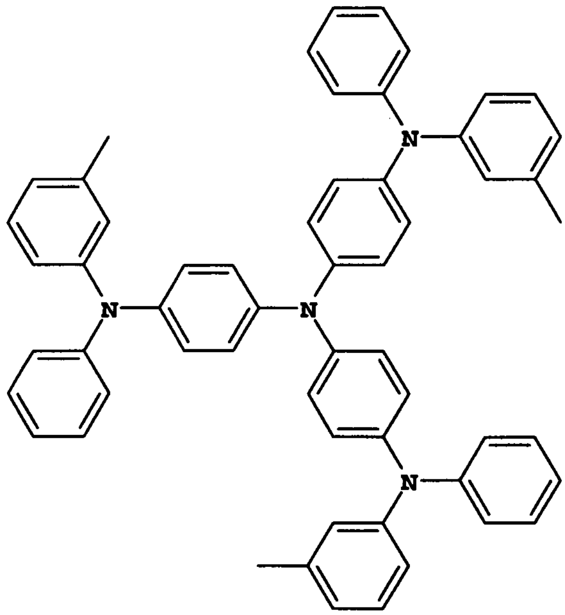 |

The EXBL 140 can be between 1 and 50 nm thick and suitably between 2 and 20 nm thick. The EXBL can include more than one compound, deposited as a blend or divided into separate layers.

When more than one material is present in the EXBL, the triplet energy of the entire layer is considered to be the same as the triplet energy of the predominate material. Throughout this invention, the predominate material is the material that is present by the highest % by volume of all materials in that layer. If two or more materials are present in equal amounts, the triplet energy of the layer is considered to be the same as the triplet energy of the material with the lowest triplet energy relative to the triplet energy of the phosphorescent host.

The phosphorescent LEL 150 includes at least one host (or host material) and at least one phosphorescent dopant (or dopant material).

Suitable host in the phosphorescent LEL 150 should be selected so that transfer of a triplet exciton can occur efficiently from the host to the phosphorescent dopant(s) but cannot occur efficiently from the phosphorescent dopant(s) to the host. Therefore, it is highly desirable that the triplet energy of the host be higher than the triplet energies of phosphorescent dopant(s). Generally speaking, a large triplet energy implies a large optical band gap. However, the band gap of the host should not be chosen so large as to cause an unacceptable barrier to injection of holes or electrons and an unacceptable increase in the drive voltage of the OLED. The host in the phosphorescent LEL 150 can include the aforementioned hole-transporting material used for the HTL 130, as long as it has a triplet energy higher than that of the phosphorescent dopant in the layer. More important to the present invention, it is desirable that the host in the phosphorescent LEL 150 is an electron-transporting material as long as it has a triplet energy higher than that of the phosphorescent dopant in the phosphorescent LEL 150.

If two or more phosphorescent hosts are present, the triplet energy is considered to be the same as the triplet energy of the predominate host. If two or more hosts are present in equal amounts, the triplet energy of the layer is considered to be the same as the triplet energy of the host with the lowest triplet energy.

A desirable electron-transporting host can be any suitable electron-transporting compound, such as benzazole, phenanthroline, 1,3,4-oxadiazole, triazole, triazine, fluoranthene, or triarylborane, as long as it has a triplet energy that is higher than that of the phosphorescent dopant to be employed.

A preferred class of benzazoles is described by Shi et al. in U.S. Patent Nos. 5,645,948 and 5,766,779. Such compounds are represented by structural formula (K):

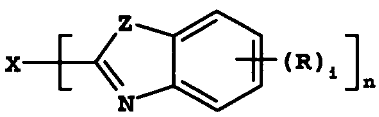

(K)

In formula (K), n is selected from 2 to 8;
Z is independently O, NR or S;
R and R' are individually hydrogen; alkyl of from 1 to 24 carbon atoms, for example, propyl, t-butyl, heptyl, and the like; aryl or hetero-atom substituted aryl of from 5 to 20 carbon atoms, for example, phenyl and naphthyl, furyl, thienyl, pyridyl, quinolinyl and other heterocyclic systems; or halo such as chloro, fluoro; or atoms necessary to complete a fused aromatic ring; and
X is a linkage unit containing carbon, alkyl, aryl, substituted alkyl, or substituted aryl, which conjugately or unconjugately connects the multiple benzazoles together.
An example of a useful benzazole is 2,2',2"-(1,3,5-phenylene)tris[1-phenyl-1H-benzimidazole] (TPBI) (see Formula K-1) represented as shown below:

| | |
|---|---|
| K-1 (TPBI) | 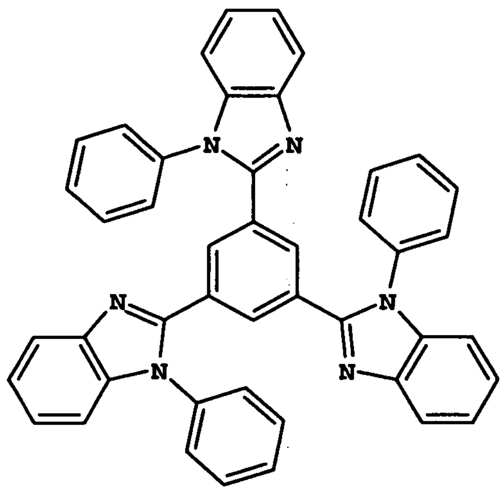 |

Another class of the electron-transporting materials suitable for use as a host includes various substituted phenanthrolines as represented by formula (L):

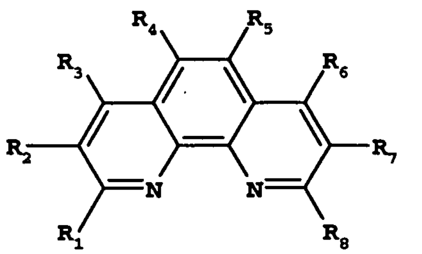

(L)

In formula (L), $R_1$-$R_8$ are independently hydrogen, alkyl group, aryl or substituted aryl group, and at least one of $R_1$-$R_8$ is aryl group or substituted aryl group.
Examples of particularly suitable materials of this class are 2,9-dimethyl-4,7-diphenyl-1,10-phenanthroline (BCP) (see Formula L-1) and 4,7-diphenyl-1,10-phenanthroline (Bphen) (see Formula L-2).

| | |
|---|---|
| L-1 (BCP) | 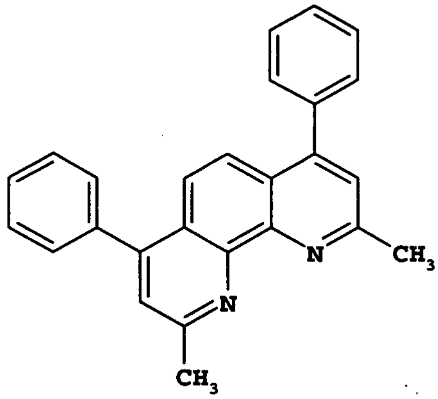 |
| L-2 (Bphen) | 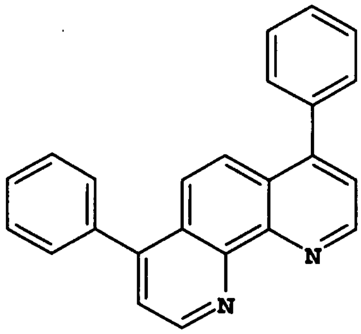 |

The triarylboranes that function as the electron-transporting host in the present invention can be selected from compounds having the chemical formula (M):

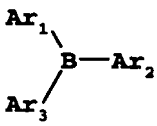

(M-a)

wherein
$Ar_1$ to $Ar_3$ are independently an aromatic hydrocarbocyclic group or an aromatic heterocyclic group, which can have a substituent. It is preferable that compounds having the above structure are selected from formula (M-b):

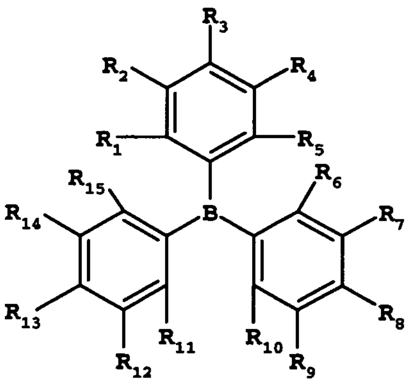

(M-b)

wherein $R_1$-$R_{15}$ are independently hydrogen, fluoro, cyano, trifluoromethyl, sulfonyl, alkyl, aryl or substituted aryl group.
Specific representative embodiments of the triarylboranes include:

| | |
|---|---|
| M-1 | 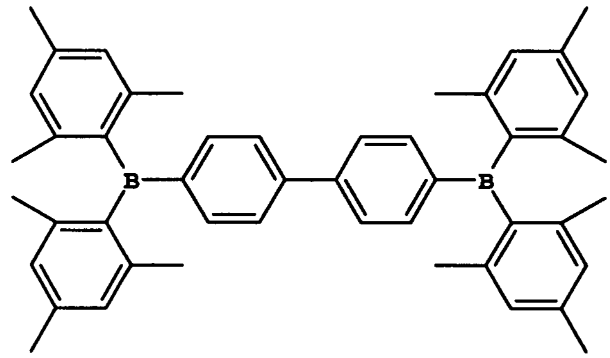 |
| M-2 | 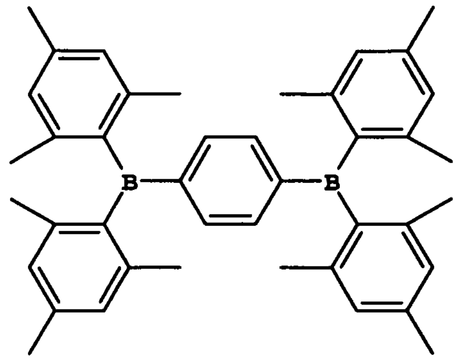 |
| M-3 | 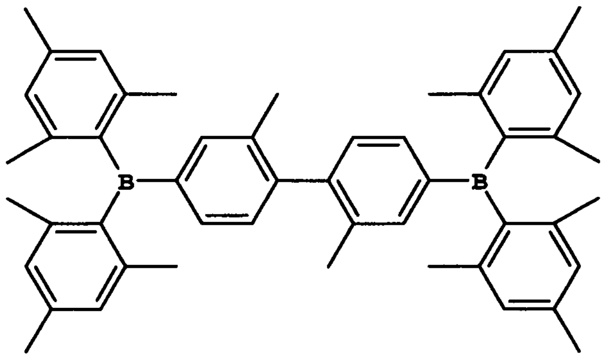 |

The electron-transporting host in the present invention can be selected from substituted 1,3,4-oxadiazoles. Illustrative of the useful substituted oxadiazoles are the following:

| | |
|---|---|
| N-1 | 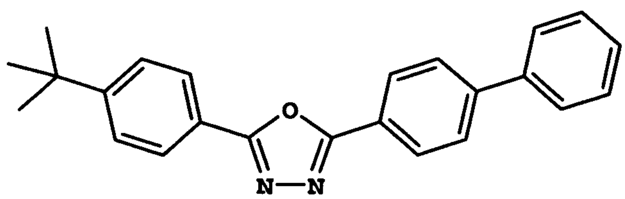 |
| N-2 | 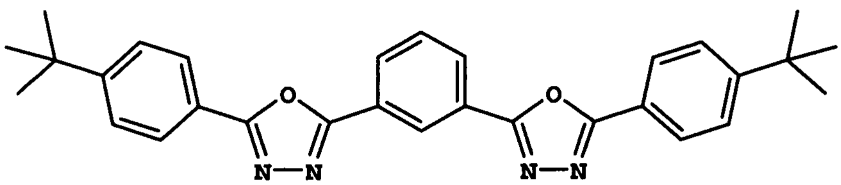 |

The electron-transporting host in the present invention also can be selected from substituted 1,2,4-triazoles.

An example of a useful triazole is 3-phenyl-4-(1-naphtyl)-5-phenyl-1,2,4-triazole:

| | |
|---|---|
| O-1 | 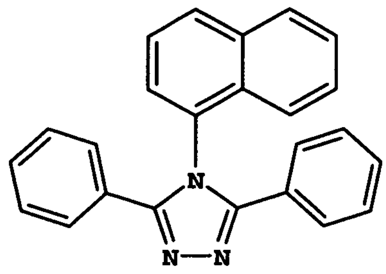 |

The electron-transporting host in the present invention also can be selected from substituted 1,3,5-triazines. Examples of suitable materials are:

2,4,6-tris(diphenylamino)-1,3,5-triazine;
2,4,6-tricarbazolo-1,3,5-triazine;
2,4,6-tris(N-phenyl-2-naphthylamino)-1,3,5-triazine;
2,4,6-tris(N-phenyl-1-naphthylamino)-1,3,5-triazine;
4,4',6,6'-tetraphenyl-2,2'-bi-1,3,5-triazine;
2,4,6-tris([1,1':3',1"-terphenyl]-5'-yl)-1,3,5-triazine.

Preferred fluorathene compounds useful as electron transporting hosts or in electron transporting layers are represented by structural formula (OP):

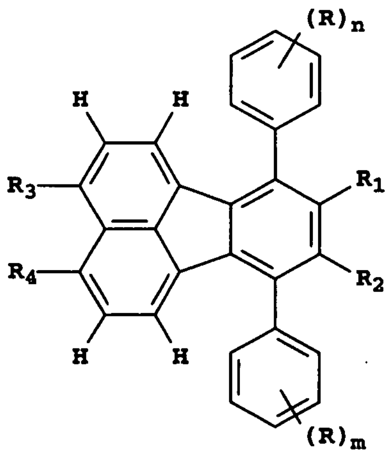

Formula (OP)

wherein

$R_1$, $R_2$, $R_3$ and $R_4$ are independently hydrogen or an aromatic group containing 6 to 24 carbon atoms with the proviso that any adjacent $R_1$-$R_4$ is not part of an annulated aromatic ring system;
R is hydrogen or an optional substituent; and

n and m are independently 1-5.

Examples of particularly suitable materials of the fluorathene compounds are:

OP-1

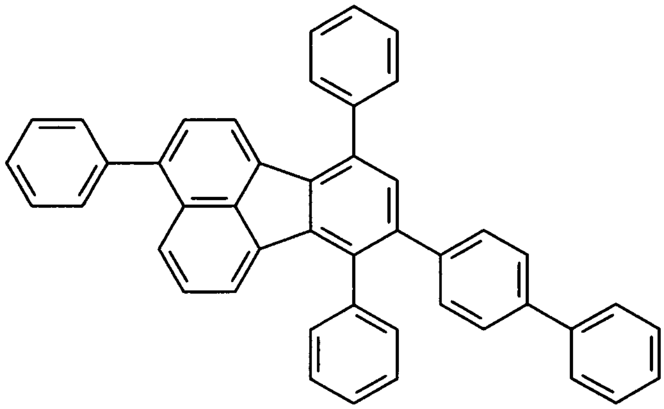

OP-2

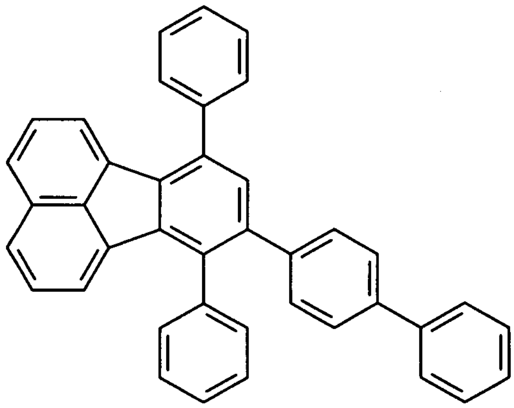

OP-3

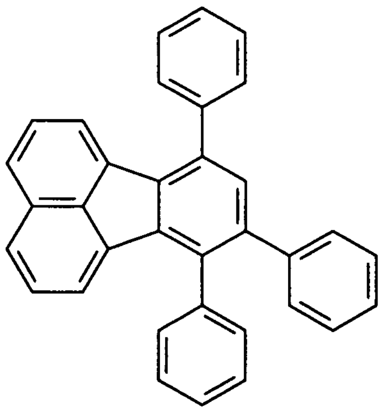

OP-4

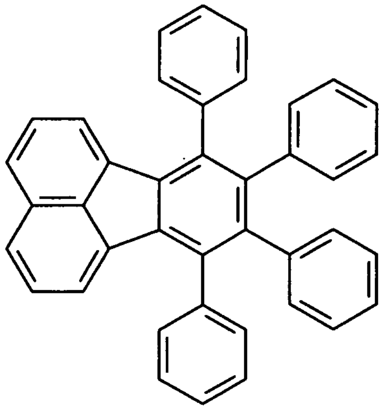

The following table lists the HOMO energy, LUMO energy, and the triplet energy of some representative structures of hosts in the phosphorescent LEL 150.

**Hosts of Light-Emitting Layer**

| Identifier | HOMO Energy | LUMO Energy | Triplet Energy | Structure |
|---|---|---|---|---|
| ETM-1 (TPBI) | -5.79 | -2.09 | 2.69 | 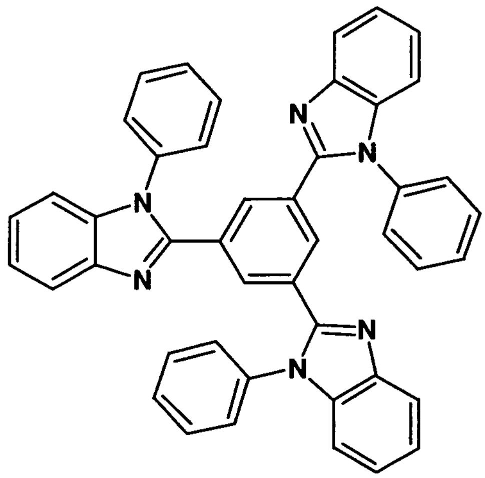 $E^{ox}$ = 1.7; $E^{red}$ = -2.02 |
| ETM-2 | < -6.10 | -2.74 | 2.95 | 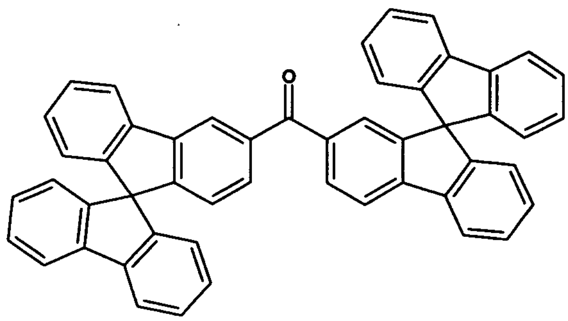 |

(continued)

| Identifier | HOMO Energy | LUMO Energy | Triplet Energy | Structure |
|---|---|---|---|---|
| ETM-3 (BPhen) | -6.03 | -2.29 | 2.64 | 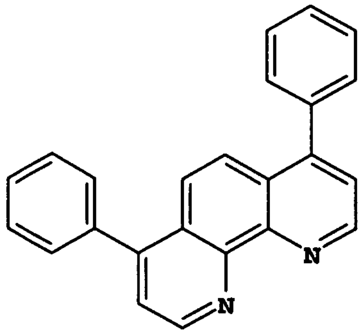 $E^{ox}$ = 1.8; $E^{red}$ = -1.9 |
| ETM-4 | -5.63 | -2.42 | 2.57 | 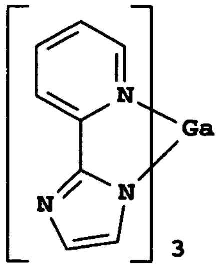 |
| ETM-5 | -5.69 | -2.69 | 2.43 | 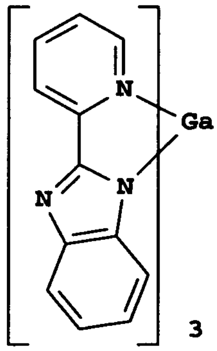 |
| ETM-6 | -5.63 | -2.39 | 2.47 | 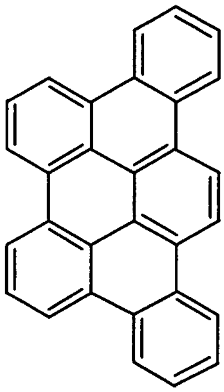 |

(continued)

| Identifier | HOMO Energy | LUMO Energy | Triplet Energy | Structure |
|---|---|---|---|---|
| ETM-7 | -5.55 | -2.26 | 2.47 | 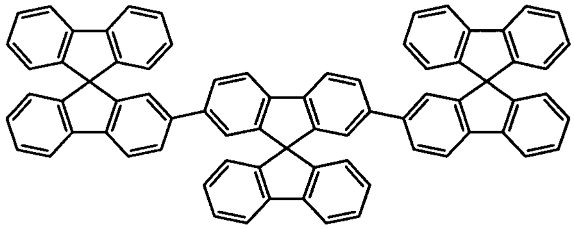 |
| ETM-8 | -5.54 | -2.41 | 2.25 | 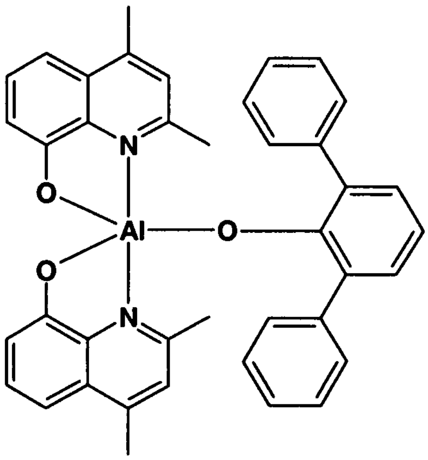 |
| ETM-9 | -5.58 | -2.50 | 2.21 | 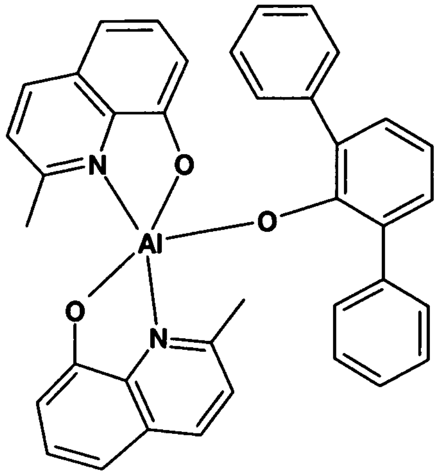 |
| ETM-10 | -5.95 | -2.61 | 2.29 | 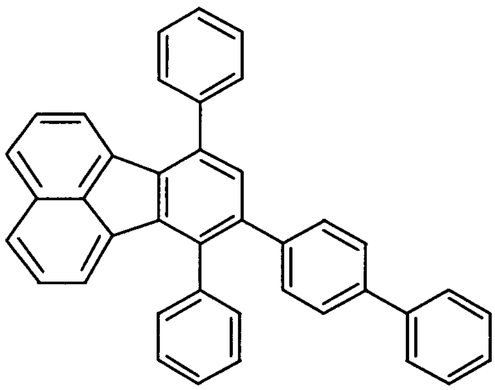 |

(continued)

| Identifier | HOMO Energy | LUMO Energy | Triplet Energy | Structure |
|---|---|---|---|---|
| ETM-11 (Balq) | -5.50 | -2.53 | 2.25 | 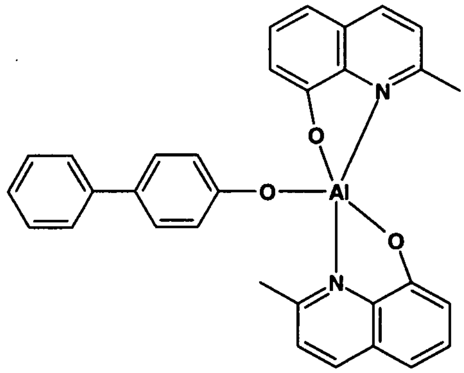 |
| ETM-12 (TBADN) | -5.44 | -2.40 | 1.86 | 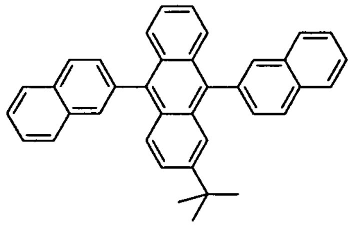 |
| ETM-13 (NPB) | -5.19 | -2.06 | 2.50 | 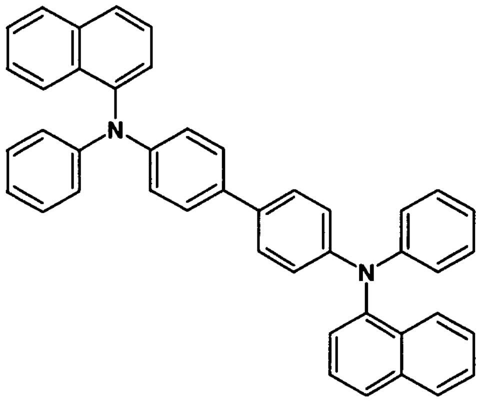 |
| ETM-15 (ALQ) | -5.36 | -2.51 | 2.11 | 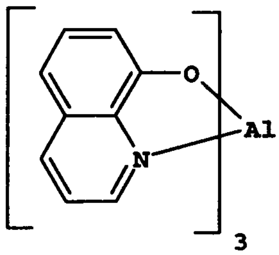 |
| ETM-16 (rubrene) | -5.17 | -2.85 | 1.24 | 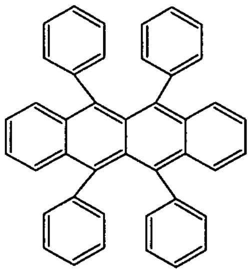 |

(continued)

| Identifier | HOMO Energy | LUMO Energy | Triplet Energy | Structure |
|---|---|---|---|---|
| ETM-17 (ADN) | -5.49 | -2.45 | 1.84 | 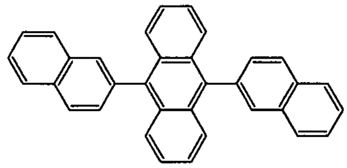 |
| ETM-18 (BCP) | -5.91 | -2.16 | 2.61 | 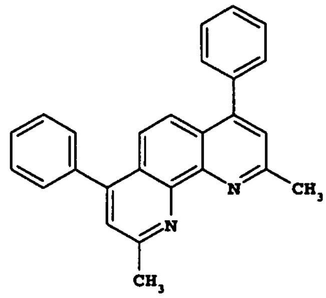 |
| ETM-19 | -5.58 | -2.30 | 2.76 | 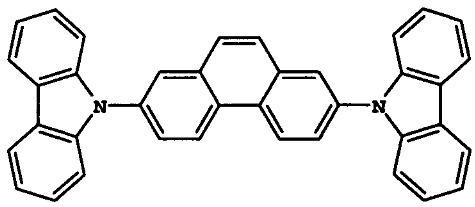 |

The phosphorescent dopant in the phosphorescent LEL 150 typically presents in an amount of from 1 to 25 % by volume of the light-emitting layer, and conveniently from 2 to 10 % by volume of the light-emitting layer. In some embodiments, the phosphorescent complex guest material(s) can be attached to one or more host materials. The host materials can further be polymers. For convenience, the phosphorescent complex guest material also can be referred to herein as a phosphorescent dopant.

Particularly useful phosphorescent dopants are described by Formula (P) below.

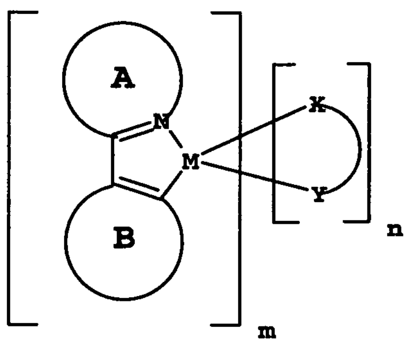

(P)

wherein:

A is a substituted or unsubstituted heterocyclic ring containing at least one N atom;
B is a substituted or unsubstituted aromatic or heteroaromatic ring, or ring containing a vinyl carbon bonded to M;
X-Y is an anionic bidentate ligand;
m is an integer from 1 to 3; and
n in an integer from 0 to 2 such that m + n = 3 for M = Rh or Ir; or
m is an integer from 1 to 2 and n in an integer from 0 to 1 such that m + n = 2 for M = Pt or Pd.

Compounds according to Formula (P) can be referred to as C,N-cyclometallated complexes to indicate that the central metal atom is contained in a cyclic unit formed by bonding the metal atom to carbon and nitrogen atoms of one or more ligands. Examples of heterocyclic ring A in Formula (P) include substituted or unsubstituted pyridine, quinoline, isoquinoline, pyrimidine, indole, indazole, thiazole, and oxazole rings. Examples of ring B in Formula (P) include substituted or unsubstituted phenyl, napthyl, thienyl, benzothienyl, furanyl rings. Ring B in Formula (P) can also be a N-containing ring such as pyridine, with the proviso that the N-containing ring bonds to M through a C atom as shown in Formula (P) and not the N atom.

An example of a tris-C,N-cyclometallated complex according to Formula (P) with m = 3 and n = 0 is tris(2-phenyl-pyridinato-N,$C^{2'}$-)Iridium(III), shown below in stereodiagrams as facial (*fac*-) or meridional (*mer*-) isomers.

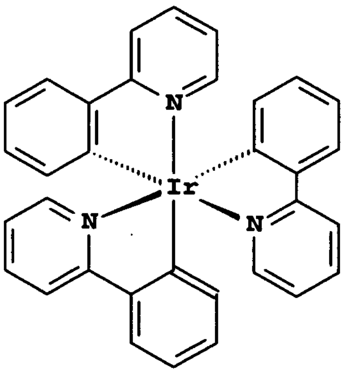

*Fac*

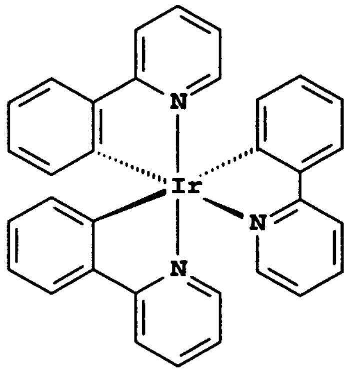

*Mer*

Generally, facial isomers are preferred since they are often found to have higher phosphorescent quantum yields than the meridional isomers. Additional examples of tris-C,N-cyclometallated phosphorescent dopants according to Formula (P) are tris(2-(4'-methylphenyl)pyridinato-N,$C^{2'}$)Iridium(III), tris(3-phenylisoquinolinato-N,$C^{2'}$)Iridium(III), tris(2-phenylquinolinato-N,$C^{2'}$)Iridium(III), tris(1-phenylisoquinolinato-N,$C^{2'}$)Iridium(III), tris(1-(4'-methylphenyl)isoquinolinato-N,$C^{2'}$)Iridium(III), tris(2-(4',6'-difluorophenyl)-pyridinato-N,$C^{2'}$)Iridium(III), tris(2-(5'-phenyl-4',6'-difluorophenyl)-pyridinato-N,$C^{2'}$)Iridium(III), tris(2-(5'-phenyl-phenyl)pyridinato-N,$C^{2'}$)Iridium(III), tris(2-(2'-benzothienyl)pyridinato-N,$C^{3'}$)Iridium(III), tris(2-phenyl-3,3'-dimethyl)indolato-N,$C^{2'}$)Ir(III), tris(1-phenyl-1H-indazolato-N,$C^{2'}$)Ir(III).

Tris-C,N-cyclometallated phosphorescent dopants also include compounds according to Formula (P) wherein the monoanionic bidentate ligand X-Y is another C,N-cyclometallating ligand. Examples include bis(1-phenylisoquinolinato-N,$C^{2'}$)(2-phenylpyridinato-N,$C^{2'}$)Iridium(III), bis(2-phenylpyridinato-N,$C^{2'}$)(1-phenylisoquinolinato-N,$C^{2'}$)Iridium(III), bis(1-phenylisoquinolinato-N,$C^{2'}$)(2-phenyl-5-methyl-pyridinato-N,$C^{2'}$)Iridium(III), bis(1-phenylisoquinolinato-N,$C^{2'}$)(2-phenyl-4-methyl-pyridinato-N,$C^{2'}$)Iridium(III), and bis(1-phenylisoquinolinato-N,$C^{2'}$)(2-phenyl-3-methyl-pyridinato-N,$C^{2'}$)Iridium(III).

Structural formulae of some tris-C,N-cyclometallated Iridium complexes are shown below.

| | |
|---|---|
| P-1 | 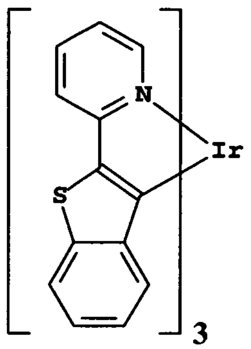 |

(continued)

| | |
|---|---|
| P-2 | 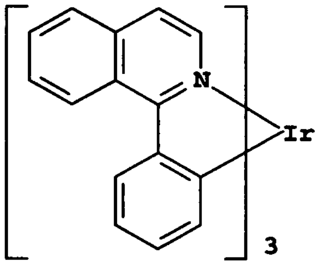 |
| P-3 | 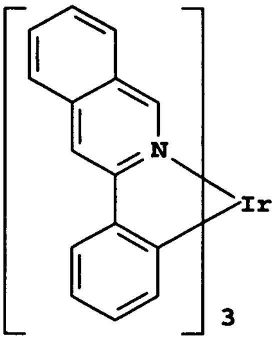 |
| P-4 | 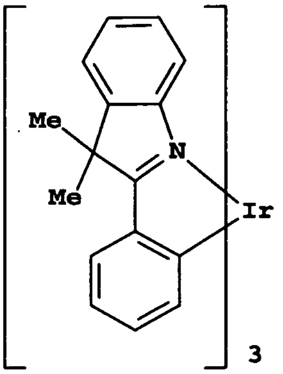 |
| P-5 | 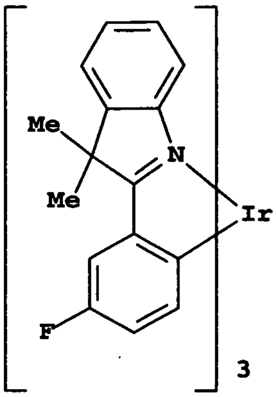 |

(continued)

| | |
|---|---|
| P-6 | 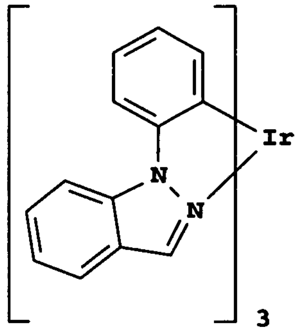 |
| P-7 | 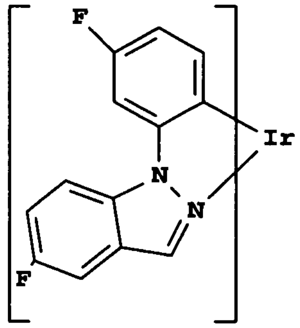 |
| P-8 | 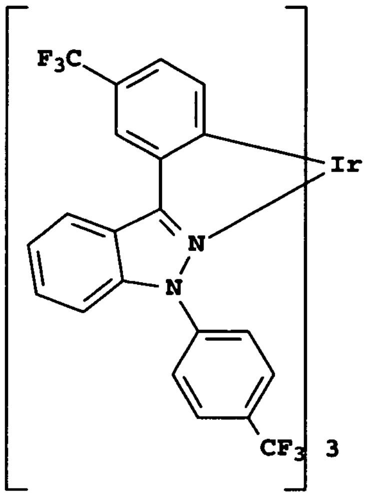 |
| P-9 | 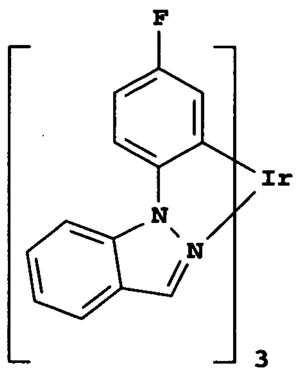 |

(continued)

| | |
|---|---|
| P-10 | 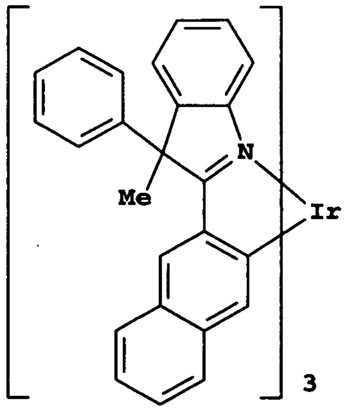 |
| P-11 | 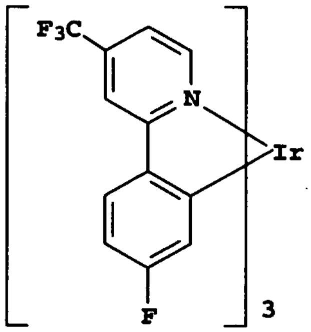 |
| P-12 | 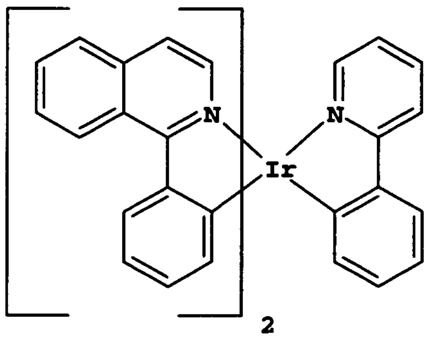 |
| P-13 | 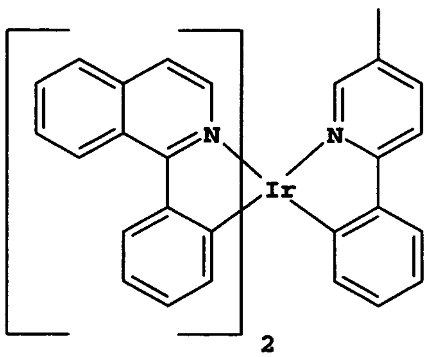 |

(continued)

| | |
|---|---|
| P-14 | 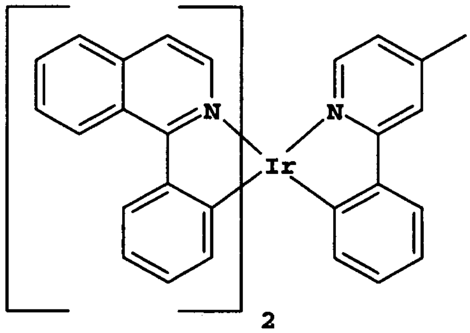 |
| P-15 | 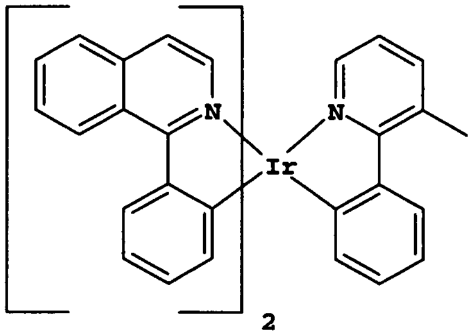 |

Suitable phosphorescent dopants according to Formula (P) can in addition to the C,N-cyclometallating ligand(s) also contain monoanionic bidentate ligand(s) X-Y that are not C,N-cyclometallating. Common examples are beta-diketonates such as acetylacetonate, and Schiff bases such as picolinate. Examples of such mixed ligand complexes according to Formula (P) include bis(2-phenylpyridinato-N,$C^{2'}$)Iridium(III)(acetylacetonate), bis(2-(2'-benzothienyl)pyridinato-N,$C^{3'}$)Iridium(III)(acetylacetonate), and bis(2-(4',6'-difluorophenyl)-pyridinato-N,$C^{2'}$)Iridium(III)(picolinate).

Other important phosphorescent dopants according to Formula (P) include C,N-cyclometallated Pt(II) complexes such as cis-bis(2-phenylpyridinato-N,$C^{2'}$)platinum(II), cis-bis(2-(2'-thienyl)pyridinato-N,$C^{3'}$) platinum(II), cis-bis(2-(2'-thienyl)quinolinato-N,$C^{5'}$) platinum(II), or (2-(4',6'-difluorophenyl)pyridinato-N,$C^{2'}$) platinum (II) (acetylacetonate).

In addition to bidentate C,N-cyclometallating complexes represented by Formula (P), many suitable phosphorescent emitters contain multidentate C,N-cyclometallating ligands. Phosphorescent emitters having tridentate ligands suitable for use in the present invention are disclosed in U.S. Patent Nos. 6,824,895 B1 and 7,029,766 and references therein, incorporated in their entirety herein by reference. Phosphorescent dopants having tetradentate ligands suitable for use in the present invention are described by the following formulae:

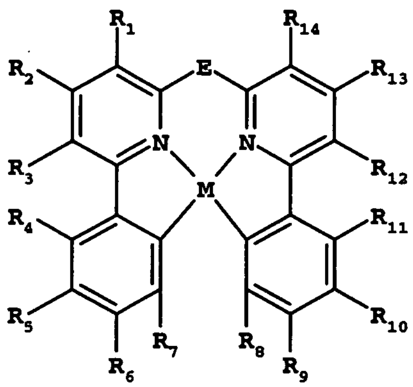

(P-T-a)

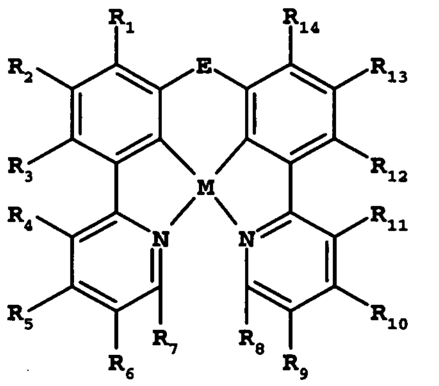

(P-T-b)

wherein:

M is Pt or Pd;

$R^1$-$R^7$ represent hydrogen or independently selected substituents, provided that $R^1$ and $R^2$, $R^2$ and $R^3$, $R^3$ and $R^4$, $R^4$ and $R^5$, $R^5$ and $R^6$, as well as $R^6$ and $R^7$ can join to form a ring group;

$R^8$-$R^{14}$ represent hydrogen or independently selected substituents, provided that $R^8$ and $R^9$, $R^9$ and $R^{10}$, $R^{10}$ and $R^{11}$, $R^{11}$ and $R^{12}$, $R^{12}$ and $R^{13}$, as well as $R^{13}$ and $R^{14}$ can join to form a ring group;

E represents a bridging group selected from the following:

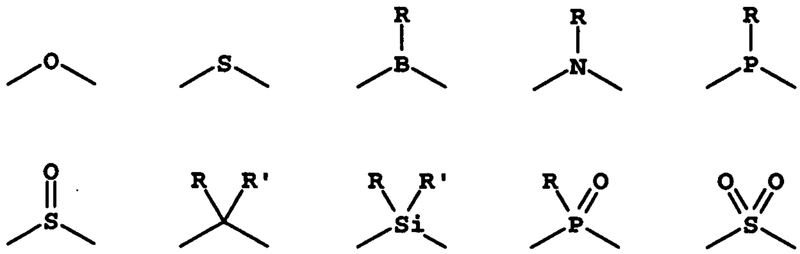

wherein R and R' represent hydrogen or independently selected substituents; provided R and R' can combine to form a ring group.

In one desirable embodiment, the tetradentate C,N-cyclometallated phosphorescent emitter suitable for use in the present invention is represented by the following formula:

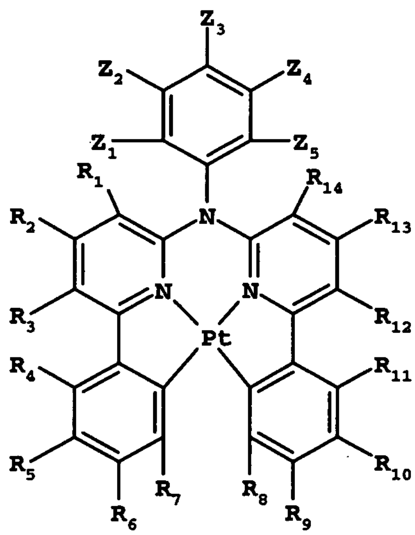

(P-T-c)

wherein,

$R^1$-$R^7$ represent hydrogen or independently selected substituents, provided that $R^1$ and $R^2$, $R^2$ and $R^3$, $R^3$ and $R^4$, $R^4$ and $R^5$, $R^5$ and $R^6$, as well as $R^6$ and $R^7$ can combine to form a ring group;
$R^8$-$R^{14}$ represent hydrogen or independently selected substituents, provided that $R^8$ and $R^9$, $R^9$ and $R^{10}$, $R^{10}$ and $R^{11}$, $R^{11}$ and $R^{12}$, $R^{12}$ and $R^{13}$, as well as $R^{13}$ and $R^{14}$ can combine to form a ring group;
$Z^1$-$Z^5$ represent hydrogen or independently selected substituents, provided that $Z^1$ and $Z^2$, $Z^2$ and $Z^3$, $Z^3$ and $Z^4$, as well as $Z^4$ and $Z^5$ can combine to form a ring group.

Examples of phosphorescent dopants having tetradentate C,N-cyclometallating ligands include the compounds represented below.

| | |
|---|---|
| 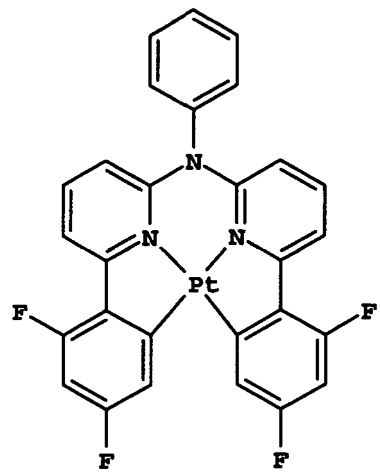 | Q-1 |
| 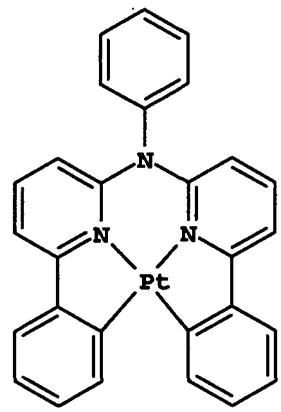 | Q-2 |

(continued)

| | |
|---|---|
| 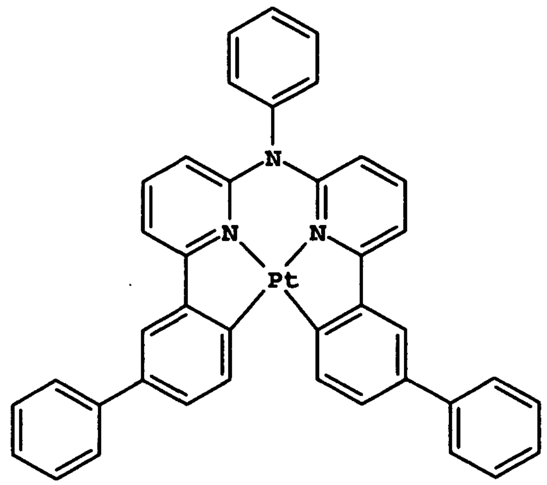 | Q-3 |

The emission wavelengths (color) of C,N-cyclometallated phosphorescent dopants according to Formulas (P), (P-T-a), (P-T-b) and (P-T-c) are governed principally by the lowest energy optical transition of the complex and hence by the choice of the C,N-cyclometallating ligand. For example, 2-phenyl-pyridinato-N,$C^{2'}$ complexes are typically green emissive while 1-phenyl-isoquinolinolato-N,$C^{2'}$ complexes are typically red emissive. In the case of complexes having more than one C,N-cyclometallating ligand, the emission will be that of the ligand having the property of longest wavelength emission. Emission wavelengths can be further shifted by the effects of substituent groups on the C,N-cyclometallating ligands. For example, substitution of electron donating groups at appropriate positions on the N-containing ring A or electron withdrawing groups on the C-containing ring B tend to blue-shift the emission relative to the unsubstituted C,N-cyclometallated ligand complex. Selecting a monodentate anionic ligand X,Y in Formula (P) having more electron withdrawing properties also tends to blue-shift the emission of a C,N-cyclometallated ligand complex. Examples of complexes having both monoanionic bidentate ligands possessing electron-withdrawing properties and electron-withdrawing substituent groups on the C-containing ring B include bis(2-(4',6'-difluorophenyl)-pyridinato-N,$C^{2'}$)iridium(III)(picolinate); bis(2-[4"-trifluoromethyl-5'-phenyl-(4',6'-difluorophenyl)-pyridinato-N,$C^{2'}$)iridium(III)(picolinate); bis(2-(5'-phenyl-4',6'-difluorophenyl)-pyridinato-N,$C^{2'}$)iridium(III)(picolinate); bis(2-(5'-cyano-4',6'-difluorophenyl)-pyridinato-N,$C^{2'}$)iridium(III)(picolinate); bis(2-(4',6'-difluorophenyl)-pyridinato-N, $C^{2'}$)iridium(III)(tetrakis(1-pyrazolyl)borate); bis[2-(4',6'-difluorophenyl)-pyridinato- N,$C^{2'}$]{2-[(3-trifluoromethyl)-1H-pyrazol-5-yl]pyridinato-N,N'}iridium(III); bis[2-(4',6'-difluorophenyl)-4-methylpyridinato-N,$C^{2'}$] {2-[(3-trifluoromethyl)-1H-pyrazol-5-yl]pyridinato-N,N'}iridium(III); and bis[2-(4',6'-difluorophenyl)-4-methoxypyridinato- N,$C^{2'}$]{2-[(3-trifluoromethyl)-1H-pyrazol-5-yl]pyridinato-N,N'} iridium(III).

The central metal atom in phosphorescent dopants according to Formula (P) can be Rh or Ir for (m + n = 3) and Pd or Pt (m + n = 2). Preferred metal atoms are Ir and Pt since these tend to give higher phosphorescent quantum efficiencies according to the stronger spin-orbit coupling interactions generally obtained with elements in the third transition series.

Other phosphorescent dopants that do not involve C,N-cyclometallating ligands are known. Phosphorescent complexes of Pt(II), Ir(I), and Rh(I) with maleonitriledithiolate have been reported (Johnson et al, J. Am. Chem. Soc., 105,1795-1802 (1983)). Re(I) tricarbonyl diimine complexes are also known to be highly phosphorescent (Wrighton and Morse, J. Am. Chem. Soc., 96, 998-1003 (1974); Stufkens, Comments Inorg. Chem., 13, 359-385 (1992); Yam, Chem. Commun., 2001, 789-796)). Os(II) complexes containing a combination of ligands including cyano ligands and bipyridyl or phenanthroline ligands have also been demonstrated in a polymer OLED (Ma et al, Synthetic Metals, 94, 245-248 (1998)).

Porphyrin complexes such as 2,3,7,8,12,13,17,18-octaethyl-21H, 23H-porphine platinum(II) are also useful phosphorescent dopants.

Still other examples of useful phosphorescent dopants include coordination complexes of the trivalent lanthanides such as $Tb^{3+}$ and $Eu^{3+}$ (Kido et al., Chem Lett., 657 (1990); J. Alloys and Compounds, 192, 30-33 (1993); Jpn J. Appl Phys, 35, L394-6 (1996) and Appl. Phys. Lett., 65, 2124 (1994)).

Additional information on suitable phosphorescent dopants, incorporated herein by reference, can be found in US 6,303,238 B1, WO 00/57676, WO 00/70655, WO 01/41512 A1, US 2002/0182441 A1, US 2003/0017361 A1, US 2003/ 0072964 A1, US 6,413,656 B1, US 6,687,266 B1, US 2004/0086743 A1, US 2004/0121184 A1, US 2003/0059646 A1, US 2003/0054198 A1, EP 1 239 526 A2, EP 1 238 981 A2, EP 1 244 155 A2, US 2002/0100906 A1, US 2003 / 0068526 A1, US 2003/0068535 A1, JP 2003073387A, JP 2003 073388A, US 6,677,060 B2, US 2003/0235712 A1, US

2004/0013905 A1, US 6,733,905 B2, US 6,780,528 B2,US 2003/0040627 A1, JP 2003059667A, JP 2003073665A, US 2002/0121638 A1, EP 1371708A1, US 2003/010877 A1, WO 03/040256 A2, US 2003/0096138 A1, US 2003/0173896 A1, US 6,670645 B2, US 2004/0068132 A1, WO 2004/015025 A1, US 2004/0072018 A1, US 2002/0134984 A1, WO 03/079737 A2, WO 2004/020448 A1, WO 03/091355 A2, US 7,101,631, US 7147,937, US 7118,812, US 7,029,766, US 6,870,054, US 6,835,835, and US 6,824,895 B1.

The HOMO energy, LUMO energy, and the triplet energy of some suitable phosphorescent dopants are shown in the table below:

**Phosphorescent Dopants**

| Identifier | HOMO Energy | LUMO Energy | Triplet Energy | Structure |
|---|---|---|---|---|
| $Ir(ppy)_3$ | -5.27 | -2.10 | 2.54 | 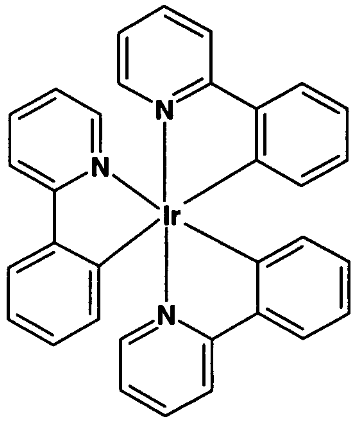 $E^{ox}$ = 0.77; $E^{red}$ = -2.27 |
| $Ir(piq)_3$ | -5.24 | -2.63 | 2.12 | 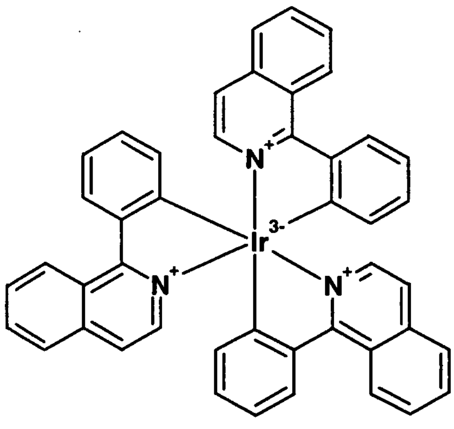 |
| OEPPT | -5.40 | -2.67 | 2.13 | 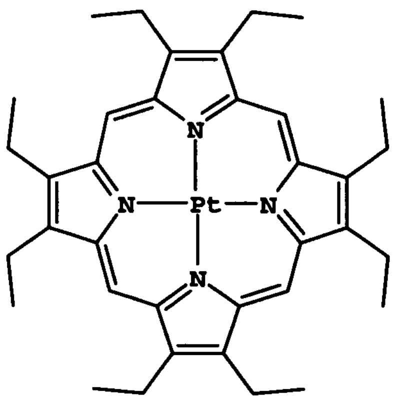 |

(continued)

| Identifier | HOMO Energy | LUMO Energy | Triplet Energy | Structure |
|---|---|---|---|---|
| $Ir(ppy)_2cou1$ | -5.45 | -2.33 | 2.36 | 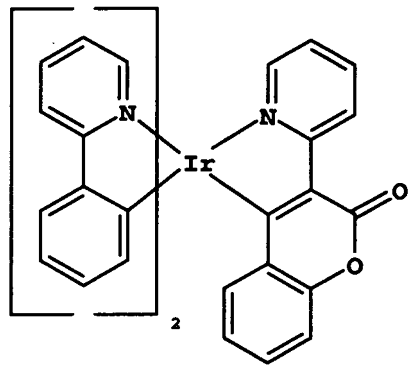 |
| Ir(cou2)2 ppy | -5.39 | -2.48 | 2.51 | 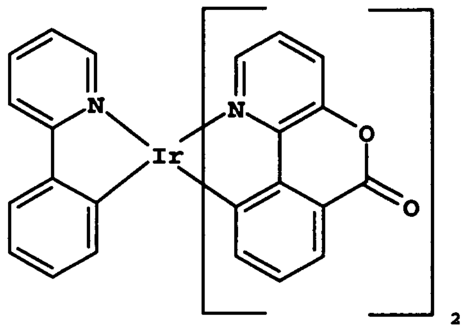 |

As an example, the phosphorescent dopant in the phosphorescent LEL can be selected from tris(1-phenylisoquinoline) iridium (III) ($Ir(piq)_3$), $Ir(ppy)_2cou1$, $Ir(cou2)_2ppy$ or tris(2-phenylpyridine) iridium (III) ($Ir(ppy)_3$).

Phosphorescent LEL 150 includes one phosphorescent dopant selected from phosphorescent materials with different colors. Phosphorescent LEL 150 also can include two phosphorescent dopants selected from phosphorescent light-emitting materials with different colors. Furthermore, phosphorescent LEL 150 also can produce white light.

The thickness of the phosphorescent LEL 150 is greater than 0.5 nm, preferably, in the range of from 1.0 nm to 40 nm.

The first HBL 161 disposed in contact with the phosphorescent LEL 150 at the cathode side is desirable to help confine carrier recombination to the LEL 150. Therefore, there should be an energy barrier for hole migration from the LEL 150 into the first HBL 161. In order to block holes, the HOMO energy of the first hole-blocking material in the first HBL 161 should be lower than that of the predominant host in the phosphorescent LEL 150. Moreover, the first HBL 161 is also desirable to help confine excitons to the LEL 150. Therefore, the triplet energy of the first hole-blocking material in the first HBL 161 should be greater than that of the predominant host in the phosphorescent LEL 150.

Since the first HBL 161 is disposed in contact with the LEL 150 at the cathode side, the first HBL 161 should facilitate electrons passing readily from the first HBL 161 into the LEL 150. Therefore, the first hole-blocking material in the first HBL 161 should be a suitable electron-transporting material. Moreover, in order to facilitate the electron injection from the first HBL 161 into the LEL 150, the LUMO energy difference between the predominant host in the LEL 150 and the first hole-blocking material in the first HBL 161 is less than 0.5 V. Preferably, the LUMO energy difference is less than 0.3 V.

A desirable first hole-blocking material can include any suitable electron-transporting material, such as benzazole, phenanthroline, 1,3,4-oxadiazole, triazole, triazine, fluoranthene, or triarylborane, as long as it has a lower HOMO energy and a higher triplet energy than those of the predominant host in the phosphorescent LEL 150.

For example, the suitable electron-transporting material includes bis(9,9'-spirobifluoren-2-yl) compound, such as the material selected from:

X-1

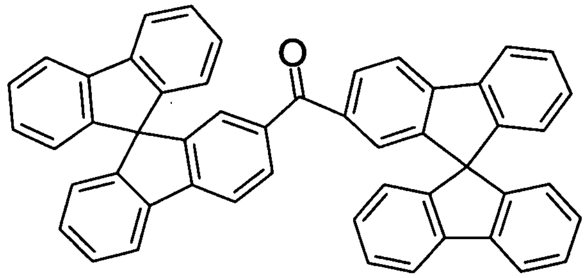

,

X-2

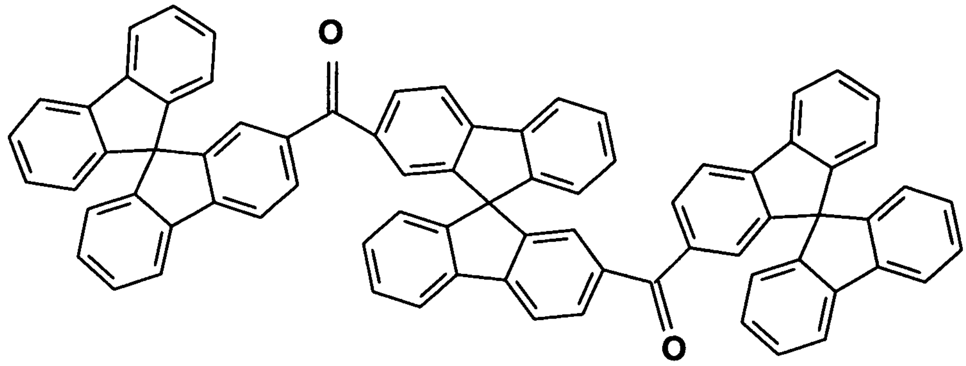

,

X-3

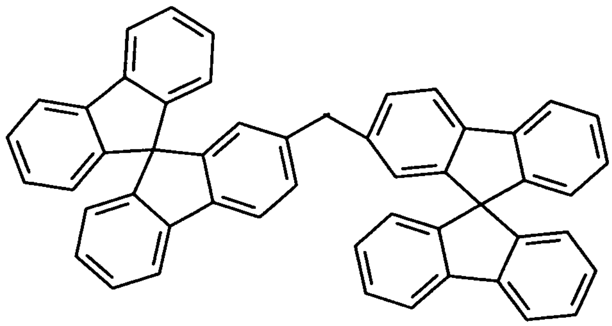

,

or

X-4

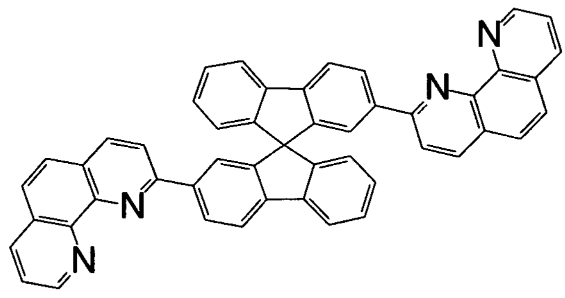

.

The suitable electron-transporting material includes a benzazole derivative represented by structural formula (K):

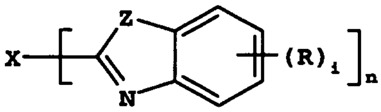

(K)

wherein:

n is selected from 2 to 8 and i is selected from 1-5;
Z is independently O, NR or S;
R is individually hydrogen; alkyl of from 1 to 24 carbon atoms aryl or hetero-atom substituted aryl of from 5 to 20 carbon atoms, halo, or atoms necessary to complete a fused aromatic ring; and
X is a linkage unit including carbon, alkyl, aryl, substituted alkyl, or substituted aryl, which conjugately or unconjugately connects the multiple benzazoles together.

An exemplary of benzazole derivative includes 2,2',2"-(1,3,5-phenylene)tris[1-phenyl-1H-benzimidazole] (TPBI).

A suitable electron-transporting material includes an aluminum or gallium complex represented by Formula (R-a):

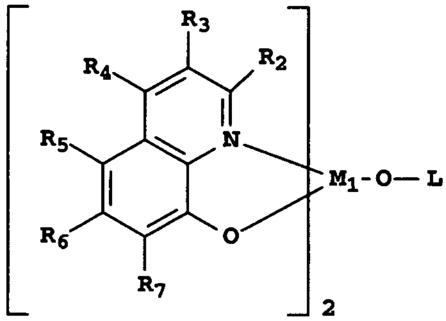

(R-a)

wherein:

$M_1$ is Al or Ga; and
$R_2$-$R_7$ independently represent hydrogen or an alkyl group; and
L is an aromatic moiety with 6 to 30 carbon atoms.

An exemplary of aluminum or gallium complex includes aluminum(III) bis(2-methyl-8-hydroxyquinoline)-4-phenylphenolate [alias, Balq] and gallium oxine [alias, tris(8-quinolinolato)gallium(III).

The thickness of the first hole-blocking layer can be between 1 and 80 nm and suitably between 2 and 40 nm.

The second HBL 162 disposed in contact with the first HBL 161 at the cathode side is desirable to further help confine carrier recombination events to the LEL 150. Therefore, there should be an energy barrier for hole migration from the LEL 150 into the second HBL 162 through the first HBL 161. In order to further block holes, the HOMO energy of the second hole-blocking material in the second HBL 162 should be lower than that of the predominant host in the phosphorescent LEL 150. Preferably, the HOMO energy of the second hole-blocking material in the second HBL 162 should be lower than that of the first hole-blocking material in the first HBL 161. Moreover, the second HBL 162 is also desirable to help confine excitons to the LEL 150. Therefore, the triplet energy of the second hole-blocking material in the second HBL 162 should be greater than that of the dopant in the phosphorescent LEL 150. Preferably, the triplet energy of the second hole-blocking material in the second HBL 162 should be greater than that of the predominant host in the phosphorescent LEL 150.

Since the second HBL 162 is disposed in contact with the first HBL 161 at the cathode side, the second HBL 162 should facilitate electrons passing readily from the second HBL 162 into the first HBL 161. Therefore, the second hole-blocking material in the second HBL 162 should be a suitable electron-transporting material. Moreover, in order to facilitate the electron injection from the second HBL 162 into the first HBL 161, the LUMO energy difference between the first hole-blocking material in the fist HBL 161 and the second hole-blocking material in the second HBL 162 is less than 0.5 V. Preferably, the LUMO energy difference is less than 0.3 V.

Similar to the first hole-blocking material, a desirable second hole-blocking material can also include any suitable electron-transporting material, such as benzazole, phenanthroline, 1,3,4-oxadiazole, triazole, triazine, fluoranthene, or

triarylborane, as long as it has a lower HOMO energy than that of the predominant host in the phosphorescent LEL 150 and a higher triplet energy than that of the dopant in the phosphorescent LEL 150.

For example, the suitable electron-transporting material includes phenanthroline compound, such as: BCP (see Formula L-1) and Bphen (see Formula L-2).

The ETL 170, disposed in contact with the second HBL 162, contains at least one electron-transporting material such as benzazole, phenanthroline, 1,3,4-oxadiazole, triazole, triazine, or triarylborane as discussed in the phosphorescent LEL 150. For example, these electron-transporting materials have the molecular structures of Formula K, Formula L, Formula M-a, M-b, Formula N-1 and N-2, and Form O-1 as discussed previously.

In addition to the aforementioned electron-transporting materials, the electron-transporting materials for use in the ETL 170 can also be selected from, but are not limited to, chelated oxinoid compounds, anthracene derivatives, pyridine-based materials, imidazoles, oxazoles, thiazoles and their derivatives, polybenzobisazoles, cyano-containing polymers and perfluorinated materials.

For example, the electron-transporting materials for use in the ETL 170 can be a metal chelated oxinoid compound including chelates of oxine itself (also commonly referred to as 8-quinolinol or 8-hydroxyquinoline). Exemplary of contemplated oxinoid compounds are those satisfying structural Formula (R)

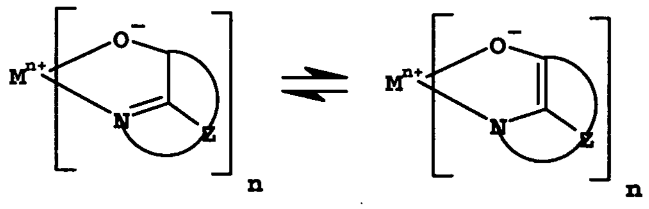

(R)

wherein:

- M represents a metal;
- n is an integer of from 1 to 4; and
- Z independently in each occurrence represents the atoms completing a nucleus having at least two fused aromatic rings.

Particularly useful electron-transporting aluminum or gallium complex host materials are represented by Formula (R-a).

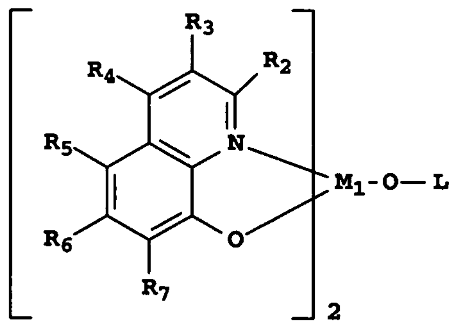

(R-a)

In Formula (R-a), $M_1$ represents Al or Ga. $R_2$ - $R_7$ represent hydrogen or an independently selected substituent. Desirably, $R_2$ represents an electron-donating group. Suitably, $R_3$ and $R_4$ each independently represent hydrogen or an electron donating substituent. A preferred electron-donating group is alkyl such as methyl. Preferably, $R_5$, $R_6$, and $R_7$ each independently represent hydrogen or an electron-accepting group. Adjacent substituents, $R_2$ - $R_7$, can combine to form a ring group. L is an aromatic moiety linked to the aluminum by oxygen, which can be substituted with substituent groups such that L has from 6 to 30 carbon atoms.

Illustrative of useful chelated oxinoid compounds for use in the ETL 170 are the following:

R-1: Aluminum trisoxine [alias, tris(8-quinolinolato)aluminum(III) or Alq or Alq3];
R-2: Magnesium bisoxine [alias, bis(8-quinolinolato)magnesium(II)];
R-3: Bis[benzo{f}-8-quinolinolato]zinc (II);
R-4: Bis(2-methyl-8-quinolinolato)aluminum(III)-$\mu$-oxo-bis(2-methyl-8-quinolinolato) aluminum(III);

R-5: Indium trisoxine [alias, tris(8-quinolinolato)indium];
R-6: Aluminum tris(5-methyloxine) [alias, tris(5-methyl-8-quinolinolato) aluminum(III)];
R-7: Lithium oxine [alias, (8-quinolinolato)lithium(I)];
R-8: Gallium oxine [alias, tris(8-quinolinolato)gallium(III)]; and
R-9: Zirconium oxine [alias, tetra(8-quinolinolato)zirconium(IV)]
R-a-1: Aluminum(III) bis(2-methyl-8-hydroxyquinoline)-4-phenylphenolate [alias, Balq].

As another example, anthracene derivatives according to Formula (S) as useful in the ETL 170:

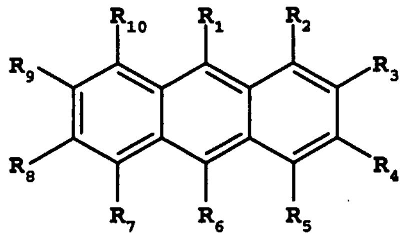

(S)

wherein $R_1$-$R_{10}$ are independently chosen from hydrogen, alkyl groups for 1-24 carbon atoms or aromatic groups from 1-24 carbon atoms. Particularly preferred are compounds where $R_1$ and $R_6$ are phenyl, biphenyl or napthyl, $R_3$ is phenyl, substituted phenyl or napthyl and $R_2$, $R_4$, $R_5$, $R_7$-$R_{10}$ are all hydrogen. Some illustrative examples of suitable anthracenes are:

(S-1)

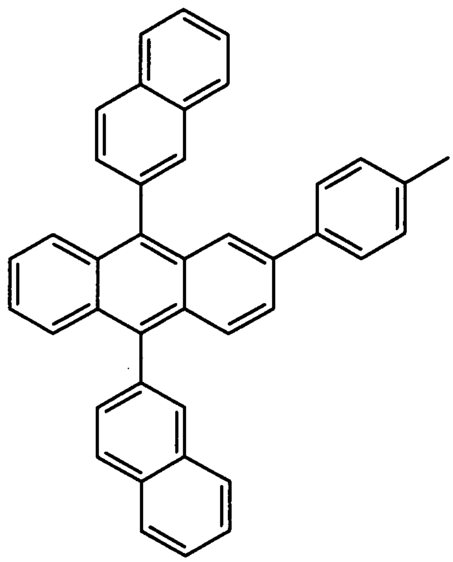

(S-2)

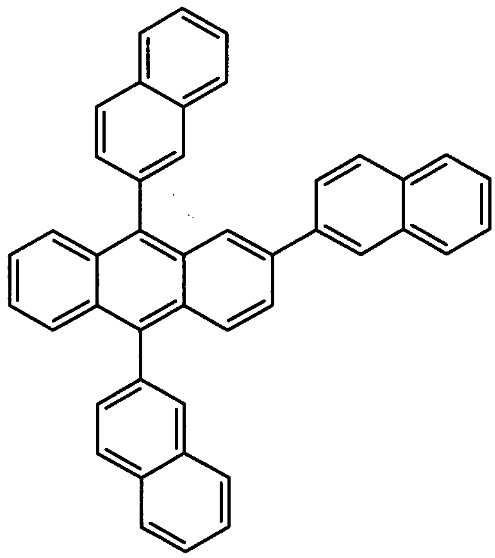

(S-3)

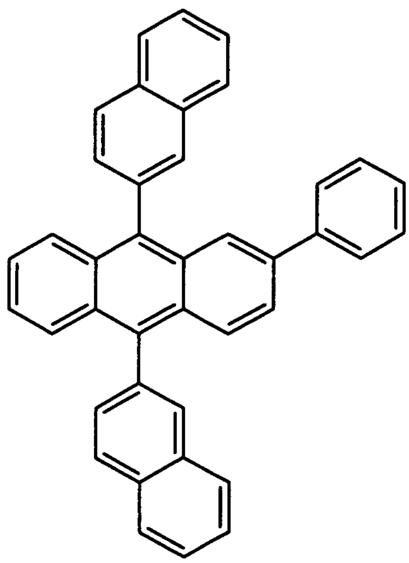

(S-4)

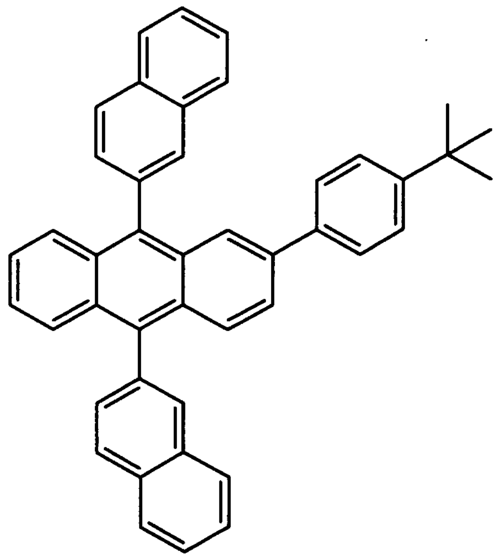

(S-5)

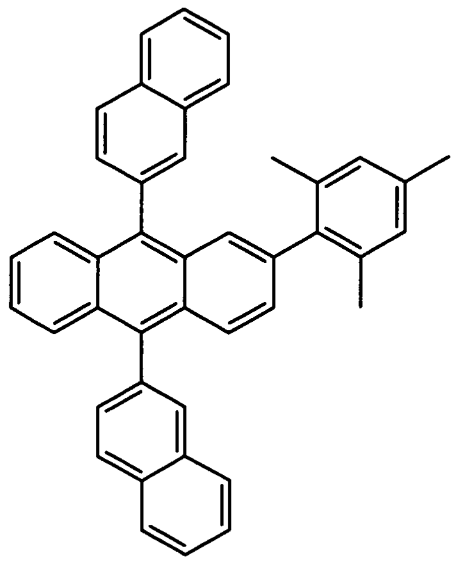

(S-6)

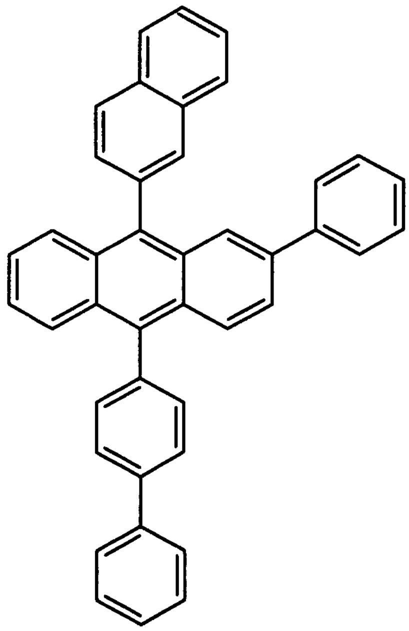

(S-7)

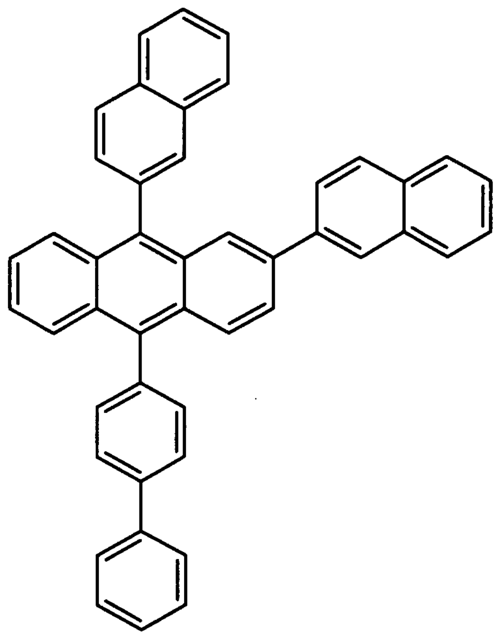

(S-8)

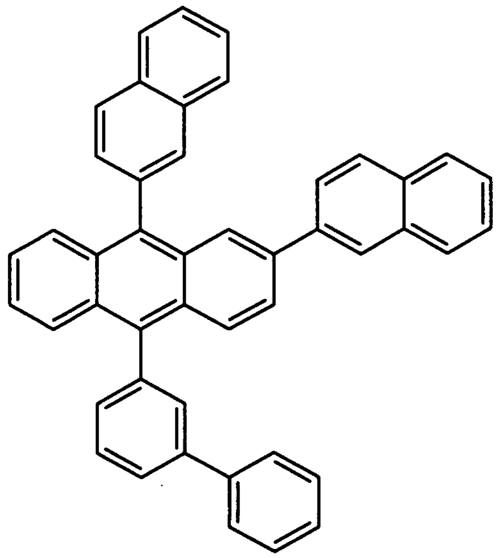

(S-9)

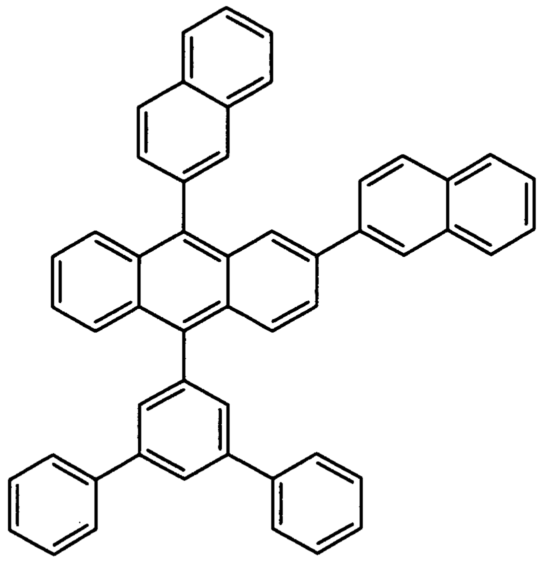

(S-10)

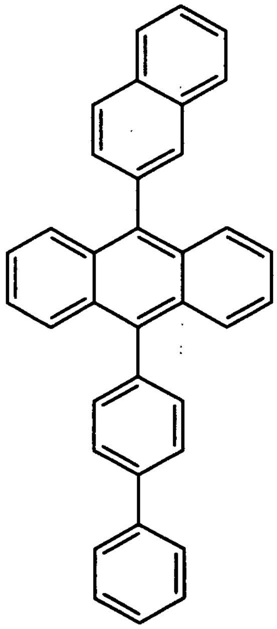

(S-11)

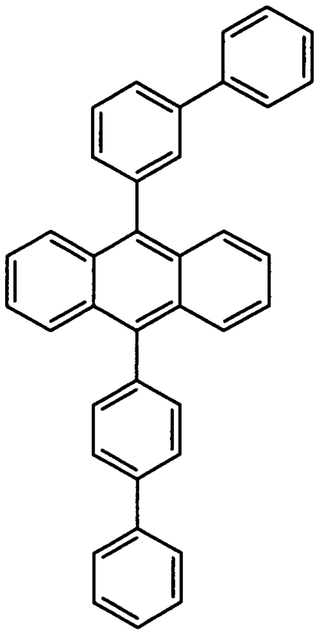

(S-12)

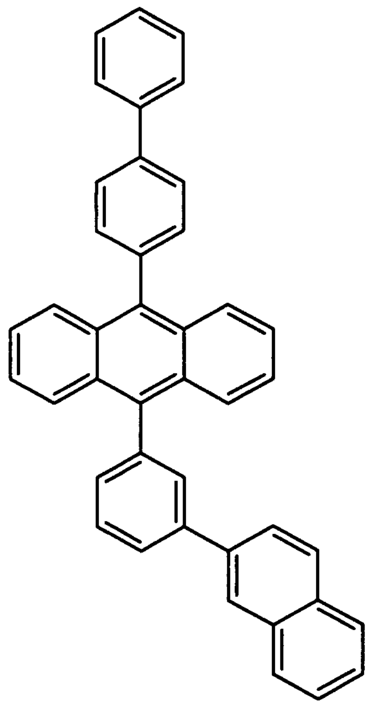

(S-13)

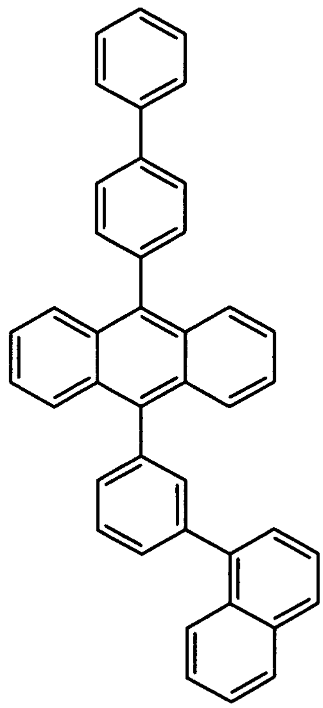

(S-14)

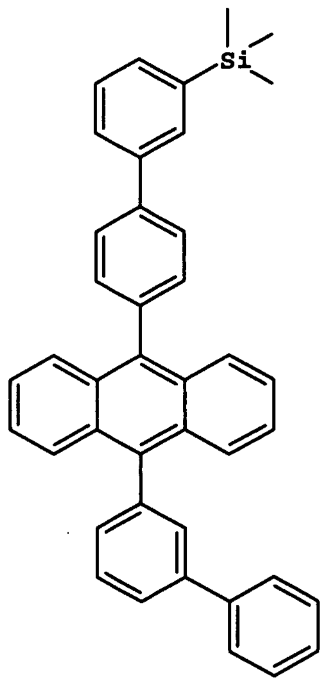

(S-15)

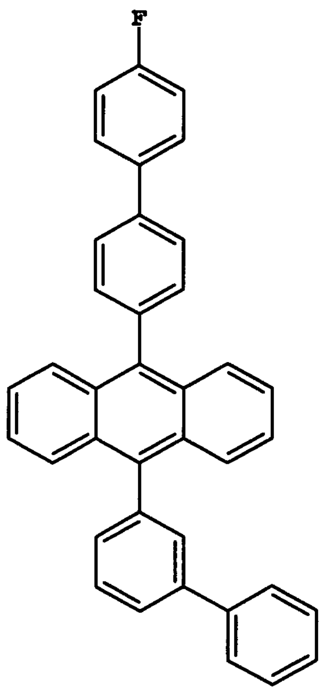

(S-16)

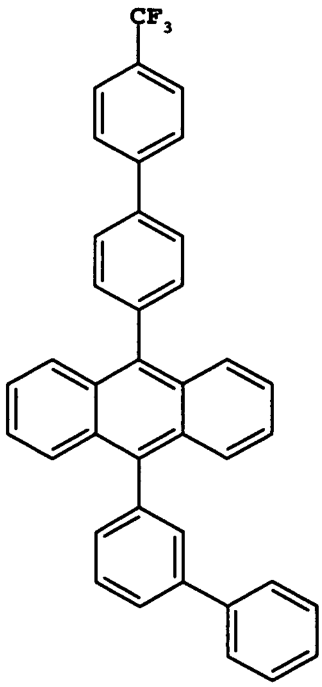

(S-17)

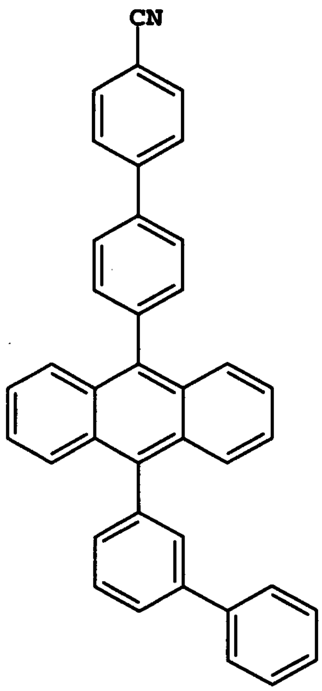

(S-18)

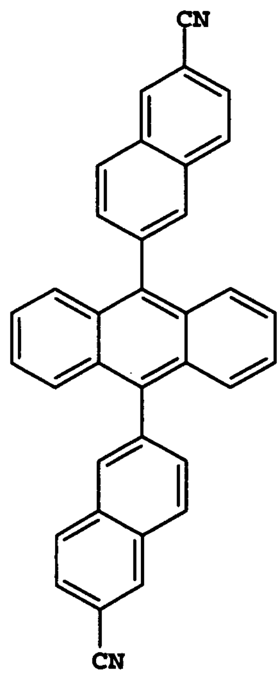

(S-19)

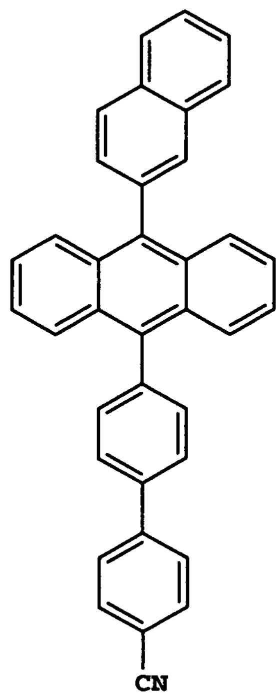

(S-20)

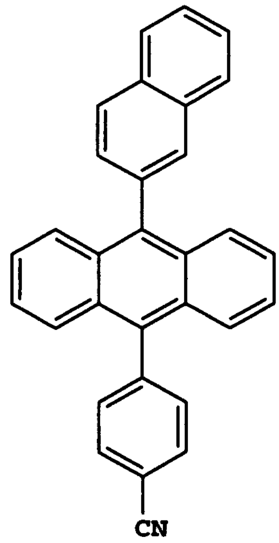

ETL 170 can also be an n-type doped layer containing at least one electron-transporting material as a host and at least one n-type dopant. The dopant is capable of reducing the host by charge transfer. The term "n-type doped layer" means that this layer has semiconducting properties after doping, and the electrical current through this layer is substantially carried by the electrons.

The host in ETL 170 is an electron-transporting material capable of supporting electron injection and electron transport. The electron-transporting material can be selected from the electron-transporting materials as defined above.

The n-type dopant in the n-type doped ETL 170 is selected from alkali metals, alkali metal compounds, alkaline earth metals, or alkaline earth metal compounds, or combinations thereof. The term "metal compounds" includes organometallic complexes, metal-organic salts, and inorganic salts, oxides and halides. Among the class of metal-containing n-type dopants, Li, Na, K, Rb, Cs, Mg, Ca, Sr, Ba, La, Ce, Sm, Eu, Tb, Dy, or Yb, and their compounds, are particularly useful. The materials used as the n-type dopants in the n-type doped ETL 170 also include organic reducing agents with strong electron-donating properties. By "strong electron-donating properties" it is meant that the organic dopant should be able to donate at least some electronic charge to the host to form a charge-transfer complex with the host. Nonlimiting examples of organic molecules include bis(ethylenedithio)-tetrathiafulvalene (BEDT-TTF), tetrathiafulvalene (TTF), and their derivatives. In the case of polymeric hosts, the dopant is any of the above or also a material molecularly dispersed or copolymerized with the host as a minor component. Preferably, the n-type dopant in the n-type doped ETL 170 includes Li, Na, K, Rb, Cs, Mg, Ca, Sr, Ba, La, Ce, Nd, Sm, Eu, Tb, Dy, or Yb, or combinations thereof. The n-type doped concentration is preferably in the range of 0.01-20% by volume of this layer.

In order to facilitate the electron injection from the ETL 170 into the second HBL 162, the LUMO energy difference between the second hole-blocking material in the second HBL 162 and the electron-transporting material in the ETL 170 is less than 0.5 V. Preferably, the LUMO energy difference is less than 0.3 V.

The thickness of the ETL 170 is in the range of from 5 nm to 200 nm, preferably, in the range of from 10 nm to 150 nm.

EIL 180 can include alkaline metal complexes or alkaline earth metal complexes. Wherein, the metal complex in the electron-injecting layer includes a cyclometallated complex represented by Formula (T)

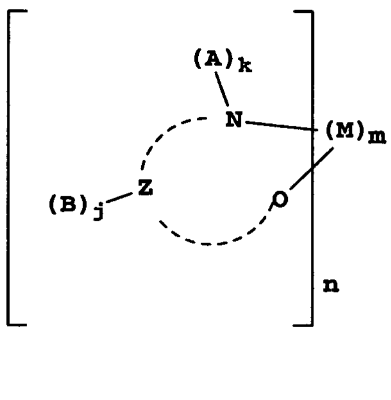

(T)

wherein:

Z and the dashed arc represent two or three atoms and the bonds necessary to complete a 5- or 6-membered ring with M;

each A represents H or a substituent and each B represents an independently selected substituent on the Z atoms, provided that two or more substituents can combine to form a fused ring or a fused ring system;

j is 0-3 and k is 1 or 2;

M represents an alkali metal or an alkaline earth metal; and

m and n are independently selected integers selected to provide a neutral charge on the complex.

Illustrative examples of useful electron-injecting materials include, but are not limited to, the following:

(T-1)

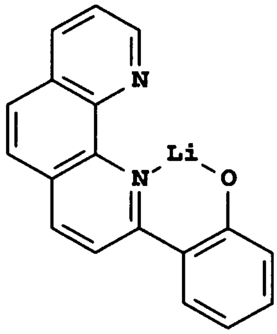

(T-2)

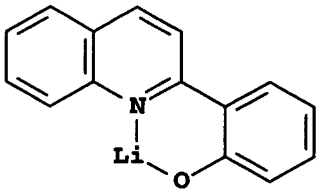

(T-3)

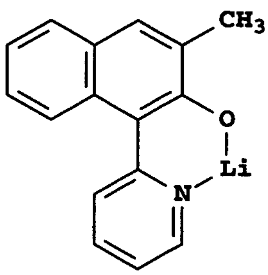

(T-4)

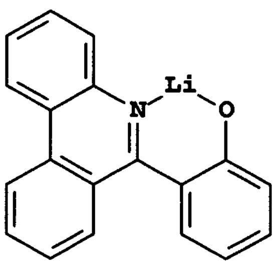

(T-5)

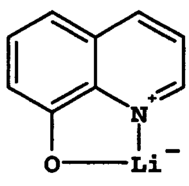

The thickness of EIL 180 including the alkaline metal complexes or alkaline earth metal complexes is typically

less than 20 nm, and preferably in the range of less than 5 nm.

When light emission is viewed solely through the anode 110, the cathode 190 includes nearly any conductive material. Desirable materials have effective film-forming properties to ensure effective contact with the underlying organic layer, promote electron injection at low voltage, and have effective stability. Useful cathode materials often contain a low work function metal (<4.0 eV) or metal alloy. One preferred cathode material includes a Mg:Ag alloy as described in U.S. Patent No. 4,885,221. Another suitable class of cathode materials includes bilayers including a thin inorganic EIL in contact with an organic layer (e.g., organic EIL or ETL), which is capped with a thicker layer of a conductive metal. Here, the inorganic EIL preferably includes a low work function metal or metal salt and, if so, the thicker capping layer does not need to have a low work function. One such cathode includes a thin layer of LiF followed by a thicker layer of Al as described in U.S. Patent No. 5,677,572. Other useful cathode material sets include, but are not limited to, those disclosed in U.S. Patent Nos. 5,059,861, 5,059,862, and 6,140,763.

When light emission is viewed through the cathode, cathode 190 should be transparent or nearly transparent. For such applications, metals should be thin or one should use transparent conductive oxides, or include these materials. Optically transparent cathodes have been described in more detail in U.S. Patent Nos. 4,885,211, 5,247,190, 5,703,436, 5,608,287, 5,837,391, 5,677,572, 5,776,622, 5,776,623, 5,714,838, 5,969,474, 5,739,545, 5,981,306, 6,137,223, 6,140,763, 6,172,459, 6,278,236, 6,284,393, and EP 1 076 368. Cathode materials are typically deposited by thermal evaporation, electron beam evaporation, ion sputtering, or chemical vapor deposition. When needed, patterning is achieved through many well known methods including, but not limited to, through-mask deposition, integral shadow masking, for example as described in U.S. Patent No. 5,276,380 and EP 0 732 868, laser ablation, and selective chemical vapor deposition.

In the prior art OLED 400, the HBL 460 is similar to one of the hole-blocking layers used in OLED 100 and OLED 200 of the present invention.

The phosphorescent OLED is typically provided over a supporting substrate where either the anode 110 or cathode 190 can be in contact with the substrate. The electrode in contact with the substrate is conveniently referred to as the bottom electrode. Conventionally, the bottom electrode is the anode 110, but this invention is not limited to that configuration. The substrate can either be light transmissive or opaque, depending on the intended direction of light emission. The light transmissive property is desirable for viewing the EL emission through the substrate. Transparent glass or plastic is commonly employed in such cases. The substrate can be a complex structure including multiple layers of materials. This is typically the case for active matrix substrates wherein TFTs are provided below the OLED layers. It is still necessary that the substrate, at least in the emissive pixelated areas, be comprised of largely transparent materials such as glass or polymers. For applications where the EL emission is viewed through the top electrode, the transmissive characteristic of the bottom support is immaterial, and therefore the substrate can be light transmissive, light absorbing or light reflective. Substrates for use in this case include, but are not limited to, glass, plastic, semiconductor materials such as silicon, ceramics, and circuit board materials. Again, the substrate can be a complex structure including multiple layers of materials such as found in active matrix TFT designs. It is necessary to provide in these device configurations a light-transparent top electrode.

The organic materials mentioned above are suitably deposited by any methods suitable for the form of the organic materials. In the case of small molecules, they are conveniently deposited through sublimation or evaporation, but can be deposited by other methods such as coating from a solvent together with an optional binder to improve film formation. If the material is a polymer, solvent deposition is usually preferred. The material to be deposited by sublimation or evaporation can be vaporized from a sublimator "boat" often comprised of a tantalum material, e.g., as described in U.S. Patent No. 6,237,529, or can be first coated onto a donor sheet and then sublimed in closer proximity to the substrate. Layers with a mixture of materials can utilize separate sublimator boats or the materials can be pre-mixed and coated from a single boat or donor sheet. Patterned deposition can be achieved using shadow masks, integral shadow masks (U.S. Patent No. 5,294,870), spatially-defined thermal dye transfer from a donor sheet (U.S. Patent Nos. 5,688,551, 5,851,709 and 6,066,357) or an inkjet method (U.S. Patent No. 6,066,357).

OLED devices of this invention can employ various well-known optical effects in order to enhance their emissive properties if desired. This includes optimizing layer thicknesses to yield improved light transmission, providing dielectric mirror structures, replacing reflective electrodes with light-absorbing electrodes, providing anti-glare or anti-reflection coatings over the display, providing a polarizing medium over the display, or providing colored, neutral density, or color-conversion filters over the display. Filters, polarizers, and anti-glare or anti-reflection coatings can be specifically provided over the EL device or as part of the EL device.

Most OLED devices are sensitive to moisture or oxygen, or both, so they are commonly sealed in an inert atmosphere such as nitrogen or argon, along with a desiccant such as alumina, bauxite, calcium sulfate, clays, silica gel, zeolites, alkaline metal oxides, alkaline earth metal oxides, sulfates, or metal halides and perchlorates. Methods for encapsulation and desiccation include, but are not limited to, those described in U.S. Patent No. 6,226,890. In addition, barrier layers such as $SiO_x$, Teflon, and alternating inorganic/polymeric layers are known in the art for encapsulation. Any of these methods of sealing or encapsulation and desiccation can be used with the EL devices constructed according

to the present invention.

One advantageous use of this invention is part of a tandem OLED which generally has at least two light-emitting units joined together by a non-emitting intermediate connector. These individual light-emitting units each are composed of one or more separate light-emitting layers and each unit can emit substantially the same or different colors of light. Preferably, they emit different colors of light. By substantially, it is meant that one color of light predominates (more than 50% of the emission). Other smaller amounts of light of different color can be present in addition to the predominate color emission. The invention can be used in more than one of the light-emitting units of a tandem OLED device.

Embodiments of the invention (OLED 100 and OLED 200) can provide advantageous features such as higher luminous yield, low drive voltage, and higher power efficiency. In one desirable embodiment the OLED is part of a display device. Embodiments of the invention can also provide an area lighting device or other electronic device.

**EXAMPLES**

The following examples are presented for a further understanding of the present invention. The reduction potential and the oxidation potential of the materials were measured using a Model CHI660 electrochemical analyzer (CH Instruments, Inc., Austin, TX) with the method as discussed before. During the fabrication of OLEDs, the thickness of the organic layers and the doping concentrations were controlled and measured in situ using calibrated thickness monitors built in an evaporation system (Made by Trovato Mfg., Inc., Fairport, NY). The EL characteristics of all the fabricated devices were evaluated using a constant current source (KEITHLEY 2400 SourceMeter, made by Keithley Instruments, Inc., Cleveland, Ohio) and a photometer (PHOTO RESEARCH SpectraScan PR 650, made by Photo Research, Inc., Chatsworth, CA) at room temperature. Operational lifetime (or stability) of the devices was tested at the room temperature and at an initial luminance of 1,000 cd/$m^2$ by driving a constant current through the devices. The color was reported using Commission Internationale de l'Eclairage (CIE) coordinates.

<u>Examples 1-3</u>

The preparation of a conventional OLED (Device 1) is as follows: A ~1.1 mm thick glass substrate coated with a transparent ITO conductive layer was cleaned and dried using a commercial glass scrubber tool. The thickness of ITO is about 22 nm and the sheet resistance of the ITO is about 68 Ω/square. The ITO surface was subsequently treated with oxidative plasma to condition the surface as an anode. A layer of $CF_x$, 1 nm thick, was deposited on the clean ITO surface as the anode buffer layer by decomposing $CHF_3$ gas in an RF plasma treatment chamber. The substrate was then transferred into a vacuum deposition chamber for deposition of all other layers on top of the substrate. The following layers were deposited in the following sequence by evaporation from a heated boat under a vacuum of approximately $10^{-6}$ Torr:

a) a HTL, 100 nm thick, including *N,N'*-di-1-naphthyl-*N,N'*-diphenyl-4,4'-diaminobiphenyl (NPB);
b) an EXBL, 10 nm thick, including 4-(9H-carbazol-9-yl)-N,N-bis[4-(9H-carbazol-9-yl)phenyl]-benzenamine (TCTA);
c) a LEL, 20 nm thick, including 9,9'-[1,1'-biphenyl]-4,4'-diylbis-9H-carbazole (CBP, HOMO energy = -5.58 eV, LUMO energy = -2.13 eV,
triplet energy = 2.67 eV) doped with 6% of tris(2-phenylpyridine) iridium (III) ($Ir(ppy)_3$, HOMO energy = -5.27 eV, LUMO energy = -2.10 eV, triplet energy = 2.54 eV) by volume;
d) an HBL, 25 nm thick, including 4,7-diphenyl-1,10-phenanthroline (Bphen, HOMO energy = -6.03 eV, LUMO energy = -2.29 eV, triplet energy = 2.64 eV);
e) an ETL, 15 nm thick, including Bphen doped with about 1.0% of lithium; and
f) a cathode: approximately 100 nm thick, including Al.

After the deposition of these layers, the device was transferred from the deposition chamber into a dry box (made by VAC Vacuum Atmosphere Company, Hawthorne, CA) for encapsulation. The OLED has an emission area of 10 $mm^2$.

Device 1 is denoted as: ITO/100 nm NPB/10 nm TCTA/20 nm CBP:6% $Ir(ppy)_3$/25 nm Bphen/15 nm Bphen:1.0% Li/100 nm Al. The EL spectrum of Device 1 is shown in FIG. 5. This device has an EL peak wavelength of about 513 nm. This EL spectrum is used as a reference spectrum for spectral comparison of other devices.

In order to illustrate triplet exciton diffusion from a light-emitting layer into a hole-blocking layer, another OLED (Device 2) is fabricated with the same method and the same layer structure as Example 1, except that a thin triplet red emitting layer is inserted into the hole-blocking layer. The layer structure is:

a) a HTL, 100 nm thick, including NPB;
b) an EXBL, 10 nm thick, including TCTA;

c) a LEL, 20 nm thick, including CBP doped with 6% of $Ir(ppy)_3$ by volume;
d) an HBL, 25 nm thick in total, including three sub-layers:

d-1) 5 nm thick of Bphen;
d-2) 5 nm thick of red emission region, including Bphen doped with about 4% of tris(1-phenylisoquinoline) iridium (III) ($Ir(piq)_3$, HOMO energy = -5.24 eV, LUMO energy = -2.63 eV, triplet energy = 2.12 eV); and
d-3) 15 nm thick of Bphen;

e) an ETL, 15 nm thick, including Bphen doped with about 1.0% of lithium; and
f) a cathode: approximately 100 nm thick, including Al.

Device 2 (not according to the invention) is denoted as: ITO/100 nm NPB/10 nm TCTA/20 nm CBP:6% $Ir(ppy)_3$/5 nm Bphen/5 nm Bphen:4% $Ir(piq)_3$/15 nm Bphen/15 nm Bphen:1.0% Li/100 nm Al. The EL spectrum of Device 1 is shown in FIG. 5. In comparison with Device 1, Device 2 also has an EL peak wavelength of about 513 nm. Moreover, there is a spectral shoulder in the red color region. This indicates that a 5 nm thick of Bphen HBL cannot fully block holes or triplet excitons from moving into the HBL and reaching the triplet red dopant in the HBL.

Another OLED (Device 3, not according to the invention) is fabricated with the same method and the same layer structure as Example 2, except that the distance between the LEL and the red emission region in the HBL is increased from 5 nm to 10 nm. The layer structure is:

a) a HTL, 100 nm thick, including NPB;
b) an EXBL, 10 nm thick, including TCTA;
c) a LEL, 20 nm thick, including CBP doped with 6% of $Ir(ppy)_3$ by volume;
d) an HBL, 25 nm thick in total, including three sub-layers:

d-1) 10 nm thick of Bphen;
d-2) 5 nm thick of red emission region, including Bphen doped with about 4% $Ir(piq)_3$; and
d-3) 10 nm thick of Bphen;

e) an ETL, 15 nm thick, including Bphen doped with about 1.0% of lithium; and
f) a cathode: approximately 100 nm thick, including Al.

Device 3 is denoted as: ITO/100 nm NPB/10 nm TCTA/20 nm CBP:6% $Ir(ppy)_3$/10 nm Bphen/5 nm Bphen:4% $Ir(piq)_3$/10 nm Bphen/15 nm Bphen: 1.0% Li/100 nm Al. The EL spectrum of Device 1 is shown in FIG. 5. In comparison with Device 1, Device 3 also has an EL peak wavelength of about 513 nm. Moreover, the spectral shoulder in the red color region is still discernable. This indicates that even a 10 nm thick HNL of Bphen still cannot fully block holes or triplet excitons from moving into the HBL and reaching the triplet red dopant in the HBL. Therefore, thicker or multiple hole-blocking layers are needed to fully block holes and triplet excitons.

Examples 4-5

A comparative phosphorescent OLED (Device 4) is fabricated with the same method and the same layer structure as Example 1.

Device 4 is denoted as: ITO/100 nm NPB/10 nm TCTA/20 nm CBP:6% $Ir(ppy)_3$/25nm Bphen/15 nm Bphen:1.0% Li/100 nm Al. The EL performance of the device is summarized in Table 1.

An inventive phosphorescent OLED (Device 5) is fabricated with the same method and the same layer structure as Example 4, except that the there are two HBLs in the device. The layer structure is:

a) a HTL, 100 nm thick, including NPB;
b) an EXBL, 10 nm thick, including TCTA;
c) a LEL, 20 nm thick, including CBP doped with 6% of $Ir(ppy)_3$ by volume;
d) a first HBL, 5 nm thick, including Formula (X-1) (HOMO energy < -6.1 eV, LUMO energy = -2.73 eV, triplet energy = 2.95 eV);
e) a second HBL, 20 nm thick, including Bphen;
f) an ETL, 15 nm thick, including Bphen doped with about 1.0% of lithium; and
g) a cathode: approximately 100 nm thick, including Al.

Device 5 is denoted as: ITO/100 nm NPB/10 nm TCTA/20 nm CBP:6% $Ir(ppy)_3$/5 nm (X-1)/20 nm Bphen/15

nm Bphen:1.0% Li/100 nm Al. The EL performance of the device is summarized in Table 1.

TABLE 1

| Example (EL measured @ RT and 1.0 mA/$cm^2$) | Voltage (V) | Luminance (cd/$m^2$) | Luminous Efficiency (cd/A) | CIE x (1931) | CIE y (1931) | External Quantum Efficiency (%) | Lifetime ($T_{50}$ @ 1000 nits) (h) |
|---|---|---|---|---|---|---|---|
| 4 (Comp) | 3.9 | 447 | 44.7 | 0.279 | 0.633 | 12.9 | 102 |
| 5 (Inv) | 4.0 | 434 | 43.4 | 0.280 | 0.636 | 12.4 | 608 |

As can be seen from Table 1, the major difference in the EL performance between Device 4 and Device 5 is the operational lifetime. Operated at an initial luminance of 1000 nits, Device 5 has a lifetime more than 5 times longer than that of Device 4. In Device 4, the thick Bphen HBL (thicker than 20 nm) can effectively block holes (the HOMO energy is lower than that of the CBP host in the LEL) and block triplet excitons (the triplet energy is higher than that of the triplet green dopant in the LEL). However, it is believed that the CBP host and the Bphen HBL cannot form a stable interface, which could substantially influence the lifetime. In Device 5, using Formula (X-1) as a first HBL and Bphen as the second HBL can not only form an improved interface between the LEL and the first HBL but also effectively block holes and triplet excitons. Therefore, the operational lifetime of Device 5 is improved.

In Device 5, the material in the 1$^{st}$ HBL has a triplet energy (2.95) greater than that of the host of the phosphorescent LEL (2.67) and a HOMO (-6.1 less than that of the host (-5.58). The material in the 2$^{nd}$ HBL has a triplet energy (2.64) greater than that of the phosphorescent dopant (2.54) and a HOMO (-6.03) that is less than the host (-5.58).

Examples 6-8

A comparative phosphorescent OLED (Device 6) is constructed in the same manner as that of Example 1. The layer structure is:

a) an HIL, 10 nm thick, including hexaazatriphenylene hexacarbonitrile (HAT-CN);
b) a HTL, 120 nm thick, including NPB;
c) an EXBL, 10 nm thick, including TCTA;
d) a LEL, 20 nm thick, including Formula (OP-1) (HOMO energy = -5.97 eV, LUMO energy = -2.66 eV, triplet energy = 2.18 eV) doped with 4% of $Ir(piq)_3$ by volume;
e) a first ETL, 20 nm thick, including Formula (OP-1);
f) a second ETL, 35 nm thick, including Bphen doped with about 1.0% lithium by volume ; and
g) a cathode: approximately 100 nm thick, including Al.

Device 6 is denoted as: ITO/10 nm HAT-CN/120 nm NPB/10 nm TCTA/20 nm (OP-1):4% $Ir(piq)_3$/20 nm (OP-1)/35 nm Bphen:1.0% Li/100 nm Al. The EL performance of the device is summarized in Table 2. This device does not have any HBL since the first ETL is formed by the same LEL host and it does not have a lower HOMO energy to block holes. Therefore, the external quantum efficiency of this device is low.

Another comparative phosphorescent OLED (Device 7) is constructed in the same manner as that of Example 6. The layer structure is:

a) an HIL, 10 nm thick, including HAT-CN;
b) a HTL, 120 nm thick, including NPB;
c) an EXBL, 10 nm thick, including TCTA;
d) a LEL, 20 nm thick, including Formula (OP-1) doped with 4% of $Ir(piq)_3$ by volume;
e) an HBL, 20 nm thick, including Bphen;
f) an ETL, 35 nm thick, including Bphen doped with about 1.0% lithium by volume ; and
g) a cathode: approximately 100 nm thick, including Al.

Device 7 is denoted as: ITO/10 nm HAT-CN/120 nm NPB/10 nm TCTA/20 nm (OP-1):4% $Ir(piq)_3$/20 nm Bphen/35 nm Bphen:1.0% Li/100 nm Al. The EL performance of the device is summarized in Table 2. This device does have an HBL. Therefore, the external quantum efficiency of this device is higher than that of Device 6.

An inventive phosphorescent OLED (Device 8) is constructed in the same manner and the same layer structure as that of Example 7, except that a another HBL of formula (X-1) is disposed in contact with the LEL at the cathode side. The layer structure is:

a) an HIL, 10 nm thick, including HAT-CN;
b) a HTL, 120 nm thick, including NPB;
c) an EXBL, 10 nm thick, including TCTA;
d) a LEL, 20 nm thick, including Formula (OP-1) doped with 4% of $Ir(piq)_3$ by volume;
e) a first HBL, 5 nm thick, including Formula (X-1);
f) a second HBL, 15 nm thick, including Bphen;
g) an ETL, 35 nm thick, including Bphen doped with about 1.0% lithium by volume ; and
h) a cathode: approximately 100 nm thick, including Al.

Device 8 is denoted as: ITO/10 nm HAT-CN/120 nm NPB/10 nm TCTA/20 nm (OP-1):4% $Ir(piq)_3$/5 nm (X-1)/15 nm Bphen/35 nm Bphen:1.0% Li/100 nm Al. The EL performance of the device is summarized in Table 2. This device contains two HBLs.

Examples 9-11

A comparative phosphorescent OLED (Device 9) is constructed in the same manner as that of Example 1. The layer structure is:

a) an HIL, 10 nm thick, including HAT-CN;
b) a HTL, 120 nm thick, including NPB;
c) an EXBL, 10 nm thick, including TCTA;
d) a LEL, 20 nm thick, including Formula (OP-2) (HOMO energy = -5.95 eV, LUMO energy = -2.61 eV, triplet energy = 2.29 eV) doped with 4% of $Ir(piq)_3$ by volume;
e) an HBL, 20 nm thick, including Formula (X-1);
f) an ETL, 35 nm thick, including Bphen doped with about 1.0% lithium by volume ; and
g) a cathode: approximately 100 nm thick, including Al.

Device 9 is denoted as: ITO/10 nm HAT-CN/120 nm NPB/10 nm TCTA/20 nm (OP-2):4% $Ir(piq)_3$/20 nm (X-1)/35 nm Bphen:1.0% Li/100 nm Al. The EL performance of the device is summarized in Table 2. This device has one HBL.

Another comparative phosphorescent OLED (Device 10) is constructed in the same manner as that of Example 9. The layer structure is:

a) an HIL, 10 nm thick, including HAT-CN;
b) a HTL, 120 nm thick, including NPB;
c) an EXBL, 10 nm thick, including TCTA;
d) a LEL, 20 nm thick, including Formula (OP-2) doped with 4% of $Ir(piq)_3$ by volume;
e) an HBL, 20 nm thick, including Bphen;
f) an ETL, 35 nm thick, including Bphen doped with about 1.0% lithium by volume ; and
g) a cathode: approximately 100 nm thick, including Al.

Device 10 is denoted as: ITO/10 nm HAT-CN/120 nm NPB/10 nm TCTA/20 nm (OP-2):4% $Ir(piq)_3$/20 nm Bphen/35 nm Bphen: 1.0% Li/100 nm Al. The EL performance of the device is summarized in Table 2. This device also has one HBL.

An inventive phosphorescent OLED (Device 11) is constructed in the same manner and the same layer structure as that of Example 10, except that there are two HBLs in the device. The layer structure is:

a) an HIL, 10 nm thick, including HAT-CN;
b) a HTL, 120 nm thick, including NPB;
c) an EXBL, 10 nm thick, including TCTA;
d) a LEL, 20 nm thick, including Formula (OP-2) doped with 4% of $Ir(piq)_3$ by volume;
e) a first HBL, 5 nm thick, including Formula (X-1);
f) a second HBL, 15 nm thick, including Bphen;
g) an ETL, 35 nm thick, including Bphen doped with about 1.0% lithium by volume ; and
h) a cathode: approximately 100 nm thick, including Al.

Device 11 is denoted as: ITO/10 nm HAT-CN/120 nm NPB/10 nm TCTA/20 nm (OP-2):4% $Ir(piq)_3$/5 nm (X-1)/15 nm Bphen/35 nm Bphen:1.0% Li/100 nm Al. The EL performance of the device is summarized in Table 2. This device contains two HBLs.

Examples 12-13

Another comparative phosphorescent OLED (Device 12) is constructed in the same manner and the same layer structure as that of Example 10, except that the host in the LEL is different. The layer structure is:

a) an HIL, 10 nm thick, including HAT-CN;
b) a HTL, 120 nm thick, including NPB;
c) an EXBL, 10 nm thick, including TCTA;
d) a LEL, 20 nm thick, including Formula (OP-4) (HOMO energy = -5.95 eV, LUMO energy = -2.57 eV, triplet energy = 2.36 eV) doped with 4% of $Ir(piq)_3$ by volume;
e) an HBL, 20 nm thick, including Bphen;
f) an ETL, 35 nm thick, including Bphen doped with about 1.0% lithium by volume ; and
g) a cathode: approximately 100 nm thick, including Al.

Device 12 is denoted as: ITO/10 nm HAT-CN/120 nm NPB/10 nm TCTA/20 nm (OP-4):4% $Ir(piq)_3$/20 nm Bphen/35 nm Bphen:1.0% Li/100 nm Al. The EL performance of the device is summarized in Table 2. This device also has one HBL.

An inventive phosphorescent OLED (Device 13) is constructed in the same manner and the same layer structure as that of Example 11, except that the host in the LEL is different. The layer structure is:

a) an HIL, 10 nm thick, including HAT-CN;
b) a HTL, 120 nm thick, including NPB;
c) an EXBL, 10 nm thick, including TCTA;
d) a LEL, 20 nm thick, including Formula (OP-4) doped with 4% of $Ir(piq)_3$ by volume;
e) a first HBL, 5 nm thick, including Formula (X-1);
f) a second HBL, 15 nm thick, including Bphen;
g) an ETL, 35 nm thick, including Bphen doped with about 1.0% lithium by volume ; and
h) a cathode: approximately 100 nm thick, including Al.

Device 13 is denoted as: ITO/10 nm HAT-CN/120 nm NPB/10 nm TCTA/20 nm (OP-4):4% $Ir(piq)_3$/5 nm (X-1)/15 nm Bphen/35 nm Bphen:1.0% Li/100 nm Al. The EL performance of the device is summarized in Table 2. This device contains two HBLs.

Examples 14-15

Another comparative phosphorescent OLED (Device 14) is constructed in the same manner and the same layer structure as that of Example 11, except that the 1$^{st}$ HBL is different. The layer structure is:

a) an HIL, 10 nm thick, including HAT-CN;
b) a HTL, 120 nm thick, including NPB;
c) an EXBL, 10 nm thick, including TCTA;
d) a LEL, 20 nm thick, including Formula (OP-2) (HOMO energy = -5.95 eV, LUMO energy = -2.61 eV, triplet energy = 2.29 eV) doped with 4% of $Ir(piq)_3$ by volume;
e) a first HBL, 5 nm thick, including Formula (ETM-9) (HOMO energy = -5.58 eV, LUMO energy = -2.50 eV, triplet energy = 2.21 eV);
f) a second HBL, 15 nm thick, including Bphen;
g) an ETL, 35 nm thick, including Bphen doped with about 1.0% lithium by volume ; and
h) a cathode: approximately 100 nm thick, including Al.

Device 14 is denoted as: ITO/10 nm HAT-CN/120 nm NPB/10 nm TCTA/20 nm (OP-2):4% $Ir(piq)_3$/5 nm (ETM-9)/15 nm Bphen/35 nm Bphen:1.0% Li/100 nm Al. The EL performance of the device is summarized in Table 2. This device contains two HBLs.

An inventive phosphorescent OLED (Device 15) is constructed in the same manner and the same layer structure as that of Example 11 at the same time as Device 14. Device 15 is denoted as: ITO/10 nm HAT-CN/120 nm NPB/10 nm TCTA/20 nm (OP-2):4% $Ir(piq)_3$/5 nm (X-1)/15 nm Bphen/35 nm Bphen:1.0% Li/100 nm Al. The EL performance of the device is summarized in Table 2. This device contains two HBLs.

TABLE 2

| Example (EL measured @ RT and 1.0 mA/cm$^2$) | Voltage (V) | Luminance (cd/m$^2$) | Luminous Efficiency (cd/A) | CIE x (1931) | CIE y (1931) | External Quantum Efficiency (%) | Lifetime ($T_{50}$ @ 1000 nits) (h) |
|---|---|---|---|---|---|---|---|
| 6 (Comp) | 4.6 | 26.2 | 2.62 | 0.667 | 0.328 | 2.98 | |
| 7 (Comp) | 4.0 | 77.5 | 7.75 | 0.670 | 0.325 | 9.04 | -1230 |
| 8 (Inv) | 4.5 | 116 | 11.6 | 0.674 | 0.326 | 13.8 | -2510 |
| 9 (Comp) | 7.9 | 79.5 | 7.95 | 0.671 | 0.328 | 8.87 | |
| 10 (Comp) | 6.4 | 93.4 | 9.34 | 0.670 | 0.328 | 10.5 | -1540 |
| 11 (Inv) | 6.9 | 116 | 11.6 | 0.671 | 0.328 | 13.0 | -2880 |
| 12 (Comp) | 4.2 | 109 | 10.9 | 0.671 | 0.327 | 12.4 | -958 |
| 13 (Inv) | 4.2 | 123 | 12.3 | 0.672 | 0.326 | 13.9 | -1560 |
| 14 (Comp) | 4.5 | 133 | 13.3 | 0.671 | 0.328 | 14.7 | -2700 |
| 15 (Inv) | 4.3 | 124 | 13.4 | 0.672 | 0.327 | 15.3 | -5000 |

Based on the data shown in Table 2, Device 8 has the best EL performance in terms of external quantum efficiency and operational lifetime compared to Device 6 or 7.

Based on the data shown in Table 2, Device 11 has the highest drive voltage and lowest external quantum efficiency as compared to Devices 9 and 10. Devices 10 and 11 with only one thick HBL have lower external quantum efficiency and shorter lifetime than Device 11. Therefore, Device 11, with double HBLs, has the best EL performance in terms of external quantum efficiency and operational lifetime.

Based on the data shown in Table 2, the EL performance of Device 13, in comparison with Device 12, further demonstrates that having double HBLs in the device, the external quantum efficiency and the operational lifetime can be substantially improved.

Based on the data shown in Table 2, although Device 14 has double HBLs, the first HBL does not meet the requirement set in the present invention. The HOMO energy of the first hole-blocking material (ETM-9) in the first HBL is not lower than that of the predominant host (OP-2) in the LEL. As a result, in comparison with Device 15, Device 14 has lower external quantum efficiency, and especially shorter operational lifetime.

**PARTS LIST**

100 Organic light emitting device (OLED)
110 Anode
120 Hole-injecting layer (HIL)
130 Hole-transporting layer (HTL)
140 Exciton-blocking layer (EXBL)
150 Phosphorescent light-emitting layer (LEL)
161 First hole-blocking layer (1st HBL)
162 Second hole-blocking layer (2nd HBL)
170 Electron-transporting layer (ETL)
180 Electron-injecting layer (EIL)
190 Cathode
200 Organic light emitting device (OLED)
300 Organic light emitting device (OLED)
400 Organic light emitting device (OLED)
460 Hole-blocking layer in a prior art OLED (HBL)

**Claims**

**1.** An organic light-emitting device (100) comprising:

a) an anode (110);
b) a cathode (190);
c) a phosphorescent light-emitting layer (150) disposed between the anode and the cathode, wherein the phosphorescent light-emitting layer includes at least one host and at least one phosphorescent dopant;
d) a first hole-blocking layer (161) disposed in contact with the phosphorescent light-emitting layer at the cathode side, wherein the first hole-blocking layer includes a first hole-blocking material having a triplet energy greater than the triplet energy of the predominant host in the phosphorescent light-emitting layer; and wherein the HOMO energy of the first hole-blocking material in the first hole-blocking layer is lower than that of the predominant host in the phosphorescent light-emitting layer;
e) a second hole-blocking layer (162) disposed in contact with the first hole-blocking layer at the cathode side, wherein the second hole-blocking layer includes a second hole-blocking material having a triplet energy greater than the triplet energy of the dopant in the phosphorescent light-emitting layer, and wherein the HOMO energy of the second hole-blocking material in the second hole-blocking layer is lower than that of the predominant host in the phosphorescent light-emitting layer; and
f) an electron-transporting layer (170) disposed between the second hole-blocking layer and the cathode, wherein the electron-transporting layer includes at least one electron-transporting material;

wherein there is a LUMO energy difference between the predominant host in the phosphorescent light-emitting layer and the first hole-blocking material in the first hole-blocking layer, and wherein the LUMO energy difference is less than 0.5 V; and
wherein the first hole-blocking material in the first hole-blocking layer and the second hole-blocking material in the second hole-blocking layer are different electron-transporting materials.

**2.** The organic light-emitting device of claim 1, wherein there is a LUMO energy difference between the first hole-blocking material in the first hole-blocking layer and the second hole-blocking material in the second hole-blocking layer, and wherein the LUMO energy difference is less than 0.5 V.

**3.** The organic light-emitting device of claim 1, wherein there is a LUMO energy difference between the second hole-blocking material in the second hole-blocking layer and the dominant electron-transporting material in the electron-transporting layer, and wherein the LUMO energy difference is less than 0.5 V.

**4.** The organic light-emitting device of claim 1, wherein second hole-blocking material in the second hole-blocking layer has a triplet energy greater than the triplet energy of the predominant host in the phosphorescent light-emitting layer.

**5.** The organic light-emitting device of claim 1, wherein the first hole-blocking layer and the second hole-blocking layer each has a thickness in the range of from 1 nm to 80 nm, preferably in the range of from 2 nm to 40 nm.

**6.** The organic light-emitting device of claim 1, wherein the electron-transporting material includes bis(9,9'-spirobifluoren-2-yl) compound.

**7.** The organic light-emitting device of claim 6, wherein the bis(9,9'-spirobifluo-ren-2-yl) compound is selected from:

X-1

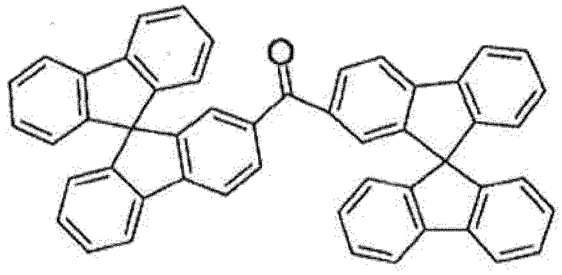

;

X-2

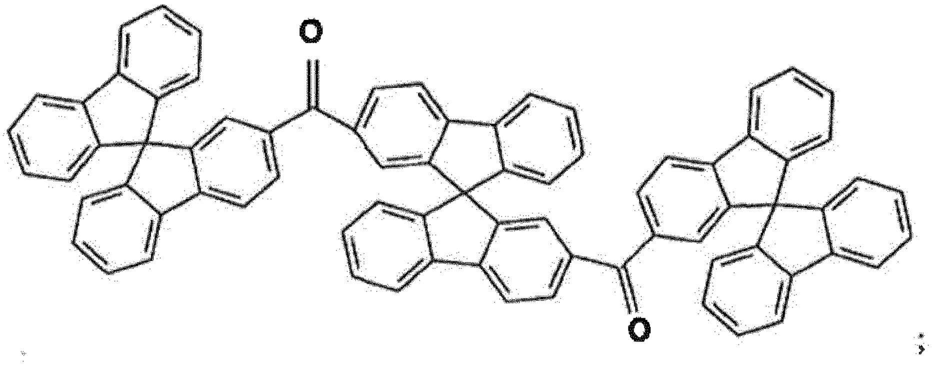

X-3

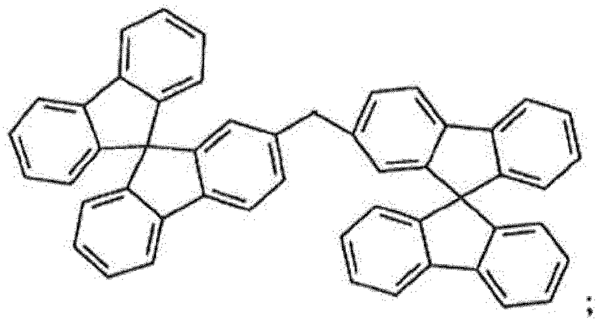

or

X-4

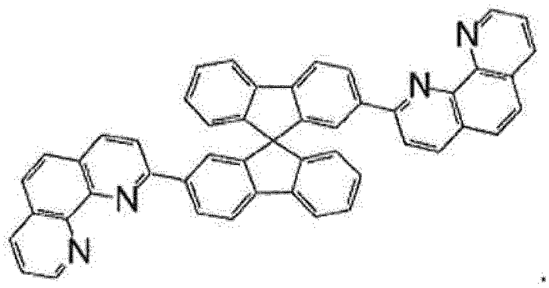

**8.** The organic light-emitting device of claim 1, wherein the electron-transporting material is a benzazole derivative represented by structural formula (K):

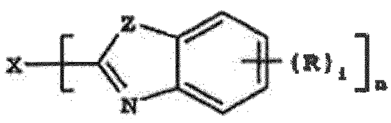

(K)

wherein:

n is selected from 2 to 8 and i is selected from 1-5;
Z is independently O, NR or S;
R is individually hydrogen; alkyl of from 1 to 24 carbon atoms aryl or heteroatom substituted aryl of from 5 to 20 carbon atoms, halo, or atoms necessary to complete a fused aromatic ring; and
X is a linkage unit including carbon, alkyl, aryl, substituted alkyl, or substituted aryl, which conjugately or unconjugately connects the multiple benzazoles together, preferably said benzazole derivative includes 2,2',2"-(1,3,5-phenylene)tris[1-phenyl-1H-benzimidazole] (TPBI).

**9.** The organic light-emitting device of claim 1, wherein the electron-transporting material is an aluminum or gallium complex represented by Formula (R-a):

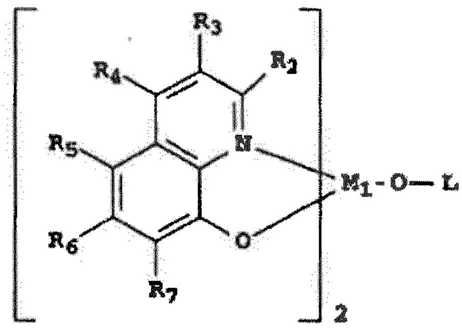

(R-a)

wherein:

$M_1$ is Al or Ga; and
$R_2$-$R_7$ independently represent hydrogen or an alkyl group; and
L is an aromatic moiety with 6 to 30 carbon atoms, preferably wherein the aluminum or gallium complex includes aluminum(III)bis(2-methyl-8-hydroxyquinoline)-4-phenylphenolate [alias, Balq] and gallium oxine [alias, tris(8-quino-linolato)gallium(III)].

**10.** The organic light-emitting device of claim 1, wherein the host in the phosphorescent light-emitting layer includes a fluorathene compound represented by Formula (OP)

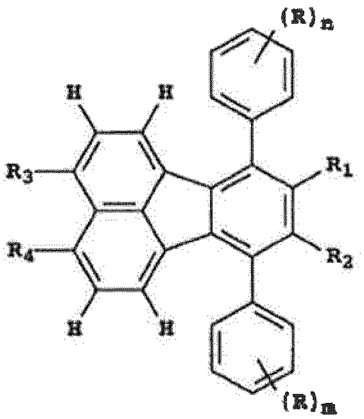

(OP)

wherein

$R_1$, $R_2$, $R_3$ and $R_4$ are independently hydrogen or an aromatic group containing 6 to 24 carbon atoms with the proviso that any adjacent $R_1$-$R_4$ is not part of an annulated aromatic ring system;
R is hydrogen or an optional substituent;
and n and m are independently 1-5, preferably wherein the fluorathene compound is selected from:

OP-1

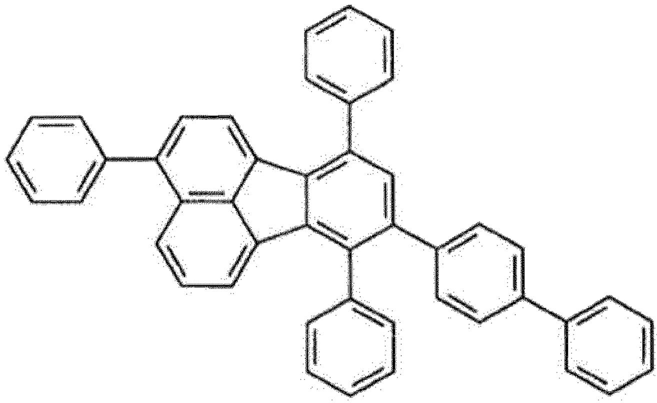

;

OP-2

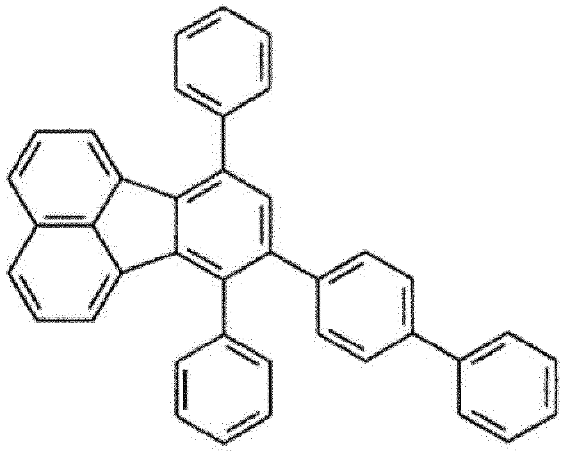

;

OP-3

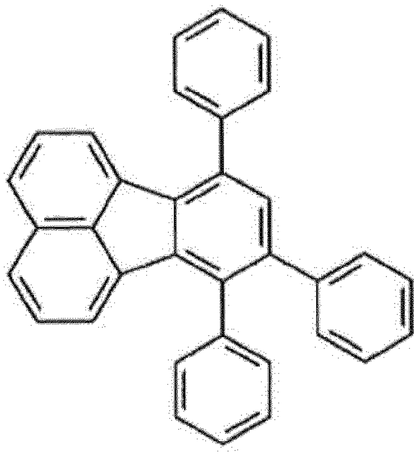

; or

or

OP-4

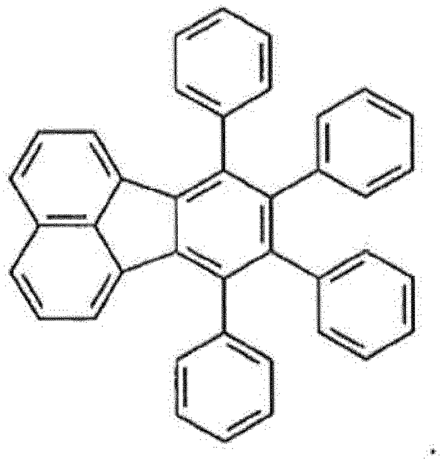

11. The OLED of claim 1, wherein the phosphorescent dopant in the phosphorescent light-emitting layer is selected from tris(1-phenylisoquinoline) iridium (III) ($Ir(piq)_3$), $Ir(ppy)_2(cou1)$ having the formula:

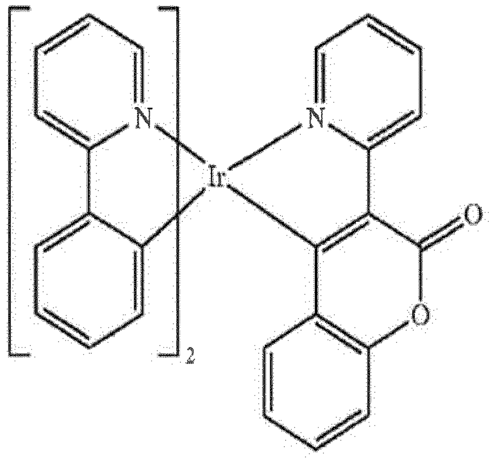

,

$Ir(cou2)_2ppy$ having the formula:

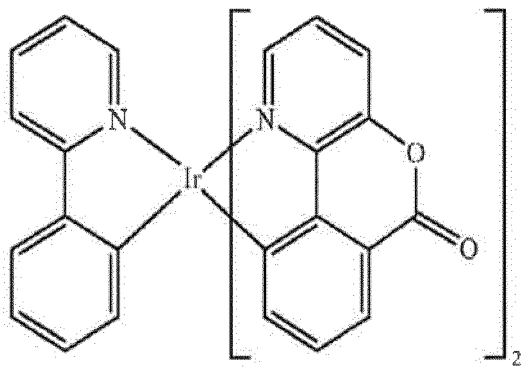

,

or tris(2- phenylpyridine) indium (III) ($Ir(ppy)_3$).

12. The organic light-emitting device of claim 1 wherein the device includes an exciton-blocking layer (140) disposed in contact with the phosphorescent light-emitting layer on the anode side.

13. The organic light-emitting device of claim 1, wherein the device includes two light-emitting layers; and wherein the

two light-emitting layers emit light of different colors.

**14.** The organic light-emitting device of claim 1 that includes a tandem structure.

## Patentansprüche

**1.** Organische lichtemittierende Vorrichtung (100), umfassend:

a) eine Anode (110);
b) eine Kathode (190);
c) eine phosphoreszierende lichtemittierende Schicht (150), angeordnet zwischen der Anode und der Kathode, wobei die phosphoreszierende lichtemittierende Schicht mindestens einen Wirt und mindestens ein phosphoreszierendes Dotierungsmittel einschließt;
d) eine erste Loch-blockierende Schicht (161), angeordnet in Kontakt mit der phosphoreszierenden lichtemittierenden Schicht an der Kathodenseite, wobei die erste Loch-blockierende Schicht ein erstes Loch-blockierendes Material einschließt mit einer Triplet-Energie größer als die Triplet-Energie des prädominanten Wirtes in der phosphoreszierenden lichtemittierenden Schicht, und wobei die HOMO-Energie des ersten Loch-blockierenden Materials in der ersten Loch-blockierenden Schicht geringer ist als die des prädominanten Wirtes in der phosphoreszierenden lichtemittierenden Schicht;
e) eine zweite Loch-blockierende Schicht (162), angeordnet in Kontakt mit der ersten Loch-blockierenden Schicht an der Kathodenseite, wobei die zweite Loch-blockierende Schicht ein zweites Loch-blockierendes Material einschließt mit einer Triplet-Energie größer als die Triplet-Energie des Dotierungsmittels in der phosphoreszierenden lichtemittierenden Schicht, und wobei die HOMO-Energie des zweiten Loch-blockierenden Materials in der zweiten Loch-blockierenden Schicht geringer ist als die des prädominanten Wirtes in der phosphoreszierenden lichtemittierenden Schicht; und
f) eine Elektronen-transportierende Schicht (170), angeordnet zwischen der zweiten Loch-blockierenden Schicht und der Kathode, wobei die Elektronen-transportierende Schicht mindestens ein Elektronen-transportierendes Material einschließt;

wobei es eine LUMO-Energie-Differenz zwischen dem prädominanten Wirt in der phosphoreszierenden lichtemittierenden Schicht und dem ersten Loch-blockierenden Material in der ersten Loch-blockierenden Schicht gibt, und wobei die LUMO-Energie-Differenz geringer als 0,5 V ist; und
wobei das erste Loch-blockierende Material in der ersten Loch-blockierenden Schicht und das zweite Loch-blockierende Material in der zweiten Loch-blockierenden Schicht verschiedene Elektronen-transportierende Materialien sind.

**2.** Organische lichtemittierende Vorrichtung nach Anspruch 1, worin es eine LUMO-Energie-Differenz gibt zwischen dem ersten Loch-blockierenden Material in der ersten Loch-blockierenden Schicht und dem zweiten Loch-blockierenden Material in der zweiten Loch-blockierenden Schicht, und wobei die LUMO-Energie-Differenz geringer als 0,5 V ist.

**3.** Organische lichtemittierende Vorrichtung nach Anspruch 1, worin es eine LUMO-Energie-Differenz gibt zwischen dem zweiten Loch-blockierenden Material in der zweiten Loch-blockierenden Schicht und dem dominanten Elektronen-transportierenden Material in der Elektronen-transportierenden Schicht, und wobei die LUMO-Energie-Differenz geringer als 0,5 V ist.

**4.** Organische lichtemittierende Vorrichtung nach Anspruch 1, worin das zweite Loch-blockierende Material in der zweiten Loch-blockierenden Schicht eine Triplet-Energie größer als die Triplet-Energie des prädominanten Wirtes in der phosphoreszierenden lichtemittierenden Schicht hat.

**5.** Organische lichtemittierende Vorrichtung nach Anspruch 1, worin die erste Loch-blockierende Schicht und die zweite Loch-blockierende Schicht jeweils eine Dicke in einem Bereich von 1 nm bis 80nm, vorzugsweise in einem Bereich von 2 nm bis 40 nm, hat.

**6.** Organische lichtemittierende Vorrichtung nach Anspruch 1, worin das Elektronen-transportierende Material Bis(9,9'-spirobifluoren-2-yl)-Verbindung einschließt.

7. Organische lichtemittierende Vorrichtung nach Anspruch 6, worin die Bis(9,9'-spirobifluoren-2-yl)-Verbindung ausgewählt ist aus:

X-1

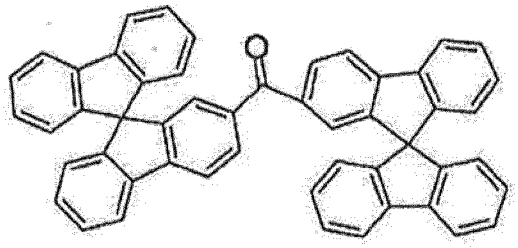

;

X-2

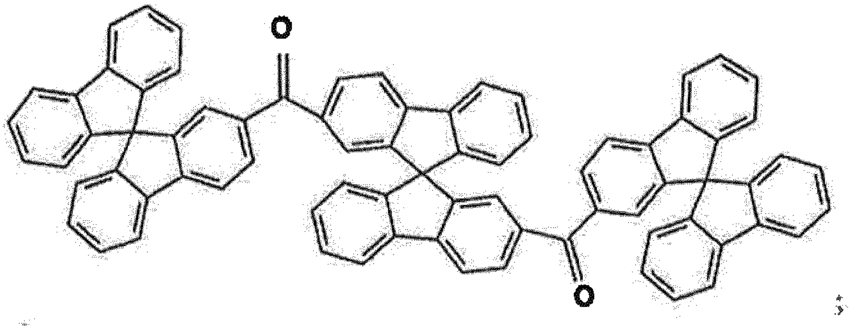

;

X-3

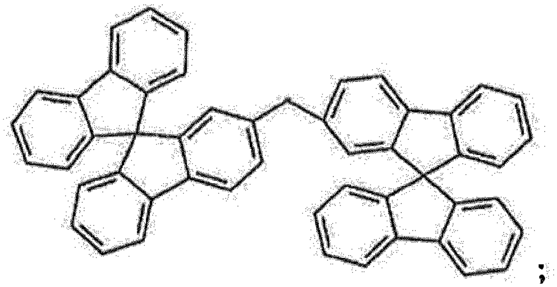

;

oder

X-4

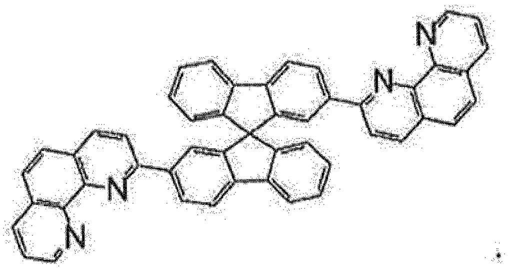

.

8. Organische lichtemittierende Vorrichtung nach Anspruch 1, worin das Elektronen-transportierende Material ein Benzazolderivat ist, wiedergegeben durch die Strukturformel (K):

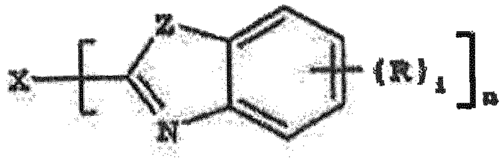

(K)

,

worin:

n ist ausgewählt aus 2 bis 8 und i ist ausgewählt aus 1-5;
Z ist unabhängig voneinander O, NR oder S;
R ist unabhängig voneinander Wasserstoff; Alkyl mit 1 bis 24 Kohlenstoffatomen, Aryl oder Heteroatom-substituiertes Aryl vom 5 mit 20 Kohlenstoffatomen, Halo oder Atome notwendig, um einen fusionierten aromatischen Ring zu vervollständigen; und
X ist eine Verknüpfungseinheit, einschließlich Kohlenstoff, Alkyl, Aryl, substituiertes Alkyl oder substituiertes Aryl, welche konjugierend oder nichtkonjugierend die mehrfachen Benzazole miteinander verknüpfen, wobei das Benzazolderivat vorzugsweise 2,2',2'-(1,3,5-Phenylen)tris[1-phenyl-1H-benzimidazol] (TPBI) einschließt.

**9.** Organische lichtemittierende Vorrichtung nach Anspruch 1, worin das Elektronen-transportierende Material ein Aluminium- oder Gallium-Komplex ist, wiedergegeben durch die Formel (R-a):

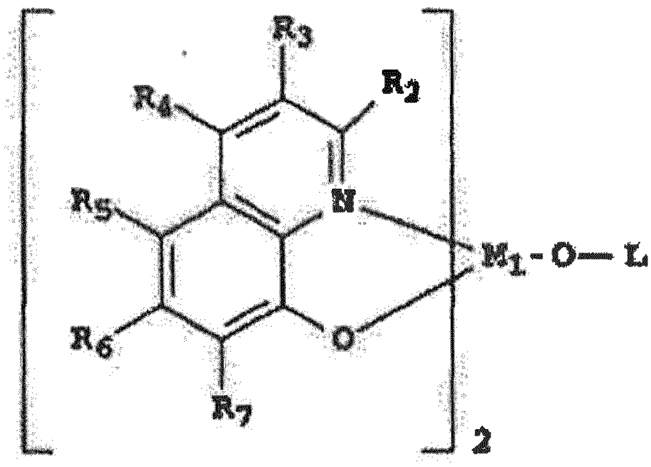

(R-a)

,

worin:

$M_1$ ist Al oder Ga; und
$R_2$-$R_7$ sind unabhängig voneinander Wasserstoff oder eine Alkylgruppe; und
L ist ein aromatischer Rest mit 6 bis 30 Kohlenstoffatomen, vorzugsweise wobei der Aluminium- oder Gallium-Komplex Aluminium(III)bis(2-methyl-8-hydroxychinolin)-4-phenylphenolat [alias, Balq] und Galliumoxin [alias, Tris(8-chinolinolato)gallium (III)] einschließt.

**10.** Organische lichtemittierende Vorrichtung nach Anspruch 1, worin der Wirt in der phosphoreszierenden lichtemittierenden Schicht eine Fluorathen-Verbindung, wiedergegeben durch die Formal (OP), einschließt:

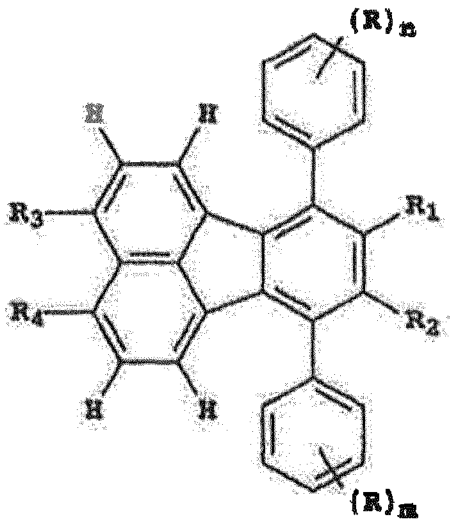

(OP) ,

worin:

$R_1$, $R_2$, $R_3$ und $R_4$ sind unabhängig voneinander Wasserstoff oder eine aromatische Gruppe mit 6 bis 24 Kohlenstoffatomen, mit der Maßgabe, dass angrenzende $R_1$-$R_4$ nicht Teil eines kondensierten aromatischen Ringsystems sind;
R ist Wasserstoff oder gegebenenfalls ein Substituent;
und n und m sind unabhängig voneinander 1-5, vorzugsweise wird die Fluorathen-Verbindung ausgewählt aus:

OP-1

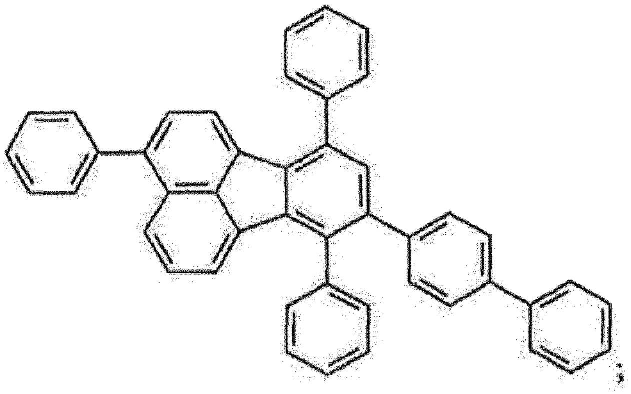

;

OP-2

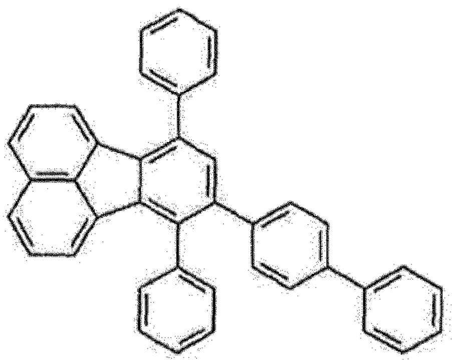

;

OP-3

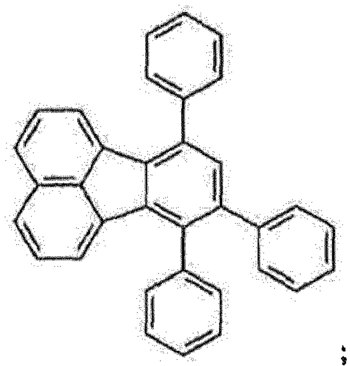

;

oder

OP-4

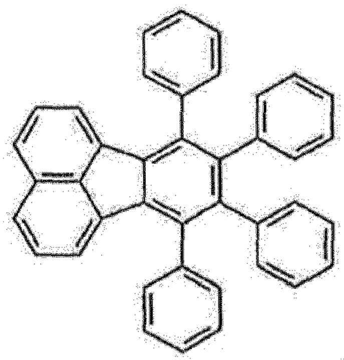

.

11. OLED nach Anspruch 1, wobei das phosphoreszierende Dotierungsmittel in der phosphoreszierenden lichtemittierenden Schicht ausgewählt ist aus Tris(1-phenylisochinolin) iridium (III) ($Ir(piq)_3$), $Ir(ppy)_2(cou1)$ mit der Formel:

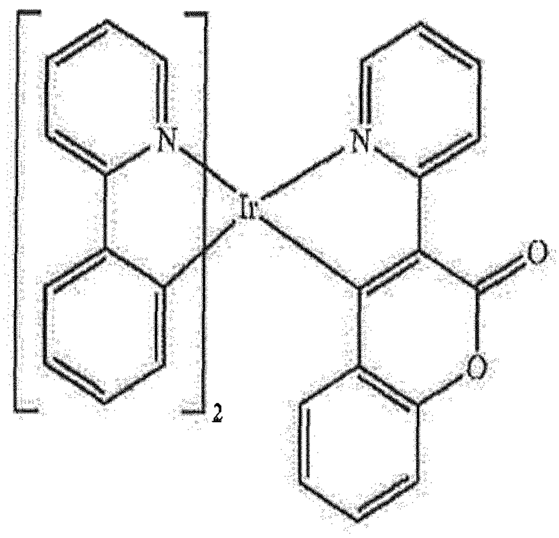

,

Ir $(cou2)_2ppy$ mit der Formel:

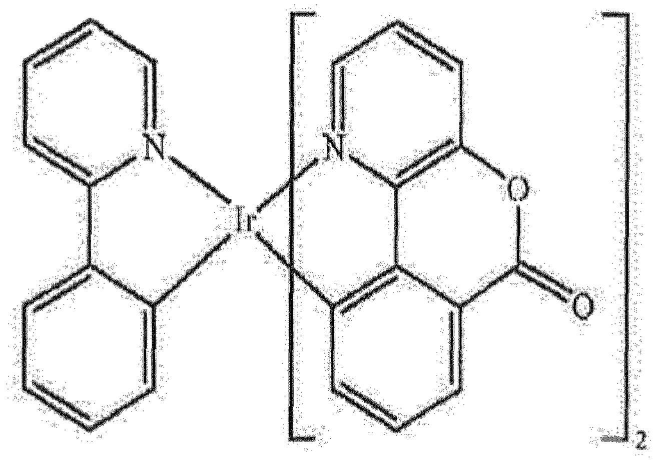

oder Tris(2-phenylpyridin)indium (III) ($Ir(ppy)_3$).

**12.** Organische lichtemittierende Vorrichtung nach Anspruch 1, worin die Vorrichtung eine Exitonen-blockierende Schicht (140) einschließt, angeordnet in Kontakt mit der phosphoreszierenden lichtemittierenden Schicht auf der Anondenseite.

**13.** Organische lichtemittierende Vorrichtung nach Anspruch 1, worin die Vorrichtung zwei lichtemittierende Schichten einschließt, und worin die zwei lichtemittierenden Schichten Licht verschiedener Farben emittieren.

**14.** Organische lichtemittierende Vorrichtung nach Anspruch 1, die eine Tandem-Struktur einschließt.

## Revendications

**1.** Dispositif électroluminescent organique (100) comprenant :

a) une anode (110) ;
b) une cathode (190) ;
c) une couche électroluminescente phosphorescente (150) disposée entre l'anode et la cathode, dans laquelle la couche électroluminescente phosphorescente comprend au moins un hôte et au moins un dopant phosphorescent ;
d) une première couche de blocage de trous (161) disposée en contact avec la couche électroluminescente phosphorescente du côté de la cathode, dans laquelle la première couche de blocage de trous comprend un premier matériau de blocage de trous présentant une énergie de triplet supérieure à l'énergie de triplet de l'hôte prédominant dans la couche électroluminescente phosphorescente ; et dans laquelle l'énergie HOMO du premier matériau de blocage de trous dans la première couche de blocage de trous est inférieure à celle de l'hôte prédominant dans la couche électroluminescente phosphorescente ;
e) une seconde couche de blocage de trous (162) disposée en contact avec la première couche de blocage de trous du côté de la cathode, dans laquelle la seconde couche de blocage de trous comprend un second matériau de blocage de trous présentant une énergie de triplet supérieure à l'énergie de triplet du dopant dans la couche électroluminescente phosphorescente, et dans laquelle l'énergie HOMO du second matériau de blocage de trous dans la seconde couche de blocage de trous est inférieure à celle de l'hôte prédominant dans la couche électroluminescente phosphorescente ; et
f) une couche de transport d'électrons (170) disposée entre la seconde couche de blocage de trous et la cathode, dans laquelle la couche de transport d'électrons comprend au moins un matériau de transport d'électrons ;

dans lequel il existe une différence d'énergie LUMO entre l'hôte prédominant dans la couche électroluminescente phosphorescente et le premier matériau de blocage de trous dans la première couche de blocage de trous, et dans lequel la différence d'énergie LUMO est inférieure à 0,5 V ; et
dans lequel le premier matériau de blocage de trous dans la première couche de blocage de trous et le second matériau de blocage de trous dans la seconde couche de blocage de trous sont des matériaux de transport d'électrons différents.

**2.** Dispositif électroluminescent organique selon la revendication 1, dans lequel il existe une différence d'énergie LUMO entre le premier matériau de blocage de trous dans la première couche de blocage de trous et le second matériau de blocage de trous dans la seconde couche de blocage de trous, et dans lequel la différence d'énergie LUMO est inférieure à 0,5 V.

**3.** Dispositif électroluminescent organique selon la revendication 1, dans lequel il existe une différence d'énergie LUMO entre le second matériau de blocage de trous dans la seconde couche de blocage de trous et le matériau de transport d'électrons dominant dans la couche de transport d'électrons, et dans lequel la différence d'énergie LUMO est inférieure à 0,5 V.

**4.** Dispositif électroluminescent organique selon la revendication 1, dans lequel le second matériau de blocage de trous dans la seconde couche de blocage de trous a une énergie de triplet supérieure à l'énergie de triplet de l'hôte prédominant dans la couche électroluminescente phosphorescente.

**5.** Dispositif électroluminescent organique selon la revendication 1, dans lequel la première couche de blocage de trous et la seconde couche de blocage de trous ont chacune une épaisseur dans la plage de 1 nm à 80 nm, de préférence dans la plage de 2 nm à 40 nm.

**6.** Dispositif électroluminescent organique selon la revendication 1, dans lequel le matériau de transport d'électrons comprend un composé bis(9,9'-spirobifluorén-2-yle).

**7.** Dispositif électroluminescent organique selon la revendication 6, dans lequel le composé bis(9,9'-spirobifluorén-2-yle) est choisi parmi :

X-1

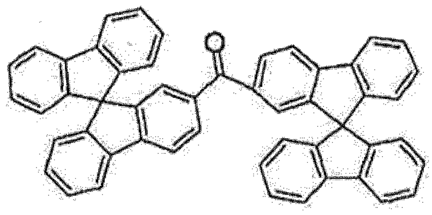

;

X-2

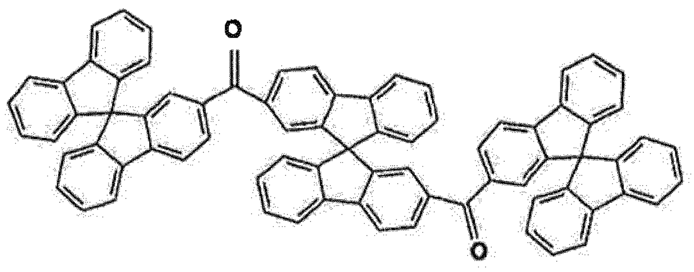

;

X-3

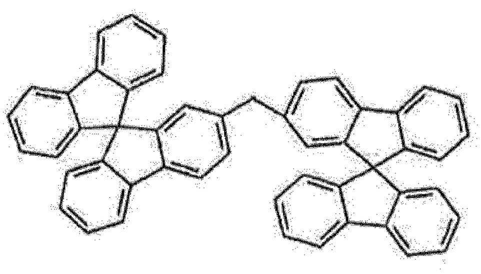

;

ou

X-4

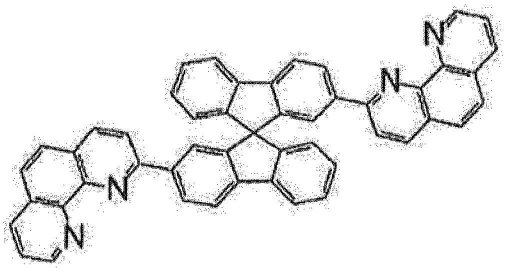

**8.** Dispositif électroluminescent organique selon la revendication 1, dans lequel le matériau de transport d'électrons est un dérivé benzazole représenté par la formule développée (K) :

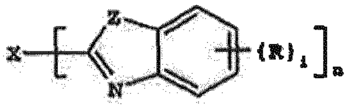

(K)

dans laquelle :

n est choisi parmi 2 à 8 et i est choisi parmi 1 à 5 ;
Z est indépendamment un O, NR ou S ;
R est individuellement un hydrogène ; un alkyle de 1 à 24 atomes de carbone, un aryle ou un aryle de 5 à 20 atomes de carbone substitué par un hétéroatome, un halogéno, ou des atomes nécessaires pour compléter un cycle aromatique condensé ; et
X est une unité de liaison comprenant un carbone, un alkyle, un aryle, un alkyle substitué ou un aryle substitué, qui relie ensemble par conjugaison ou non les multiples benzazoles, de préférence ledit dérivé benzazole comprend le 2,2',2"-(1,8,5-phénylène)tris[1-phényl-1H-benzimidazole] (TPBI).

**9.** Dispositif électroluminescent organique selon la revendication 1, dans lequel le matériau de transport d'électrons est un complexe d'aluminium ou de gallium représenté par la formule (R-a) :

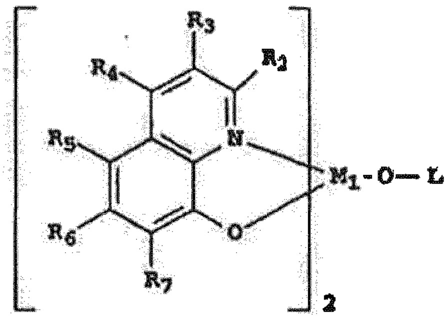

(R-a)

dans laquelle :

$M_1$ est un Al ou Ga ; et
$R_2$ à $R_7$ représentent indépendamment un atome d'hydrogène ou un groupe alkyle ; et
L est une fraction aromatique avec 6 à 30 atomes de carbone, de préférence dans lequel le complexe d'aluminium ou de gallium comprend de l'aluminium(III)bis(2-méthyl-8-hydroxy-quinoléine)-4-phénylphénolate [alias, Balq] et de l'oxine de gallium [alias, tris(8-quinolinolato)gallium(III)].

**10.** Dispositif électroluminescent organique selon la revendication 1, dans lequel l'hôte dans la couche électroluminescente phosphorescente comprend un composé fluorathène représenté par la formule (OP).

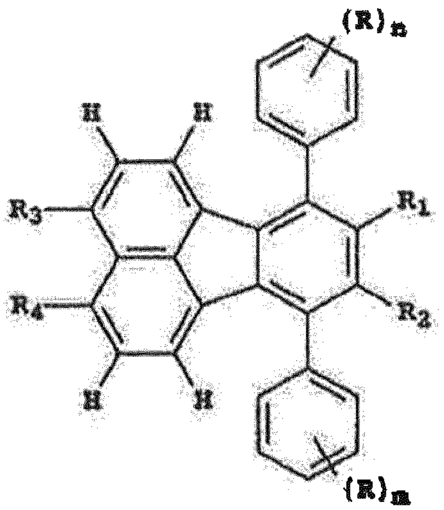

(OP)

dans laquelle

$R_1$, $R_2$, $R_3$ et $R_4$ sont indépendamment un hydrogène ou un groupe aromatique contenant 6 à 24 atomes de carbone, à la condition que tout $R_1$ à $R_4$ adjacent ne fasse pas partie d'un système cyclique aromatique condensé ;
R est un hydrogène ou un substituant éventuel ;
et n et m sont indépendamment 1 à 5, de préférence dans lequel le composé fluorathène est choisi parmi :

OP-1

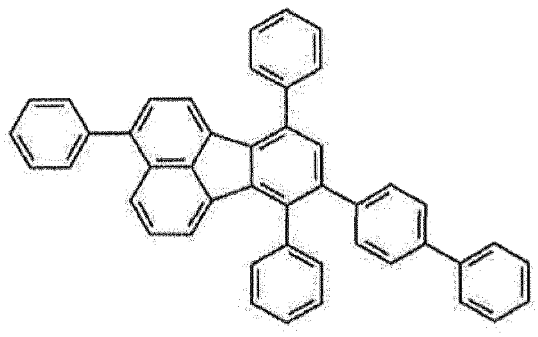

;

OP-2

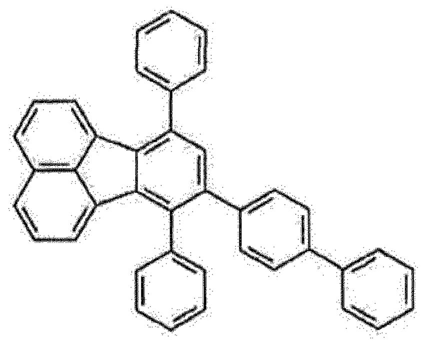

;

OP-3

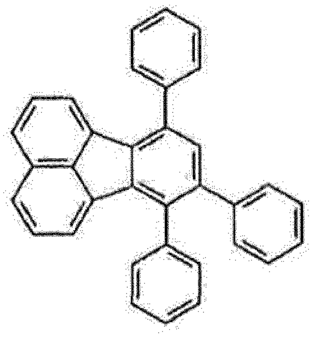

;

ou

OP-4

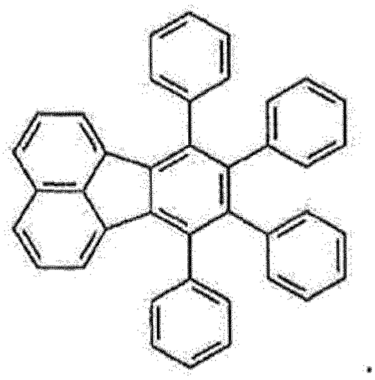

.

11. OLED selon la revendication 1, dans lequel le dopant phosphorescent dans la couche électroluminescente phosphorescente est choisi parmi le tris(1-phényl-isoquinoléine)iridium(III) ($Ir(piq)_3$), $Ir(ppy)_2(cou1)$ répondant à la formule :

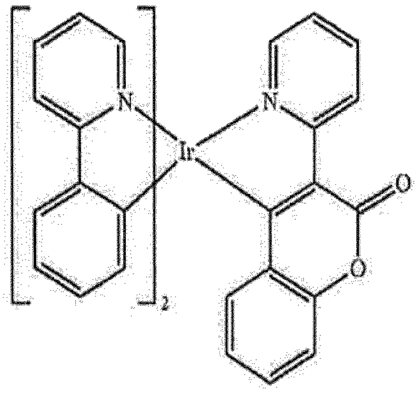

,

l'$Ir(cou2)_2ppy$ répondant à la formule :

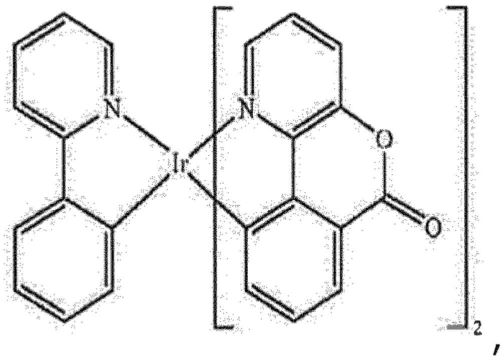

ou le tris(2-phénylpyridine)indium (III) ($Ir(ppy)_3$).

**12.** Dispositif électroluminescent organique selon la revendication 1, dans lequel le dispositif comprend une couche de blocage d'excitons (140) disposée en contact avec la couche électroluminescente phosphorescente du côté anode.

**13.** Dispositif électroluminescent organique selon la revendication 1, dans lequel le dispositif comprend deux couches électroluminescentes ; et dans lequel les deux couches électroluminescentes émettent une lumière de couleurs différentes.

**14.** Dispositif électroluminescent organique selon la revendication 1, qui comprend une structure en tandem.

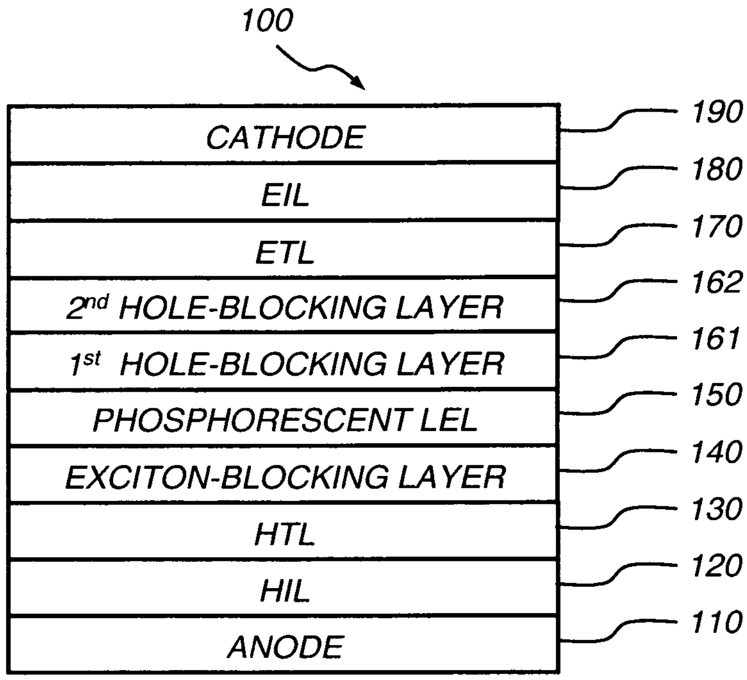
100
CATHODE
EIL
ETL
2nd HOLE-BLOCKING LAYER
1st HOLE-BLOCKING LAYER
PHOSPHORESCENT LEL
EXCITON-BLOCKING LAYER
HTL
HIL
ANODE
190
180
170
162
161
150
140
130
120
110

FIG. 1

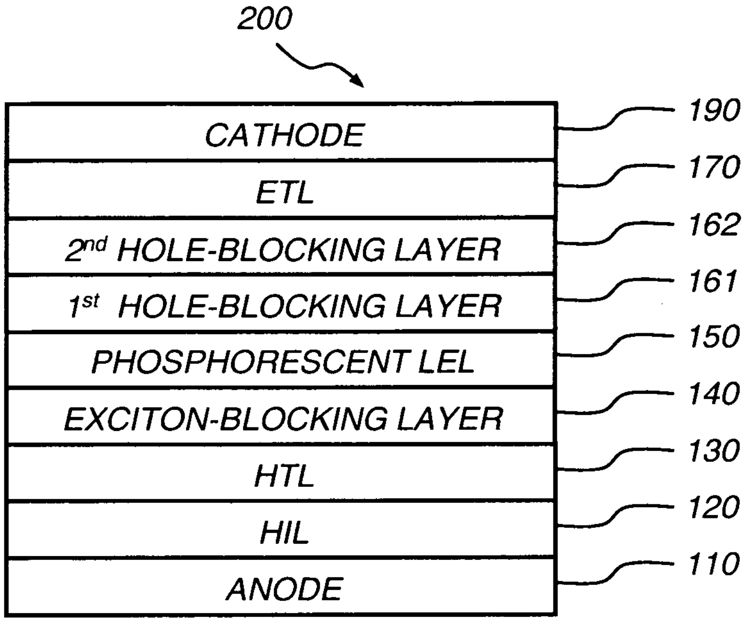
200
CATHODE
ETL
2nd HOLE-BLOCKING LAYER
1st HOLE-BLOCKING LAYER
PHOSPHORESCENT LEL
EXCITON-BLOCKING LAYER
HTL
HIL
ANODE
190
170
162
161
150
140
130
120
110

FIG. 2

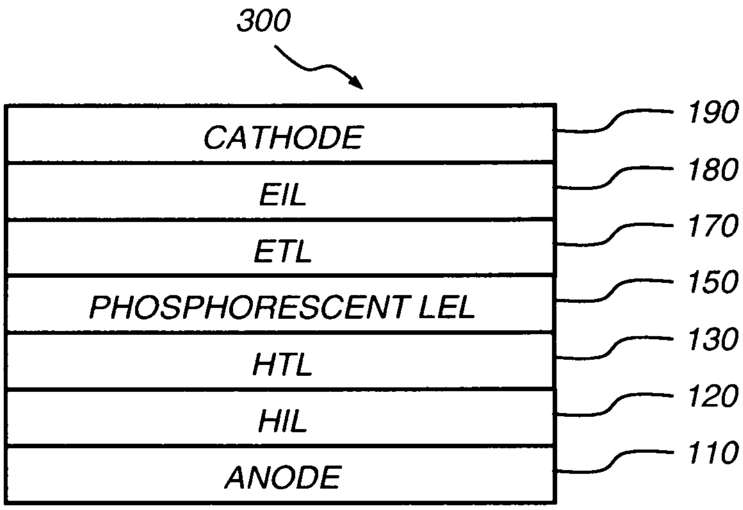


FIG. 3
(PRIOR ART)

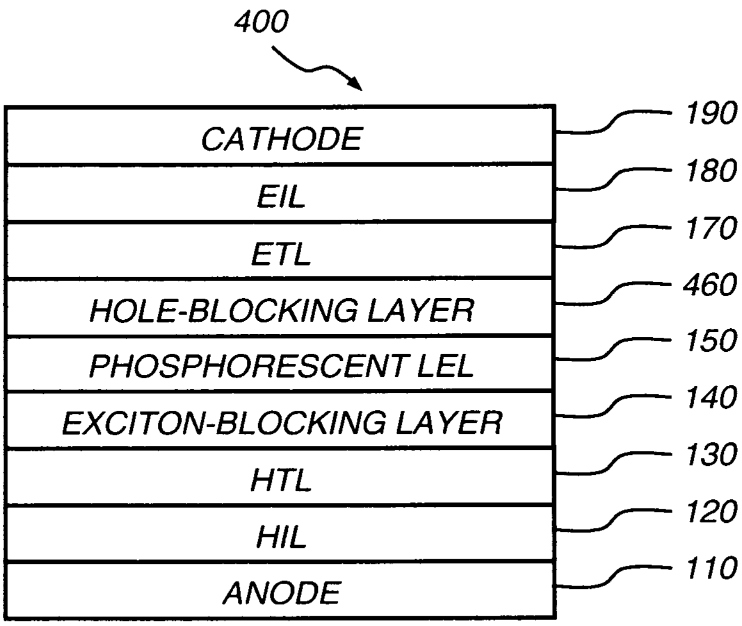


FIG. 4
(PRIOR ART)

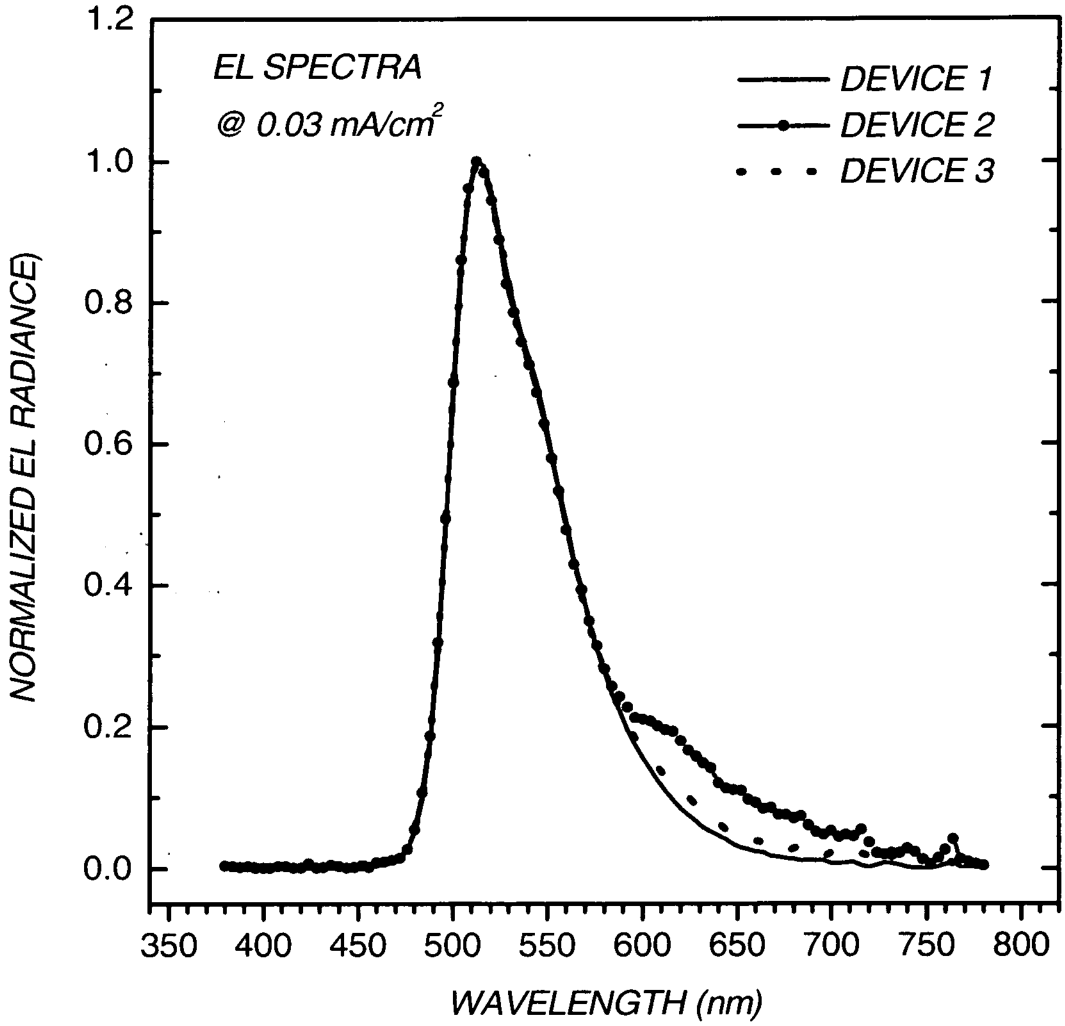
EL SPECTRA
@ 0.03 mA/cm2
DEVICE 1
DEVICE 2
DEVICE 3
NORMALIZED EL RADIANCE)
0.0
0.2
0.4
0.6
0.8
1.0
1.2
350
400
450
500
550
600
650
700
750
800
WAVELENGTH (nm)

FIG. 5

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 3172862 A
- US 3173050 A
- US 3710167 A
- US 4356429 A, Tang
- US 6097147 A, Baldo
- US 7261954 B2, Thompson
- EP 1653784 A1
- US 4720432 A
- EP 0891121 A1
- EP 1029909 A1
- US 20040113547 A1
- US 6720573 B
- US 6423429 B
- US 3180730 A, Klupfel
- US 3567450 A
- US 3658520 A, Brantley
- US 5061569 A
- EP 1009041 A
- US 5645948 A, Shi
- US 5766779 A
- US 6824895 B1
- US 7029766 B1
- US 6303238 B1
- WO 0057676 A
- WO 0070655 A
- WO 0141512 A1
- US 20020182441 A1
- US 20030017361 A1
- US 20030072964 A1
- US 6413656 B1
- US 6687266 B1
- US 20040086743 A1
- US 20040121184 A1
- US 20030059646 A1
- US 20030054198 A1
- EP 1239526 A2
- EP 1238981 A2
- EP 1244155 A2
- US 20020100906 A1
- US 20030068526 A1
- US 20030068535 A1
- JP 2003073387 A
- JP 2003073388 A
- US 6677060 B2
- US 20030235712 A1
- US 20040013905 A1
- US 6733905 B2
- US 6780528 B2
- US 20030040627 A1
- JP 2003059667 A
- JP 2003073665 A
- US 20020121638 A1
- EP 1371708 A1
- US 2003010877 A1
- WO 03040256 A2
- US 20030096138 A1
- US 20030173896 A1
- US 6670645 B2
- US 20040068132 A1
- WO 2004015025 A1
- US 20040072018 A1
- US 20020134984 A1
- WO 03079737 A2
- WO 2004020448 A1
- WO 03091355 A2
- US 7101631 B
- US 7147937 B
- US 7118812 B
- US 7029766 B
- US 6870054 B
- US 6835835 B
- US 4885221 A
- US 5677572 A
- US 5059861 A
- US 5059862 A
- US 6140763 A
- US 4885211 A
- US 5247190 A
- US 5703436 A
- US 5608287 A
- US 5837391 A
- US 5776622 A
- US 5776623 A
- US 5714838 A
- US 5969474 A
- US 5739545 A
- US 5981306 A
- US 6137223 A
- US 6172459 B
- US 6278236 B
- US 6284393 B
- EP 1076368 A
- US 5276380 A
- EP 0732868 A
- US 6237529 B
- US 5294870 A
- US 5688551 A
- US 5851709 A

- US 6066357 A
- US 6226890 B

**Non-patent literature cited in the description**


- Double Injection Electroluminescence in Anthracene. *RCA Review,* 1969, vol. 30, 322
- **ADACHI et al.** Electroluminescence in Organic Films with Three-Layer Structure. *Japanese Journal of Applied Physics,* 1988, vol. 27, L269
- **TANG et al.** Electroluminescence of Doped Organic Thin Films. *Journal of Applied Physics,* 1989, vol. 65, 3610
- Organic light-emitting devices with double-block layer. **YANG H. et al.** MICROELECTRONICS JOURNAL. MACKINTOSH PUBLICATIONS LTD, 01 November 2006, vol. 37, 1271-1275
- **S. L. MUROV ; I. CARMICHAEL ; G. L. HUG.** Handbook of Photochemistry. Marcel Dekker, 1993
- Lange's handbook of Chemistry. McGraw Hill, 1979, 3-134, 3-138
- **JOHNSON et al.** *J. Am. Chem. Soc.,* 1983, vol. 105, 1795-1802
- **WRIGHTON ; MORSE.** *J. Am. Chem. Soc.,* 1974, vol. 96, 998-1003
- **STUFKENS.** *Comments Inorg. Chem.,* 1992, vol. 13, 359-385
- **YAM.** *Chem. Commun.,* 2001, 789-796
- **MA et al.** *Synthetic Metals,* 1998, vol. 94, 245-248
- **KIDO et al.** *Chem Lett.,* 1990, 657
- *J. Alloys and Compounds,* 1993, vol. 192, 30-33
- *Jpn J. Appl Phys,* 1996, vol. 35, L394-6
- *Appl. Phys. Lett.,* 1994, vol. 65, 2124